(19) Europäisches Patentamt
European Patent Office
Office européen des brevets

(11) **EP 3 912 267 B1**

(12) **EUROPÄISCHE PATENTSCHRIFT**

(45) Veröffentlichungstag und Bekanntmachung des Hinweises auf die Patenterteilung:
**27.09.2023  Patentblatt 2023/39**

(21) Anmeldenummer: **20701685.8**

(22) Anmeldetag: **17.01.2020**

(51) Internationale Patentklassifikation (IPC):
*H03F 1/02* (2006.01)   *H03F 3/189* (2006.01)
*H03F 1/42* (2006.01)   *H03F 1/52* (2006.01)
*H03F 3/60* (2006.01)

(52) Gemeinsame Patentklassifikation (CPC):
**H03F 1/0288; H03F 1/42; H03F 1/523; H03F 3/189; H03F 3/602;** H03F 2200/405; H03F 2200/451

(86) Internationale Anmeldenummer:
**PCT/EP2020/025020**

(87) Internationale Veröffentlichungsnummer:
**WO 2020/148094 (23.07.2020 Gazette 2020/30)**

(54) **SENDE- UND EMPFANGSVORRICHTUNG MIT EINEM BREITBAND-HF-LEISTUNGSVERSTÄRKER, INSBESONDERE N-WEGE-DOHERTY VERSTARKER MIT AKTIVER LASTMODULATION**

TRANSMITTING AND RECEIVING DEVICE HAVING A WIDE-BAND HF POWER AMPLIFIER, IN PARTICULAR AN N-WAY DOHERTY AMPLIFIER HAVING ACTIVE LOAD MODULATION

DISPOSITIF ÉMETTEUR ET RÉCEPTEUR DOTÉ D'UN AMPLIFICATEUR DE PUISSANCE RF LARGE BANDE, EN PARTICULIER UN AMPLIFICATEUR DOHERTY À N VOIES À MODULATION ACTIVE DE CHARGE

(84) Benannte Vertragsstaaten:
**AL AT BE BG CH CY CZ DE DK EE ES FI FR GB GR HR HU IE IS IT LI LT LU LV MC MK MT NL NO PL PT RO RS SE SI SK SM TR**

(30) Priorität: **20.01.2019   DE 102019000324**

(43) Veröffentlichungstag der Anmeldung:
**24.11.2021   Patentblatt 2021/47**

(73) Patentinhaber: **iAd Gesellschaft für Informatik, Automatisierung und Datenverarbeitung mbH
90613 Grosshabersdorf (DE)**

(72) Erfinder:
• **HAMPEL, Hermann
  90613 Grosshabersdorf (DE)**
• **HAMPEL, Johannes
  90613 Grosshabersdorf (DE)**
• **YAKYMCHUK, Maxym
  90766 Fürth (DE)**
• **FISCHER, Georg
  90425 Nürnberg (DE)**

• **POPP, Daniel
  91085 Weisendorf (DE)**

(74) Vertreter: **Dreykorn-Lindner, Werner
Steinlachstrasse 2
90571 Schwaig (DE)**

(56) Entgegenhaltungen:
**WO-A1-2011/112129     US-A1- 2015 229 276
US-B1- 10 033 335**

• **JING LI ET AL: "A 600W broadband three-way Doherty power amplifier for multi-standard wireless communications", 2015 IEEE MTT-S INTERNATIONAL MICROWAVE SYMPOSIUM, IEEE, 17. Mai 2015 (2015-05-17), Seiten 1-3, XP033181380, DOI: 10.1109/MWSYM.2015.7166928 [gefunden am 2015-07-24]**

- **JINGCHU HE ET AL: "A 500-W high efficiency LDMOS classical three-way Doherty amplifier for base-station applications", 2016 IEEE MTT-S INTERNATIONAL MICROWAVE SYMPOSIUM (IMS), IEEE, 22. Mai 2016 (2016-05-22), Seiten 1-4, XP032941157, DOI: 10.1109/MWSYM.2016.7540133 [gefunden am 2016-08-10]**
- **DANIEL POPP ET AL: "High Power and High Bandwidth Digital Three-Way Doherty Power Amplifier", 2019 IEEE 20TH WIRELESS AND MICROWAVE TECHNOLOGY CONFERENCE (WAMICON), IEEE, 8 April 2019 (2019-04-08), pages 1-6, XP033577671, DOI: 10.1109/WAMICON.2019.8765455 [retrieved on 2019-07-16]**

**Beschreibung**

Die Erfindung betrifft, gemäß Patentanspruch 1, eine Sende- und Empfangsvorrichtung.

Auf dem technischen Gebiet der Funktechnik, insbesondere in Mobilfunk- bzw. zellularen Basisstationen, Satellitenkommunikations- und anderen Kommunikations- und Rundfunksystemen werden viele über eine große Bandbreite verteilte Hochfrequenzträger gleichzeitig mit demselben Hochleistungsverstärker verstärkt. Für den RF- oder HF-Leistungsverstärkers (RF: Radio Frequency, HF: High Frequency) hat dies den Effekt, dass die momentane Übertragungsleistung sehr stark und sehr schnell variiert. Hinzu kommt, dass der Luftraum zu einer knappen Ressource geworden ist, welcher zwischen der Vielzahl von Teilnehmer geteilt werden muss. Heutzutage spielt das Flugverkehrsmanagement eine wichtige Rolle. Es kontrolliert den Luftraum, bietet den Flugzeugen eine Wegführung, und am wichtigsten von allem, es garantiert allen Luftraumnutzern ein hohes Maß an Sicherheit. Trotzdem ist der Luftraum aufgrund der hohen Nutzerzahl und Verwendung veralteter Luftraumelektroniksysteme oft verstopft. Daher spielt die Modernisierung von Luftraumelektroniksystemen eine wesentliche Rolle in der Erhöhung der Luftraumkapazitäten und der Reduzierung der "EnRoute" Verspätungen. Die moderne Luftfahrt verlässt sich zunehmend auf Datenlink-Kommunikationen. Für die Realisierung eines sichereren und verlässlicheren Reiseerlebnisses ersetzen digitale Kommunikationssysteme ihre analogen Vorläufer. Der Entwurf eines Mehrzweck-Leistungsverstärkers, welcher den Anforderungen aller Standards, insbesondere Übertragungsstandards nahe und im Bereich des L-Band Frequenzbereichs, genügt, stellt eine beträchtliche Herausforderung dar, da Hochleistung, effiziente Verstärkung, Linearität und Breitbandbetrieb in einem Verstärker bedient werden müssen. Die interessanten Übertragungsstandards in diesem Zusammenhang sind L-DACS 1, UAT, DME, Mode-S, ADS-B und SSR.

Ein Weg zur Erhöhung der Effizienz eines RF-Leistungsverstärkers, insbesondere eines HF-Leistungsverstärkers ist es, das Doherty-Prinzip zu verwenden. Der Doherty-Verstärker verwendet in seiner grundlegenden Form zwei Verstärkerstufen (auch Verstärkerkerne genannt), einen Haupt- und einen Hilfsverstärker (ebenfalls Träger- und Maximalwertverstärker genannt). Die Last ist an dem Hilfsverstärker angeschlossen und der Hauptverstärker ist über einen Impedanz-Umwandler bzw. -Umsetzer, normalerweise eine Viertelwellenlängen Übertragungsleitung oder ein äquivalentes zusammengesetztes Netzwerk (mit GyratorVerhalten/Impedanzinverter infolge λ/4-Leitung), mit der Last verbunden.

Doherty Leistungsverstärker (DPA - Doherty Power Amplifier) bieten eine hohe durchschnittliche Effizienz für modulierte Wellenformen, bieten jedoch nur eine schmale Bandbreiteneffizienz von 5% bis 10% [siehe beispielsweise: J. H. Qureshi: "A Wide-Band 20W LMOS Doherty Power Amplifier" IMS 2010]. Hauptsächlich verantwortlich für die Bandbreitenbeschränkung sind die Impedanzinverter, welche die Lastanpassung ermöglichen. Die Impedanzinverter stellen jedoch nicht das einzige Element dar, welches für die niedrige Bandbreite verantwortlich ist, die Ausgangskapazitäten der aktiven Bauelemente tragen ebenfalls hierzu bei. Um eine maximale Bandbreite zu erreichen, müssen die parasitären Eigenschaften des Drain-Anschlusses mit Hilfe von passenden Breitbandtechniken überwunden werden. Eine umfassende analytische Untersuchung der Übertragungsfunktion muss berücksichtigt werden [siehe beispielsweise: K. Bathich, A. Z. Markos, G. Boeck: "Frequency Response Analysis and Bandwidth Extension of the Doherty Amplifier" IEEE Transactions on Microwave Theory and Techniques, Volume: 59, No. 4, April 2011]. Offset-Leitungen werden regulär dazu verwendet die parasitären Eigenschaften des Drain zu kompensieren [siehe beispielsweise: R. Quaglia, M. Pirola, C. Ramella: "Offset Lines in Doherty Power Amplifiers: Analytical Demonstration and Design" IEEE Microwave and Wireless Components Letters, Volume: 23, Issue: 2, Feb. 2013 oder B. Kim, J. Kim, I. Kim, J. Cha: "The Doherty power amplifier" IEEE Microwave Magazine, Volume: 7, Issue: 5, Oct. 2006]. Im Aufsatz von R. Giofrè, L. Piazzon, P. Colantonio, F. Giannini: "A closed-form design technique für ultra-wideband Doherty power amplifiers" IEEE Transactions on Microwave Theory and Techniques, Volume: 62, Issue: 12, December 2014 wurde gezeigt, dass Offset-Leitungen nicht unbedingt Bandbreiten-limitierende Strukturen darstellen. Durch Einsatz zweier λ/4 Mikrostreifenleitungen am Spitzenleistungsverstärker verbesserte sich das Bandbreitenpotenzial des DPA und die Lastanpassung. Ein geschlossener Ansatz zur Berechnung der notwendigen charakteristischen Impedanzen der Offset-Leitungen wird präsentiert. Der Ansatz wurde von A. Barakat, M. Thian, V. Fusco gemäß dem Aufsatz:

"Towards generalized Doherty power amplifier design for wideband multimode operation" SBMO/IEEE MTTS International Microwave and Optoelectronics Conference (IMOC),2015verallgemeinert und weiter verfeinert [siehe A. Barakat, M. Thian, V. Fusco, S. Bulja, L. Guan: "Toward a More Generalized Doherty Power Amplifier Design for Broadband Operation" IEEE Transactions on Microwave Theory and Techniques, Volume: 65, Issue: 3, March 2017]. Zusätzliche Beschränkungen werden im Zusammenhang mit dem Leistungsteiler und der Phasenausgleichsschaltung am Doherty Leistungsverstärker DPA eingeführt. Mit dem Entfernen des analogen Leistungsteilers und der Phasenausgleichsschaltung sowie deren Ersatz durch eine digitale Version kann nun jeder Verstärkerkern hinsichtlich seiner Amplitude und Phasenlage individuell gesteuert werden, was zu einer Erhöhung der Bandbreite und der Linearität führt, wie von R. Darraji, P. Mousavi, F. M. Ghannouchi in "Doherty Goes Digital: Digitally Enhanced Doherty Power Amplifiers" IEEE Microwave Magazine, Volume: 17, Issue: 8, Aug. 2016 oder von J.C. Cahuana, P. Landin, D. Gustafsson, C. Fager, T. Eriksson in "Linearization of dual-input Doherty power amplifiers" International Workshop on Integrated Nonlinear Microwave and Millimetre-wave Circuits, April 2014 berichtet wird. Das Entfernen des analogen Leistungsteilers wurde erstmals von W.C.E. Neo, J. Qureshi, M. J. Pelk, J. R. Gajadharsing, L. C. N. de Vreede in "A Mixed-Signal Approach Towards Linear and Efficient NWay Doherty Amplifiers" IEEE Transactions on Microwave Theory and Techniques, Volume: 55, Issue: 5, May 2007 berichtet.

Der klassische Doherty-Leistungsverstärker besteht aus zwei Verstärkerkernen, von welchen einer den Hauptleistungsverstärker und einer den Spitzenleistungsverstärker darstellt, welcher im Folgenden "aktiver Lastmodulator" genannt wird. Der Hauptleistungsverstärker wird klassischerweise im AB-Betrieb und der Spitzenverstärker im C-Betrieb verwendet. Der Hauptleistungsverstärker ist über ein Impedanz invertierendes elektrisches Element mit dem Spitzenleistungsverstärker verbunden.

Der Impedanzinverter wird typischerweise durch eine λ/4 Mikrostreifenleitung realisiert. Zuerst wird der Strom des Hauptleistungsverstärkers hochgefahren, bis dessen Drainstrom in Sättigung ist. Dieser Punkt wird Back-off Punkt genannt. Für höhere Ausgangsleistung fängt nun der aktive Lastmodulator an Strom einzuspeisen. Durch den eingespeisten Strom ändert sich die Impedanz am Hauptverstärker. Ist die Phasendifferenz zwischen dem Strom des Hauptleistungsverstärkers und des aktiven Lastmodulators richtig eingestellt, nimmt die Impedanz am Hauptverstärker ab. Durch diesen Effekt muss der vom Hauptverstärker eingespeiste Strom ansteigen, damit dieser in Sättigung bleibt. Dies bedeutet, dass der Hauptleistungsverstärker über den gesamten Lastmodulationsbereich eine hohe Effizienz aufweist und dessen Ausgangsleistung ansteigt. Die beschriebene Anordnung ist prinzipiell auf eine beliebige Zahl von aktiven Lastmodulatoren erweiterbar und ermöglicht eine hohe Effizienz über einen weiten Leistungsbereich.

Während sich die Originalpublikation von W.H. Doherty auf Röhrenverstärker bezieht, werden bei Verwendung aktueller Technologie Leistungstransistoren verwendet. Um die relative Bandbreite zu steigern, wird eine digitale Ansteuerung verwendet. Eine solche Art der Ansteuerung wurde zuerst von W.C.E. Neo, J. Qureshi, M. J. Pelk, J. R. Gajadharsing, L. C. N. de Vreede in "A Mixed-Signal Approach Towards Linear and Efficient NWay Doherty Amplifiers" IEEE Transactions on Microwave Theory and Techniques, Volume: 55, Issue: 5, May 2007 publiziert. Anstatt einen statischen Leistungsteiler zu verwenden, werden Hauptverstärker und aktive Lastmodulatoren individuell mit einem speziell angepassten Leistungs- und Phasenprofil angesteuert. Die Ansteuerung aller Eingänge wird als Einheit zusammengefasst und im Folgenden Steuerfunktion genannt.

Für die Steuerfunktion ergibt sich hiermit ein [2*N-1]-Dimensionaler Raum, in welchem mindestens eine statische Funktion gefunden werden muss, welche die Optimierungskriterien hinsichtlich, Effizienz, Linearität und Bandbreite erfüllt. Die Variable N ist die Anzahl der Verstärkereingänge. Da sich die Eigenschaften des Ausgangsnetzwerkes zu den Bandkanten hin signifikant verändern, sollte die Steuerfunktion mit der Mittenfrequenz des aktuell zu verstärkenden Signals bzw. Signalensemble nachgeführt werden.

Ein Breitband-Doherty-Verstärker mit Breitbandtransformator ist beispielsweise aus der WO 2013006941 A1 bekannt. Der Breitband-Doherty-Verstärker umfasst einen Hauptverstärker, welcher zum Verstärken eines ersten Teils eines Eingangssignals und eines Hilfsverstärkers betreibbar ist, wobei der Hilfsverstärker zum Einschalten und zum Verstärken eines zweiten Teils des Eingangssignals betreibbar ist die Amplitude des zweiten Teils des Eingangssignals überschreitet eine Schwellenamplitude und einen Breitbandimpedanzwandler, der zwischen den Hauptverstärker und einen Ausgang des Hilfsverstärkers geschaltet ist. Der Breitband-Impedanzwandler erzeugt basierend auf einer Ausgabe des Hauptverstärkers ein transformiertes Ausgangssignal des Hauptverstärkers. Der Breitbandimpedanzwandler erzeugt den transformierten Ausgang des Hauptverstärkers basierend auf einem Ausgang des Hauptverstärkers, wobei der Breitbandimpedanzwandler eine Viertelwellenlängenanpassungsleitung umfasst, die mit einem Richtkoppler gekoppelt ist, wobei der Richtkoppler die gleiche elektrische Länge wie das Viertel hat Wellenlängenanpassungslinie.

In einer Ausführungsform wird ein Hochfrequenz-Leistungsverstärker mit Doherty-Verstärkerarchitektur offenbart. Der Hochfrequenzleistungsverstärker umfasst einen Signalteiler, der ein eingegebenes Hochfrequenzsignal in ein erstes Signal und ein zweites Signal aufspaltet, einen ersten Verstärker, der das erste Signal verstärkt, um ein drittes Signal zu bilden, einen zweiten Verstärker, der das zweite Signal verstärkt, um ein Signal zu bilden ein viertes Signal und einen Breitbandimpedanzwandler, der das dritte Signal in ein fünftes Signal umwandelt. Der Breitbandimpedanzwandler umfasst eine Viertelwellenlängenanpassungsleitung, die mit einem Richtkoppler gekoppelt ist, wobei der Richtkoppler die gleiche elektrische Länge wie die Viertelwellenlängenanpassungsleitung aufweist. Insbesondere ist der Richtkoppler ein Breitseiten-gekoppelter Leitungskoppler. Zusammenfassend wird in der WO 2013006941 A1 ein Doherty Verstärker beschrieben, dessen Bandbreite durch eine besondere Auslegung des Impedanzinverters erhöht wird. In der Doherty Architektur wird der Impedanzinverter dazu benötigt, eine Stromquelle wie sie durch die Leistungstransistoren gegeben ist, in eine Spannungsquelle umsetzen. Man spricht von einem Gyratorverhalten. Bisher kamen hierfür λ/4 Leitungen zum Einsatz. Das Gyratorverhalten kann aber mit bisherigen λ/4 Leitungen nicht breitbandig zur Verfügung gestellt werden, da sich bei Änderung der Frequenz die Wellenlänge ändert und somit auch die mechanische Länge geändert werden müsste. Durch den Einsatz eines Richtkopplers wird die Bandbreite erhöht, über die ein akzeptables Gyratorverhalten erzielt werden kann.

Um die Linearität eines Komposit-Verstärkers, der mit einem Doherty-Ausgangsnetzwerk versehen ist, über ein breites Frequenzband zu verbessern, umfasst ein aus der DE 601 24 728 T2 bekannter Komposit-Verstärker einen Leistungshauptverstärker und einen Leistungshilfsverstärker, die über ein Doherty-Ausgabenetzwerk mit einer Last verbunden sind und weitere Mittel zum Emulieren und Kompensieren des nicht-linearen Verhaltens des Ausgangsstroms des Leistungshilfsverstärkers in dem Eingangssignal für den Hauptverstärker. Weiterhin sind Mittel zum Entzerren bzw. Ausgleichen der Frequenzantwort des Komposit-Verstärkers und Mittel zum Kreuzkoppeln und Subtrahieren einer gefilterten Version des Eingangssignals für den Hilfsverstärker von dem Eingangssignal des Hauptverstärkers vorgesehen. Ein Kreuzkopplungsfilter emuliert die Impedanz des Hilfsverstärkers und kompensiert die Durchgangsimpedanz bzw. Transimpedanz zwischen dem Haupt- und dem Hilfsverstärker. Weiterhin kann ein Kreuzkopplungsfilter vorgesehen werden, das die Transimpedanz von dem Hilfsverstärker zu dem Ausgangsknoten emuliert und die Transimpedanz von dem Hauptverstärker zu dem Ausgangsknoten kompensiert. Schließlich ist ein eingangsseitiges Filter zum Entzerren der Frequenzantwort des Haupt- und des Hilfsverstärkers vorgesehen. Somit wird beim aus der DE 601 24 728 T2 bekannten Komposit-Verstärker von dem Treibersignal des Hauptverstärkers eine nicht-lineare Funktion des Eingabesignals, die den nicht-linearen Ausgangsstrom des Hilfsverstärkers emuliert, subtrahiert. Dies hat den Vorteil, dass die nicht-linearen Komponenten in dem Ausgang aufgehoben bzw. kompensiert werden, ohne die Verstärkereffizienz anzutasten. Die nicht-lineare Funktion kann von einem Modell der Stromfunktion des Hilfsverstärkers erhalten werden (wenn der Hilfsverstärker den nicht-linearen Strom durch Arbeiten in der Klasse C bereitstellt), oder sie kann, in verstärkter Form, sowohl als das Treibersignal für den Hilfsverstärker (der dann für einen Betrieb in den linearen Klassen B oder AB vorgespannt werden kann) und zum Kreuzkoppeln durch das Filter vorher hergestellt und benutzt werden. Zusammenfassend wird in der DE 601 24 728 T2 ein N-Wege Doherty Verstärker beschrieben, bei dem die Amplituden und Phasen der Eingangssignale in die beteiligten Verstärkerkerne durch Kreuzkoppelfilter gezielt in nichtlinearer Weise beeinflusst werden, so dass sich ausgangsleistungsabhängig günstige Phasen und Amplituden am Ausgang der nichtlinearen Verstärkerkerne ergeben, die dann im Zusammenspiel mit dem N-Wege Combiner zu einer Maximierung der Effizienz und der Bandbreite führen. Das Netzwerk am Eingang der nichtlinearen Verstärkerkerne mit Kreuzkoppelfiltern, die zum Teil auch aktiv, also verstärkend, ausgeführt sein können, kann als nichtlineare analoge Vorverzerrung oder analoge Steuerfunktion angesehen werden.

Eine weitere breitbandige Doherty -Verstärkerschaltung ist aus der US 2008/0 007 331 A1 bekannt. Die Verstärkerschaltung umfasst einen Signalsummierungsknoten, einen Hauptverstärker, eine Übertragungsleitung, welche einen Ausgang des Hauptverstärkers an den Signalsummierungsknoten koppelt, einen Peaking-Verstärker, der einen Ausgang hat, welcher mit dem Signalsummierungsknoten gekoppelt ist, und einen Breitband-Impedanzwandler, der ein breiteres, an den Signalsummierungsknoten gekoppeltes Ende sowie ein schmäleres, einen Anschlussknoten bildendes Ende hat. Zusammenfassend wird in der US 2008/0 007 331 A1 ein Doherty Verstärker gezeigt, der einen Multiband-Impedanzinverter aufweist mittels welchem in mehreren Bändern ein Gyratorverhalten erzielt werden kann. Dementsprechend wird nicht ein großer zusammenhängender Frequenzbereich dargestellt. Zudem ist der Impedanzinverter aus Leitungsstücken mit Längen in der Größenordnung der Wellenlänge und mit konstanter Breite aufgebaut.

Eine weitere ähnliche breitbandige Doherty -Verstärkerschaltung ist aus der DE 10 2012 202 870 A1 bekannt. Im Einzelnen weist die Verstärkerschaltung einen Signalsummierungsknoten, einen ersten Verstärker, der dazu ausgebildet ist, in einem ersten Modus zu arbeiten, einen Impedanzinverter, der dazu ausgebildet ist, für den ersten Verstärker eine Impedanztransformation und eine Lastmodulation bereitzustellen, einen zweiten Verstärker, der dazu ausgebildet ist, in einem zweiten Modus zu arbeiten, wobei der zweite Verstärker einen an den Signalsummierungsknoten gekoppelten Ausgang aufweist und einen Breitband-Impedanzwandler auf. Der Breitband-Impedanzwandler weist ein erstes, mit dem Signalsummierungsknoten gekoppeltes Ende und ein zweites, einen Anschlussknoten bildendes Ende auf, wobei der Breitband-Impedanzwandler dazu ausgebildet ist, für den ersten Verstärker eine reelle Impedanz über zumindest 25% einer Hochfrequenzbandbreite der Verstärkerschaltung darzustellen. Dabei ist der Breitband-Impedanzwandler verjüngt und das erste, an den Signalsummierungsknoten gekoppelte Ende ist breiter als das zweite Ende, wobei die Verjüngung sukzessive über eine Länge des Breitband-Impedanzwandlers verläuft. Weiterhin ist ein Impedanzwandler vorgesehen, welcher den Ausgang des zweiten Verstärkers an den Signalsummierungsknoten koppelt. Der Ausgang des zweiten Verstärkers ist direkt mit dem ersten Ende des Breitband-Impedanzwandlers am Summierungsknoten verbunden. Insbesondere ist der Breitband-Impedanzwandler dazu ausgebildet, die reelle Impedanz über zumindest 30% der Hochfrequenzbandbreite der Verstärkerschaltung zu gewährleisten. Der Impedanzinverter ist eine $\lambda/4$-Wellenlängen-Übertragungsleitung, die ein erstes, mit dem ersten Ende des Breitband-Impedanzwandlers am Signalsummierungsknoten verbundenes Ende sowie ein zweites, mit dem Ausgang des Hauptverstärkers verbundenes Ende hat. Weiterhin ist aus der DE 10 2012 202 870 A1 ein Verfahren zum Betrieb einer Verstärkerschaltung, umfassend einen Signalsummierungsknoten, einen ersten Verstärker und einen zweiten Verstärker, bekannt, welches in einem ersten Modus die folgenden Verfahrensschritte aufweist: Koppeln eines Ausgangs des ersten Verstärkers an den Signalsummierungsknoten über einen Impedanzinverter, Betreiben des ersten Verstärkers in einem ersten Modus, Bereitstellen einer Impedanztransformation und einer Lasttransformation für den ersten Verstärker über den Impedanzinverter, Koppeln eines Ausgangs des zweiten Verstärkers an den Signalsummierungsknoten, Betreiben des zweiten Verstärkers. In einem zweiten Modus weist das Verfahren die folgenden Verfahrensschritte auf: Koppeln eines ersten Endes eines Breitband-Impedanzwandlers an den Signalsummierungsknoten, Koppeln eines zweiten Endes des Breitband-Impedanzwandlers an eine Abschluss-Impedanz, und Darstellen einer reellen Impedanz für den ersten Verstärker über den Breitband-Impedanzwandler über zumindest 25% einer Hochfrequenzbandbreite der Verstärkerschaltung. Im Einzelnen erfolgt das Koppeln des Ausgangs des zweiten Verstärkers mit dem Signalsummierungsknoten über einen Impedanzwandler und das direkte Verbinden des Ausgangs des zweiten Verstärkers mit dem ersten Ende des Breitband-Impedanzwandlers an dem Signalsummierungsknoten.

Zusammenfassend wird in der DE 10 2012 202 870 A1 ein Ausgangstransformator am Ausgang des Impedanzwandlers/Combiners angeordnet, der es ermöglicht, die Impedanz am Sternpunkt des Combiners abweichend von den sonst üblichen 50 Ohm am Ausgang des Verstärkers zu wählen. Dies greift aber nicht in den Austausch von Leistung bei Harmonischen zwischen den Verstärkerkernen ein.

Eine weitere ähnliche breitbandige Doherty -Verstärkerschaltung, insbesondere ein Breitbandleistungsverstärker mit aktiver Lastmodulation ist aus der EP 2 879 291 A1 bekannt. Durch die aktive Lastmodulation wird die Backoff-Effizienz des Leistungsverstärkers erhöht, was für die Gesamteffizienz, beispielsweise einer mobilen Basisstation relevant ist. Im Einzelnen weist der Breitbandleistungsverstärker einen Hauptverstärkerkern und mindestens einen Hilfsverstärkerkern, einen mit dem Eingang des Hauptverstärkers und dem Eingang des mindestens einen Hilfsverstärkerkerns verbundenen Eingangssignalteiler und einen mit einem Ausgang des Verstärkerkerns verbundenen Ausgangskombinierer für den Hauptverstärkerkern und einem Ausgang des mindestens einen Hilfsverstärkerkerns auf. Der Eingangssignalteiler ist ausgebildet, ein Eingangssignal in ein erstes Signal für den Hauptverstärkerkern und mindestens ein zweites Signal für den mindestens einen Hilfsverstärkerkern gemäß frequenzabhängiger nichtlinearer Eingangsansteuerfunktionen aufzuteilen. Ein Ausgangskombinierer ist derart konfiguriert, Ausgangssignale des Hauptverstärkerkerns und des mindestens einen Hilfsverstärkerkerns zu kombinieren und ein Kontinuum von optimalen Abschlussimpedanzen des Hauptverstärkerkerns für die Grundfrequenz und für mindestens eine harmonische Frequenz über eine vorbestimmte Betriebsbandbreite in einem Bereich niedriger Leistung, wobei der Bereich niedriger Leistung definiert ist, in welchem der mindestens eine Hilfsverstärkerkern inaktiv ist, bereitzustellen. Der Ausgangskombinierer ist konfiguriert, um eine gegenseitige Lastmodulation zwischen den Verstärkerkernen in einem Hochleistungsbereich, der durch beide aktive Verstärkerkerne definiert ist, derart zu ermöglichen, dass eine effiziente Wellenformformung unter Lastmodulation aufrechterhalten werden kann, Demzufolge wird eine Abweichung der virtuellen Abschlussimpedanzen an den aktiven Bauelementen der Verstärkerkerne vom Kontinuum der optimalen Abschlussimpedanzen für die Grundfrequenzkomponente und mindestens eine harmonische Frequenzkomponente minimiert. Weiterhin ist der Ausgangskombinierer konfiguriert, um die Abweichung der virtuellen Abschlussimpedanzen bei den aktiven Bauelementen der Verstärkerkerne von dem Kontinuum der optimalen Abschlussimpedanzen für die Grundfrequenzkomponente und mindestens eine harmonische Frequenzkomponente durch Halten der Abweichung unter einen vorbestimmten Schwellenwert zu minimieren. Der Ausgangskombinierer umfasst einen Impedanzumsetzer, der für den Hauptverstärkerkern und / oder den Hilfsverstärkerkern vorgesehen ist, und konfiguriert ist, um die erforderlichen kontinuierlichen Multiharmonischen-Terminierungsbedingungen und - fähigkeiten zu implementieren und um diese unter Lastmodulation beizubehalten, indem Elemente einer Tiefpassstruktur in dem Impedanzinverter verwendet werden. Der Ausgangskombinierer weist eine Ausgangstransformatorschaltung auf, die an dem Ausgang des Ausgangskombinierers vorgesehen ist, und konfiguriert ist, um kontinuierliche mehrfach harmonische Abbruchbedingungen und die Fähigkeit, diese unter Lastmodulation zu halten, durch Verwenden von Elementen einer Tiefpassstruktur in der Ausgangstransformatorschaltung zu implementieren. Die Tiefpassstruktur ist durch Impedanzschritte in Mikrostreifenübertragungsleitungen einer Schaltungsstruktur der Vorrichtung implementiert. Basierend auf dieser Technik kann der Impedanzinverter das gewünschte Impedanzniveau in dem Grundfrequenzband bereitstellen, während er die parasitären Elemente der Hauptverstärkertransistorvorrichtung absorbiert und gleichzeitig die Übertragung/den Austausch von Oberwellenfrequenzkomponenten zwischen den verbundenen Verstärkerkernen minimiert. Somit werden unerwünschte Lastmodulationseffekte bei den harmonischen Frequenzen minimiert und eine geeignete Reflexionsphase (gemäß dem verwendeten mehrharmonischen Abschlusskontinuum) für mindestens eine harmonische Frequenzkomponente am Hauptverstärkerkern bereitgestellt. Insbesondere ist der Eingangsteiler konfiguriert, um die Eingangs-Steuerungsfunktion für die jeweiligen Verstärkerkerne als Funktionen der Frequenz und der momentanen Leistung derart bereitzustellen, dass

a) der Leistungspegel bei Beginn des Betriebs des Hilfsverstärkerkerns abhängig ist von der Restschwankung des Realteils der Lastimpedanz der Hauptverstärkerkernlast und frequenzabhängig im Niederleistungsbereich ist und / oder

b) ein komplexes Verhältnis zwischen Ausgangsströmen der Haupt- und Hilfsverstärkerkerne im Hochleistungsbereich so gesteuert wird, dass die Abweichung der virtuellen Abschlussimpedanzen an den aktiven Bauelementen der Verstärkerkerne vom Kontinuum der optimalen Abschlussimpedanzen für die Grundfrequenzkomponente und mindestens eine harmonische Frequenzkomponente minimiert wird. Um die Abweichung der virtuellen Abschlussimpedanzen von dem optimalen Abschlusskontinuum für die Grundfrequenzkomponente und mindestens eine harmonische Frequenzkomponente zu minimieren, wird die Abweichung unter einem vorbestimmten Schwellenwert gehalten. Die Eingangs-Steuerungsfunktion für die jeweiligen Verstärkerkerne kann mittels einer analogen (Kreuzkoppelfilter) oder digitalen Signalverarbeitungsschaltung realisiert werden, wobei ungleiche Drain-Vorspannungen für die Haupt- und Hilfsverstärkerkerne verwendet werden. Das Kontinuum der optimalen Abschlussimpedanzen bezeichnet einen kontinuierlichen Raum von Kombinationen von Abschlussimpedanzen bei mehreren harmonischen Frequenzen, der auf einen kontinuierlichen Raum von Ausgangsspannungswellenformen an der intrinsischen Referenzebene der aktiven Vorrichtung (Transistor) abbildet, so dass sich eine konstante Ausgangsleistung und optimale Effizienz aus diesen Wellenformen ergibt. Auf der Grundlage eines idealen Modells, das auf zwei harmonische Frequenzkomponenten beschränkt ist, ist ein solches optimales Kontinuum beispielsweise durch die Theorie der Klasse-J gegeben, wie sie in der Literatur beschrieben ist (z. B. in "On the Continuity of High Efficiency Modes in Linear RF Power Amplifiers", siehe IEEE Microwave and Wireless Components Letters, Band 19, Ausgabe 10, Seiten 665 - 667, 2009, und Wright, P., Lees, J., Benedikt, J., Tasker, PJ, Cripps, SC, "A Methodology for Realizing High Efficiency Clas-J in a Linear and Broadband PA", IEEE-Transactions on Microwave Theory and Techniques, Band 57, Ausgabe 12, Teil 2, 2009). Dieses Abschlusskontinuum bildet ein Wellenformkontinuum am intrinsischen Drain (oder Kollektor) der aktiven Vorrichtung (z. B. Transistor) ab, das eine konstante Ausgangsleistung und eine konstant hohe Effizienz über den gesamten Bereich des Kontinuums aufweist. In einer Ausgestaltung werden ungleiche Drain-Bias-Spannungen für die Haupt- und die Hilfsverstärkerkerne verwendet, und zwar derart, dass das Transformationsverhältnis (d.h. der Wellenwiderstand) des/der Impedanzinverter (s) derart geändert werden kann, so dass kontinuierliche multiharmonische Terminierungsbedingungen einfacher bzw. über eine größere Bandbreite erfüllt werden können. Die Anwendung der vorstehend beschriebenen Methode zur Realisierung einer hocheffizienten Breitband-HF-Leistungsverstärkung der Klasse-J in einem linearen und Breitband- Leistungsverstärker mit dem Konzept der aktiven Lastmodulation verbessert die Backoff-Effizienz des Leistungsverstärkers und es ist es möglich, eine hocheffiziente Leistungsverstärkung über eine große relative Bandbreite > 30% zu realisieren. Zusammenfassend zeigt die EP 2 879 291 A1 eine Lösung mit einem Impedanzinverter und einem Combiner auf, der bereits im Verhältnis zur Wellenlänge kurze Leitungselemente als Ersatz für diskrete Kapazitäten und Induktivitäten enthält.

Weiterhin ist aus der DE102012105260 A1 eine Breitband-Doherty-Verstärkerschaltung mit Konstantimpedanzkombinierer bekannt. Die dort beschriebenen Ausführungsbeispiele benutzen einen Konstantimpedanzkombinierer mit einer charakteristischen Impedanz gleich dem erforderlichen lastmodulierten Zustand hoher Impedanz des Hauptverstärkers bei einer Dreiwege-Breitband-Doherty-Verstärkerschaltung, wenn ein erster und ein zweiter Spitzenverstärker abgeschaltet sind. In diesem schmalbandigsten Fall wird dem Hauptverstärker eine minimale Bandbegrenzung präsentiert. Ein signifikanter Anteil einer Bandbegrenzung wird von dem Hauptverstärkerpfad entfernt, wenn er in dem Back Off-Leistungsgebiet betrieben wird, was eine konstantere Leistung über der Frequenz und eine konstantere Effizienz über der Frequenz bei einem festen Back Off-Leistungspegel ergibt. Die dort beschriebenen Verstärkerausführungsbeispiele sind gut geeignet für breitbandige Anwendungen, so dass eine Verstärkerschaltung gleichzeitig zwei oder mehrere benachbarte Betriebsbänder abdecken kann oder konsistenter über ein gesamtes Betriebsband sein kann als zum Anmeldetag der DE102012105260 A1 existierende Architekturen. In einem Ausführungsbeispiel einer Verstärkerschaltung umfasst die Verstärkerschaltung einen Hauptverstärker, welcher in einer Klasse-B- oder AB-Betriebsart vorgespannt ist, einen ersten Spitzenverstärker (englisch "Peaking Amplifier"), welcher in einer Klasse-C-Betriebsart vorgespannt ist, einen zweiten Spitzenverstärker, welcher in einer Klasse-C-Betriebsart vorgespannt ist, und einen Konstantimpedanzkombinierer. Der Konstantimpedanzkombinierer weist einen mit einem Ausgang des Hauptverstärkers verbundenen ersten Knoten, einen mit einem Ausgang des ersten Spitzenverstärkers verbundenen zweiten Knoten, einen mit einem Ausgang des zweiten Spitzenverstärkers verbundenen dritten Knoten und einen mit einer Last verbundenen vierten Knoten auf. Der Konstantimpedanzkombinierer ist betreibbar, eine Lastimpedanz an dem vierten Knoten in eine transformierte Impedanz an dem dritten Knoten zu transformieren, z.B. zu ändern, und die gleiche transformierte Impedanz an dem ersten, zweiten und dritten Knoten bereitzustellen. Gemäß einem Ausführungsbeispiel eines Verfahrens zum Betreiben einer Verstärkerschaltung umfasst das in der DE102012105260 A1 beschriebene Verfahren:

- Vorspannen eines Hauptverstärkers in einer Klasse-B- oder AB-Betriebsart,
- Vorspannen eines zweiten Spitzenverstärkers in einer Klasse-C-Betriebsart,
- Vorspannen eines zweiten Spitzenverstärkers in einer Klasse-C-Betriebsart,
- Verbinden eines ersten Knotens eines Konstantimpedanzkombinierers mit einem Ausgang des Hauptverstärkers, eines zweiten Knotens des Konstantimpedanzkombinierers mit einem Ausgang des ersten Spitzenverstärkers, eines dritten Knotens des Konstantimpedanzkombinierers mit einem Ausgang des zweiten Spitzenverstärkers und eines vierten Knotens des Konstantimpedanzkombinierers mit einer Last, und
- Transformieren einer Lastimpedanz an dem vierten Knoten in eine transformierte Impedanz an dem dritten Knoten, so dass die gleiche transformierte Impedanz an dem ersten, zweiten und dritten Knoten bereitgestellt wird.

Gemäß einem anderen Ausführungsbeispiel einer Verstärkerschaltung umfasst die Verstärkerschaltung einen ersten Verstärker, welcher betreibbar ist, bei einem ersten Leistungspegel einzuschalten, einen zweiten Verstärker, welcher betreibbar ist, bei einem zweiten Leistungspegel unter dem ersten Leistungspegel einzuschalten, und einen dritten Verstärker, welcher betreibbar ist, bei allen Leistungspegeln eingeschaltet zu bleiben. Ein erster Leistungskombinierer ist betreibbar, eine Ausgabe des dritten Verstärkers mit einer Ausgabe des zweiten Verstärkers bei einem ersten Leistungskombinierknoten zu kombinieren, um eine erste kombinierte Verstärkerausgabe zu bilden. Ein zweiter Leistungskombinierer ist betreibbar, die erste kombinierte Verstärkerausgabe mit einer Ausgabe des ersten Verstärkers bei einem zweiten Leistungskombinierknoten zu kombinieren, um eine zweite kombinierte Verstärkerausgabe zu bilden. Ein Impedanzwandler ist betreibbar, eine Lastimpedanz der Verstärkerschaltung in eine transformierte Impedanz an dem zweiten Leistungskombinierknoten zu transformieren, wobei die transformierte Impedanz einer Impedanz des ersten und des zweiten Leistungskombinierers angepasst ist, beispielsweise dieser gleich ist. Gemäß einem anderen Ausführungsbeispiel eines Verfahrens zum Betreiben einer Verstärkerschaltung umfasst das in der DE102012105260 A1 beschriebene Verfahren:

- Einschalten eines ersten Verstärkers bei einem ersten Leistungspegel,
- Einschalten eines zweiten Verstärkers bei einem zweiten Leistungspegel unterhalb dem ersten Leistungspegel,
- Einschalten eines dritten Verstärkers bei allen Leistungspegeln,
- Kombinieren einer Ausgabe des dritten Verstärkers mit einer Ausgabe des zweiten Verstärkers an einem ersten Leistungskombinierknoten, um eine erste kombinierte Verstärkerausgabe zu bilden,
- Kombinieren der ersten kombinierten Verstärkerausgabe mit einer Ausgabe des ersten Verstärkers an einem zweiten Leistungskombinierknoten, um eine zweite kombinierte Verstärkerausgabe zu bilden, und
- Transformieren einer Lastimpedanz der Verstärkerschaltung in eine transformierte Impedanz an dem zweiten Leistungskombinierknoten, wobei von dem zweiten Leistungskombinierknoten zu dem ersten Leistungskombinierknoten keine Impedanztransformation auftritt.

Schließlich umfasst gemäß einem in der DE102012105260 A1 beschriebenen Ausführungsbeispiel einer Dreiwege-Breitband-Doherty-Verstärkerschaltung die Schaltung einen ersten Spitzenverstärker, welcher betreibbar ist, bei einem ersten Leistungspegel einzuschalten, einen zweiten Spitzenverstärker, welcher betreibbar ist, bei einem zweiten Leistungspegel unterhalb des ersten Leistungspegel einzuschalten, und einen Hauptleistungsverstärker, welcher betreibbar ist, bei allen Leistungspegeln einzuschalten. Der Hauptleistungsverstärker weist einen mit einer hohen Impedanzlastmodulierten Zustand auf, wenn der erste und der zweite Spitzenverstärker ausgeschaltet sind. Die Doherty-Verstärkerschaltung umfasst weiterhin einen Konstantimpedanzkombinierer, welcher mit einem Ausgang jedes Verstärkers verbunden ist. Der Konstantimpedanzkombinierer weist eine charakteristische Impedanz auf, welche der Impedanz des Hauptverstärkers in dem lastmodulierten Zustand mit hoher Impedanz angepasst ist, mit oder ohne einer Ausgangsanpassungseinrichtung, welche den Ausgang des Hauptverstärkers mit dem Konstantimpedanzkombinierer verbindet, gesehen von dem Ausgang des Hauptverstärkers.

Weiterhin ist in der DE 10 2010 018274 A1 ein Verfahren zur Auslegung einer elektronischen Schaltung mit einem Anpassnetzwerk, insbesondere zur Verwendung bei einem Doherty-Leistungsverstärker beschrieben, welches auf die Optimierung der aktiven Lastmodulation zielt. Das Verfahren zur Auslegung einer Kenngröße der elektronischen Schaltung, welche beispielsweise ein S-Parameter oder eine Kleinsignal-Rauschzahl oder ein effektiver Eingangsreflexionsfaktor oder ein effektiver Ausgangsreflexionsfaktor oder ein effektiver Ausgangswiderstand oder ein Rollet'scher Stabilitätsfaktor oder eine Leistungsverstärkung oder ein Intermodulationsprodukt der Ordnung n oder eine harmonische Verzerrung n-ter Ordnung oder ein Klirrfaktor oder eine Effizienz der Leistungsverstärkung oder eine Rauschzahl oder ein Kompressionspunkt oder eine Kompressionsleistung oder eine Kompression der Leistungsverstärkung oder ein Durchschnitt der Kleinsignal-Kenngröße oder ein Integral der Kleinsignal-Kenngröße ist, kann vollautomatisch - insbesondere rechnergesteuert - erfolgen. Hierzu werden Messdaten von Elementen der Schaltung, wie Transistoren, Impedanzen oder dergleichen, durch Messungen ermittelt. Die Messdaten werden in einem Programmablauf zur Berechnung der Elemente des Anpassnetzwerks der elektronischen Schaltung eingegeben. Hierdurch ist eine Berechnung der beispielsweise kapazitiven oder induktiven Elemente des Anpassnetzwerks möglich. Das Verfahren zur Auslegung der Schaltung weist mehrere Schritte auf. In einem ersten Schritt erfolgt ein Bestimmen eines ersten Wertes des ersten transformierten Quellreflexionsfaktors und eines zweiten Wertes des ersten transformierten Lastreflexionsfaktors. Für das Bestimmen des ersten Wertes und des zweiten Wertes sind mehrere Teilschritte vorgesehen. Es wird eine Anzahl von ersten Abständen bestimmt. Die ersten Abstände sind dabei keine euklidischen Abstände, sondern sogenannte Poincare-Abstände. Bei dem in der DE 10 2010 018274 A1 beschriebenen Verfahren wird eine beliebige oder vorgebbare Anzahl von ersten Punktepaaren mit einem ersten Paarpunkt auf dem ersten Kreis und einem zweiten Paarpunkt auf dem zweiten Kreis bestimmt. Der erste Paarpunkt auf dem ersten Kreis wird als erster transformierter Quellreflexionsfaktor und der zweite Paarpunkt auf dem zweiten Kreis wird als erster transformierter Lastreflexionsfaktor bestimmt. Jedem der ersten Punktepaare wird ein Wert der ersten Kenngröße zugeordnet. Die Zuordnung kann beispielsweise durch Berechnung anhand von Modellen und/oder Messung der Kenngröße der Schaltung erfolgen. In einem nachfolgenden Schritt des in der DE 10 2010 018274 A1 beschriebenen Verfahrens erfolgt ein Bestimmen des Anpassnetzwerks anhand des ersten Wertes des transformierten Quellreflexionsfaktors, des zweiten Wertes des transformierten Lastreflexionsfaktors, des Quellreflexionsfaktors und des Lastreflexionsfaktors. Der Schritt des Bestimmens des Anpassnetzwerks kann ebenfalls automatisiert erfolgen. Beispielsweise wird eine Topologie, also die Anordnung der Kapazitäten und Induktivitäten des ersten Anpassnetzwerks, ausgewählt. Nachfolgend werden die Kapazitätswerte und die Induktivitätswerte des Anpassnetzwerks aus dem ersten Wert des transformierten Quellreflexionsfaktors, aus dem zweiten Wert des transformierten Lastreflexionsfaktors, aus dem Quellreflexionsfaktor und aus dem Lastreflexionsfaktor berechnet. Zusammenfassend kann festgestellt werden, dass sich das Verfahren allerdings auf die Anpassbedingungen bei der Fundamentalen beschränkt und der Einfluss der Harmonischen wird nicht beschrieben.

Weiterhin wird in der DE 102014 115315 A1 eine Eingangsanpassung für HF-Leistungstransistoren gezeigt, d.h. eine Lösung für den Umgang mit dem typischerweise niederohmigen Eingangsverhalten von HF-Leistungstransistoren. Dieses Problem wird in der beanspruchten Verstärkerarchitektur durch klassische Leitungstransformation gelöst, indem der Transformator, welcher den Eingang des HF-Leistungstransistors vom Eingangs-Lead elektrisch entkoppelt und induktiv mit diesem koppelt, dazu ausgelegt ist, Signale zu sperren, die eine Frequenz unterhalb des HF-Frequenzbereichs des HF-Leistungstransistors aufweisen, so dass niederfrequente Signale nicht durch den Buckel in der Vorwärtsspannungsverstärkung bei niedrigen Frequenzen verstärkt werden. In einer weiteren Ausführungsform ist der Transformator dazu ausgelegt, Signale unterhalb des HF-Frequenzbereichs des HF-Leistungstransistors zu sperren und Signale innerhalb des HF-Frequenzbereichs des HF-Leistungstransistors weiterzuleiten, indem dieser das Gate des HF-Leistungstransistors vom Eingangs-Lead elektrisch entkoppelt und induktiv mit ihm koppelt.

Weiterhin wird in der DE 10 2014 213684 A1 eine Breitband Doherty-Verstärkerarchitektur gezeigt, die sowohl hinsichtlich der Verstärkerkerne wie auch eines Impedanzinverters und eines Combiners differentiell ausgeführt wird. Die differentielle Ausführung führt dabei implizit zu einer Terminierung der zweiten Harmonischen an den Verstärkerkernen. Es ist kein spezielles Netzwerk zur Terminierung der zweiten Harmonischen mehr notwendig. Dies vermeidet das Problem, dass ein dispersives Netzwerk entworfen werden muss, das sowohl die oberste Grundwellenfrequenz und die niedrigste 2. Harmonische korrekt terminiert. Kommen sich diesen beiden Frequenzen sehr nahe, wäre erforderlich, dass ein Netzwerk abrupt entlang der Frequenzachse sein Verhalten ändern müsste. Das ist aus Gütegründen nicht möglich und begrenzt daher die Bandbreite des Systems. Auch wenn es auf den ersten Blick vorteilhaft erscheint, dass die differentielle Leitungsführung implizit eine Terminierung der 2. Harmonischen herbeiführt, so ist doch klar, dass diese nicht gezielt in ihrem dispersiven Verhalten beeinflusst werden kann, so dass keine erweiterten Verstärkerklassen (Class-J, Class-F continuous) möglich sind.

Weiterhin wird in der DE 10 2016 106 278 A1 eine Breitband-Doherty-Verstärkerschaltung mit integriertem Transformationsleitungs-Balun beschrieben. Bei der gezeigten Doherty-Architektur sind alle Komponenten in einem Gehäuse integriert untergebracht. Eine gefaltete Leitung agiert gleichzeitig als Balun für den Übergang von symmetrischen zu unsymmetrischen Signalen und als Impedanztransformator. Der Impedanzinverter wird weiterhin als einfache λ/4 Leitung ausgeführt. Der Combiner in Form eines Übertragungsleitungs-Transformatorbaluns präsentiert automatisch eine hohe Impedanz bei der zweiten Harmonischen, wodurch eine größere Bandbreite erzielt wird. Es ist kein zusätzliches Netzwerk für die Terminierung der zweiten Harmonischen erforderlich und die Terminierung ist implizit gegeben.

Weiterhin wird in der DE 10 2016 123932 A1 eine in ein Bauelemente-Package integrierte Doherty Verstärkerschaltung gezeigt, bei welcher der Impedanzinverter anstelle einer λ/4 Leitung durch ein T-Netzwerk ersetzt wird. Die zweite Harmonische wird jeweils durch einen Serienschwingkreis (Saugkreis/Harmonic Trap) terminiert. Hierdurch wird der Austausch von Leistung bei der zweiten Harmonischen zwischen den Verstärkerkernen vermieden, was den Wirkungsgrad erhöht. Die Bandbreite der Terminierung definiert damit die Bandbreite über die eine hohe Effizienz erzielt werden kann.

Weiterhin wird in der DE 10 2016 105742 A1 eine Doherty Architektur gezeigt, die einen Impedanzinverter in Form einer klassischen λ/4 Leitung und einem Ausgangsleitungstransformator aufweist. Aufgrund hoher Primitivitätswerte und hoher Frequenzen fallen die Leitungslängen hinreichend kurz aus, so dass sie in einem Package Platz finden. Ein spezielles Netzwerk zur Bereitstellung eines bestimmten Terminierungverlaufes bei der zweiten Harmonischen ist nicht offenbart.

Weiterhin wird in der WO2011112129A1 eine Doherty Architektur gezeigt, die ein Zerlegungsübertragungssystem bereitstellt, das einen Datenquellenblock, einen digitalen Verarbeitungsblock, einen Verstärkungsblock, einen Kombinationsblock und einen Ausgabeblock/Monitor umfasst., wobei der digitale Verarbeitungsblock einen oder mehrere digitale Verarbeitungs-Unterblöcke aufweist, wobei jeder digitale Verarbeitungs-Unterblock dazu konfiguriert ist, eine mathematische Transformation an seinem Eingangssignal durchzuführen, um ein Signal aus dem Datenquellenblock in eine Mehrzahl von transformierten Signale zu zerlegen, und wobei jedes der Vielzahl von transformierten Signalen an einen entsprechenden Eingang des Verstärkungsblocks ausgegeben wird, wodurch die Effizienz und Linearität des Zerlegungsübertragungssystems verbessert werden. Im Einzelnen führen einige oder alle der digitalen Verarbeitungsunterblöcke in dem digitalen Verarbeitungsblock die mathematische Transformation durch, indem ein Rückkopplungssignal von dem Ausgabeblock/Monitor verwendet wird.

Um eine Miniaturisierung eines Senders mit einem Sendeverstärker zu ermöglichen, ist es aus der US2015229276A1 bekannt, dass ein erster Sendeverstärker, der entweder einen Trägerverstärker und einen Spitzenverstärker als ersten Verstärker und den anderen als zweiten Verstärker enthält, einen Übertragungsleitungstransformator mit einer ¼-Wellenlänge in dual-koaxialer Struktur aufweist, so dass ein Mittelleiter, ein Innenleiter und ein Außenleiter in dieser Reihenfolge von der Mitte nach außen ausgebildet sind, wobei der Innenleiter und der Innenleiter eine erste Koaxialleitung und der Innenleiter und der Außenleiter eine zweite Koaxialleitung bilden. Der Ausgang des ersten Verstärkers ist mit einem Ende der ersten und zweiten Koaxialleitung verbunden und ein Ausgangsanschluss ist mit dem anderen Ende der ersten und zweiten Koaxialleitung verbunden. Das andere Ende der ersten Koaxialleitung, der Ausgang des zweiten Verstärkers und das andere Ende sind mit der zweiten Koaxialleitung verbunden.

Weiterhin stellt Jing Li et al in "A 600W broadband three-way Doherty power amplifier for multistandard wireless Communications", 2015 IEEE MTT-S INTERNATIONAL MICROWAVE SYMPOSIUM, IEEE, 17. Mai 2015 (2015-05-17), Seiten 1-3, XP033181380, einen Hochleistungs-Breitband-Dreiwege-Doherty-Leistungsverstärker (3W-DPA) vor, der aus drei CREE CGHV22200-GaN-gekapselten Transistoren besteht. Um die Bandbreite zu erhöhen, werden sowohl für die Ausgangsanpassungs- als auch für die Kombinationsnetzwerke reduzierte Impedanztransformationsverhältnisse verwendet. Experimentelle Ergebnisse zeigen, dass der 3W-DPA eine gesättigte Ausgangsleistung von 600 W mit einem Drain-Wirkungsgrad von mehr als 35,5% bei 9 dB Back-Off-Leistungspegel über einen Breitband-Frequenzbereich von 1,9 GHz bis 2,2 GHz liefert, gemessen mit einem 10 %-Tastverhältnis-Impulssignal. Wenn der linearisierte DPA von einem modulierten 10-MHz-LTE-Signal mit einem Spitzen-zu-Durchschnitts-Leistungsverhältnis (PAPR) von 7,5 dB angesteuert wird, erreicht der linearisierte DPA eine durchschnittliche Effizienz von mehr als 40 % sowohl bei 1,92 GHz als auch bei 2,025 GHz mit einem ACLR von weniger als - 47dBc.

Weiterhin stellt Jingchu He et al in "A 500-W high efficiency LDMOS classical three-way Doherty amplifier for base-station applications",2016 IEEE MTT-S INTERNATIONAL MICROWAVE SYMPOSIUM (IMS), IEEE, 22. Mai 2016 (2016-05-22), Seiten 1-4, XP032941157 einen klassischen 500W-Dreiwege-Doherty-Leistungsverstärker (DPA) mit LDMOS-Bauelementen bei 1,8 GHz vor. Das optimierte Geräteverhältnis wird gewählt, um maximale Effizienz sowie Linearität zu erreichen. Mit einer einfachen Implementierung eines passiven Eingangstreibernetzwerks weist der Demonstrator eine Effizienz von mehr als 55% mit einem 9,9PAR WCDMA-Signal von 1805 MHz bis 1880 MHz auf. Es kann auf -60dBc-Pegel mit 20MHz LTE-Signal bei einer durchschnittlichen Ausgangsleistung von 49dBm linearisiert werden.

Schließlich ist aus der US10033335B1 ein Doherty-Leistungsverstärker bekannt, welcher zur Verbesserung der Effizienz und Verringerung des Stromverbrauchs eine Hauptvorrichtung in einer Hauptverstärkerschaltung und eine Hilfsvorrichtung in einer Hilfsverstärkerschaltung, die parallel zu der Hauptverstärkerschaltung angeordnet ist, enthält. Der Doherty-Leistungsverstärker enthält ferner ein Lastmodulationsnetzwerk mit einer ersten Leerlaufübertragungsleitung, die mit einem Ausgang des Hauptgeräts verbunden ist; eine zweite Leerlaufübertragungsleitung, die mit einem Ausgang der Hilfsvorrichtung verbunden ist; und ein Impedanztransformations- und Phasenkompensationsnetzwerk, das mit dem Ausgang des Hauptgeräts und dem Ausgang des Hilfsgeräts verbunden ist, um eine kombinierte Ausgangsleistung bereitzustellen. Die erste und die zweite Leerlaufübertragungsleitung sind direkt benachbart zueinander angeordnet, um im Betrieb eine gegenseitige Kopplung zwischen ihnen zu bilden. Durch die gegenseitige Kopplung zwischen zwei kurzgeschlossenen Netzwerken/Komponenten der zweiten Harmonischen kann eine höhere Effizienz über eine breite Bandbreite erreicht werden, ohne dass zusätzliche Komponenten oder komplexe Schaltungen erforderlich sind.

Wie die vorstehende Würdigung des Standes der Technik aufzeigt, sind zahlreiche breitbandige Doherty -Verstärkerschaltungen, insbesondere mit aktiver Lastmodulation für verschiedene Anwendungsfälle seit langem bekannt. Beispielsweise werden HF-Leistungsverstärker für die Sendesignale im aeronautischen L-Band (960 MHz - 1215 MHz), insbesondere Endstufenverstärker für Übertragungs-, Lokalisierungs- und Sekundärradarstandards des Flugfunks SSR, Mode-S, UAT, L-DACS, ADS-B und DME eingesetzt. Weiterhin werden digitale Sende- und Empfangsvorrichtung im Bereich der funkbasierten Flugverkehrskontrolle verwendet, welche eine Plattform für Dienste wie ADS-B (Winkelschätzung, Zeitdifferenz) innerhalb von SSR und UAT Standards oder Kommunikation sowie Navigation innerhalb von L-DACS Standard ist. Empfangs- und Sendedaten können mittels Kommunikationsschnittstellen mit einem oder mehreren zentralen Servern ausgetauscht werden. Dementsprechend besteht in der Praxis die Anforderung nach einem Mehrzweck-Leistungsverstärker, welcher den Anforderungen aller Standards genügt, insbesondere nach einem digitalen Sende- und Empfangsmodul in Verbindung mit integrierten Elektronik, welches den rauen Außen-/Freilufteinsatz sowie Innenraumbetrieb widerstehen und dadurch einen langlebigen Betrieb ermöglichen soll. Beispiele für externe bzw. Umwelt-Einflüsse sind:

- Wettereinflüsse (z.B. Umgebungstemperatur),
- Elektrische Einflüsse (z.B. Blitzeinschläge, Überspannung, Überstrom),
- Installationsort Einflüsse (z.B. Antennenkabellänge, Verschmutzung, Industriestaub) u.a.

Im Bereich des Verstärkerdesigns stehen die Ziele:

- hohe Effizienz für modulierte Wellenformen
- hohe Spitzenleistung
- hohe relative Bandbreite
- hohe Linearität

miteinander im Konflikt. Durch geeignete konstruktive Maßnahmen in Verbindung mit der Elektronik soll die Architektur für Hochleistungs- und Breitbandanwendungen geeignet sein, das Unterdrücken von parasitären Effekten, insbesondere der Kompensation von Drain-Parasiten ermöglichen und es soll ein einfacher Aufbau erreicht werden, welcher ein wirtschaftlich effizientes und robustes Produkt gewährleistet.

Der Erfindung liegt die Aufgabe zugrunde, durch geeignete konstruktive Maßnahmen in Verbindung mit der Elektronik eine für Hochleistungs- und Breitbandanwendungen geeignete Hochleistungs- Sende- und Empfangsvorrichtung mit über 10 Watt bis ca. 2.000 Watt Sendeleistung bereitzustellen.

Diese Aufgabe wird durch eine Sende- und Empfangsvorrichtung mit den Merkmalen des unabhängigen Patentanspruchs 1 gelöst.

Durch diese Ausgestaltung der Erfindung wird eine digitale, energieeffiziente, lüfterlose und gegen Blitzeinschläge geschützte, konfigurierbare Hochleistungs- Sende- und Empfangsvorrichtung für mehr als 1000 Watt Sendeleistung bereitgestellt.

Weitere Vorteile und Einzelheiten lassen sich der nachfolgenden Beschreibung von bevorzugten Ausführungsformen der Erfindung unter Bezugnahme auf die Zeichnungen entnehmen. In der Zeichnung zeigt:

Fig. 1 das Blockschaltbild einer Ausführungsform der erfindungsgemäßen Sende- und Empfangsvorrichtung,

Fig. 2 das Blockschaltbild der Sende- Empfangsanlage für den Anwendungsfall Flughafen,

Fig. 3 das Diagramm von PAE (Power Added Efficiency) über die Sendefrequenz des erfindungsgemäßen HF-Leistungsverstärkers,

Fig. 4 den Schaltungsaufbau zur Messung der HF-Sendeleistung nach einem OTA-Test (Over the air-Test),

Fig. 5 das Leiterplattengehäuse für die Gasentladungshülse des erfindungsgemäßen Moduls GSZ im Schnitt,

Fig. 6 das Leiterplattengehäuse nach Fig. 5 in Draufsicht,

Fig. 7 das elektrische Ersatzschaltbild einer Ausführungsform eines aktiven lastmodulierten HF-Leistungsverstärker,

Fig. 8 verschiedene Antennenkonfigurationen der erfindungsgemäßen Sende- und Empfangsvorrichtung,

Fig. 9 die Architektur eines 3-Wege-Doherty mit zusätzlichen Mikrostreifenleitungen gemäß der Erfindung,

Fig. 10 die relative Bandbreite eines rudimentären Zwei-Wege Dohertys ohne Transformatoren (Stand der Technik),

Fig. 11 die relative Bandbreite eines rudimentären Zwei-Wege Dohertys mit Versatzleitungen am Hauptleistungsverstärker und aktiven Lastmodulatoren/Spitzenleistungsverstärkern,

Fig. 12 die relative Bandbreite eines rudimentären Drei-Wege Dohertys ohne Transformatoren (Stand der Technik),

Fig. 13 die relative Bandbreite eines rudimentären Drei-Wege Dohertys mit Versatzleitungen am Hauptleistungsverstärker und aktiven Lastmodulatoren/Spitzenleistungsverstärkern gemäß der Erfindung,

Fig. 14 einen Aufbau eines Dreifach-Eingangs mit Treiberfunktion,

Fig. 15 ein Layout einer ersten Ausführungsform eines Ausgangskombinierers (Lastangepasster Kombinierer LMC),

Fig. 16 ein Layout einer zweiten Ausführungsform eines Ausgangskombinierers (Breitband Back-off Kombinierer WBC),

Fig. 17 die durchschnittliche Leistungseffizienz PAE an den Back-off-Punkten des Ausgangskombinierers nach Fig. 15,

Fig. 18 die Effizienz und die Verstärkung des HF-Leistungsverstärker HPA mit einem Ausgangskombinierer nach Fig. 15 bei verschiedenen Frequenzen,

Fig. 19 die durchschnittliche Leistungseffizienz PAE für Rayleigh-verteilte Spannungswellenformen,

Fig. 20 die durchschnittliche Leistungseffizienz PAE an den Back-off-Punkten des Ausgangskombinierers nach Fig. 16,

Fig. 21 die Effizienz und die Verstärkung des HF-Leistungsverstärker HPA mit einem Ausgangskombinierer nach Fig. 16 bei verschiedenen Frequenzen,

Fig. 22 die durchschnittliche Leistungseffizienz PAE für Rayleigh-verteilte Spannungswellenformen,

Fig. 23 das Diagramm für Gate-Strom und Kompressionsniveau eines GaN-HEMT Lei stungsverstärkers,

Fig. 24 Transistormodel mit Drain-Parasiten,

Fig. 25 Transistormodel mit Absorptionsnetzwerk,

Fig. 26 das Ersatzschaltbild eines nicht-linearen Transistors mit Absorptionsnetzwerk und Spannungsversorgung,

Fig. 27 das Ersatzschaltbild eines Transformator-basierten Zwei-Wege Doherty Lei stungsverstärkers,

Fig. 28 die relative Bandbreite für einen statischen Splitter und Steuerfunktion,

Fig. 29 die relative Bandbreite eines Zwei-Wege HF-Hochleistungsverstärker mit Transformatoren und das dazugehörige Parameter $\sigma$ (zur Einstellung der Performanz der Leistungstransistoren) der optimierten Kurven,

Fig. 30    einen Drei-Wege Doherty Leistungsverstärker mit drei Referenzebenen (Stand der Technik) und

Fig. 31    ein Teilnetzwerk für jeden einzelnen Verstärker (Modell).

Fig. 32    ein Layout einer Ausführungsform des erfindungsgemäßen Moduls,

Fig. 33    im Schnitt ein Detail des konstruktiven Aufbau des erfindungsgemäßen Moduls,

Fig. 34    im Schnitt eine weitere Ausführungsform des Details,

Fig. 35    das Blockschaltbild einer Ausführungsform zur Drain-Strom-Messung und

Fig. 36    das Blockschaltbild einer Ausführungsform zur Gate-Strom-Messung.

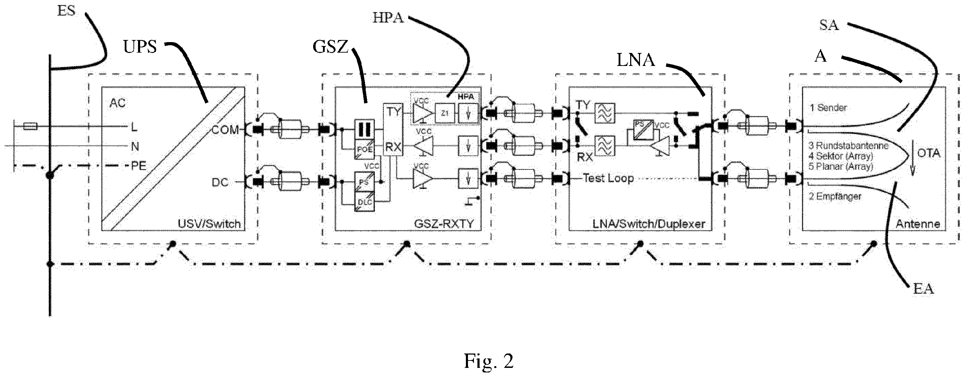

Fig. 2 zeigt das Blockschaltbild einer Ausführungsform der Sende- Empfangsanlage für den Anwendungsfall Flughafen (Bodenstation), welche aus vier Komponenten besteht, nämlich eingangsseitig eine unterbrechungsfreie Stromversorgungseinheit UPS und nachfolgend ein Modul GSZ, eine schaltbare rauscharme Verstärkerschaltung LNA und eine Antenne A. Die Gehäuse der sämtlichen Komponenten des Systems (der Sende- Empfangsanlage) sind potentialfrei aufgebaut. Das Gehäuse kann entweder das Potential von Schutzerde (PE protective earth, Schutzleiter) annehmen oder kann als Faradaykäfig (d.h. als allseitig geschlossene Hülle, welche als elektrische Abschirmung wirkt) ausgestaltet sein, welcher im inneren Bereich feldfrei ist. Die Elektronik der Komponenten ist elektrisch isoliert vom Gehäusepotential.

Das Modul UPS ist eine unterbrechungsfreie Stromversorgungseinheit und wird aus dem Wechselstromnetz versorgt. Ausgangsseitig liefert die Stromversorgungseinheit UPS eine 48V DC-Telekommunikationsspannung (DC direct current, d.h. Gleichspannung). Die Stromversorgungseinheit UPS kann mit dem Modul GSZ entweder über PLC (Power Line Communication) oder über eine COM-Schnittstelle (Communication Equipment) Nutzdaten austauschen. Dabei ermöglicht erfindungsgemäß der Ausgang eine potentialgetrennte Installation. Auf diese Weise ist die Elektronik, die von der Telekommunikationsspannung versorgt wird, vom PE (Protection Earth)-Potential frei. Dieses Stromversorgungskonzept gewährleistet einen Schutz gegenüber Überstrom und Überspannung, die auf der PE-Leitung auftreten können. Ein weiterer Vorteil ist, dass die DC-Versorgungsleitungen ($V_{DC}$ und GND) von den Störeigenschaften des Schutzleiters (PE) physikalisch und elektrisch entkoppelt sind, so dass eine Verbesserung des SNR (Signal-to-Noise Ration) ermöglicht ist. Infolgedessen ist eine störungsarme Übertragung von PLC- und COM-Signalen sichergestellt, da keine Kopplung von den Störsignalen des Schutzleiters (PE) auftritt.

Die Sende- Empfangsanlage weist ferner den energieeffizienten HF-Hochleistungsverstärker HPA gemäß der Erfindung auf, welcher für die Sendesignale im aeronautischen L-Band (960 MHz - 1215 MHz) mit einer maximalen Sendeleistung von ca. 63 dBm (ca. 2.000 Watt), d.h. einer Impulssendeleistung von ca. 2.000 Watt geeignet ist. Dabei wird dieser als Endstufenverstärker für Übertragungsstandards des Flugfunks SSR, Mode-S, UAT, L-DACS und DME eingesetzt. Der HF-Hochleistungsverstärker HPA ist ein Bestandteil eines Moduls GSZ, welches als Ground Station Indoor/Outdoor mit drei Receivern und einem Hochleistungs-Sender als eine preisgünstige, digitale Sende- und Empfangsvorrichtung zur Verwendung im Bereich der funkbasierten Flugverkehrskontrolle konzipiert ist. Die Sende- und Empfangsvorrichtung ist eine Plattform für Dienste wie ADS-B (Winkelschätzung, Zeitdifferenz) innerhalb von SSR und UAT Standards oder Kommunikation sowie Navigation innerhalb von L-DACS Standard. Empfangs- und Sendedaten können mittels Kommunikationsschnittstellen mit einem oder mehreren zentralen Servern ausgetauscht werden. Erfindungsgemäß ist das Modul GSZ eine digitale, energieeffiziente, lüfterlose Sende- und/oder Empfangseinrichtung mit einer Sendeleistung von bis zu 63 dBm für das aeronautische L-Band. Das Baukasten-Aufbauprinzip des Moduls GSZ lässt unterschiedliche Konfigurationen zu, von 1-Fach Sende- bzw. Empfangseinrichtung über 7-Fach Empfänger bis zu 3-Fach Empfänger mit einem Hochleistungssender.

Das mit dem Ausgang des Moduls UPS verbundene Modul GSZ kann in zwei Ausführungsformen ausgestaltet werden, nämlich sowohl für den Innenraumbetrieb via kompakten 19" Rack, als auch für den Außen-/Freilufteinsatz in einem robusten, kompakten IP67-Outdoor Gehäuse (IP 67: staub- und wasserdicht). Durch Steigerung der Effizienz des HF-Hochleistungsverstärker HPA und als Folge einer Reduktion der Verlustleistung ist die Kühlung des Moduls GSZ rein passiv, d.h. beide Gehäusetypen können erfindungsgemäß lüfterlos entworfen werden. Das reduziert zum einen den Wartungsaufwand und verlängert zum anderen die Lebensdauer.

Mit dem Ausgang des Moduls GSZ ist die schaltbare rauscharme Verstärkerschaltung LNA verbunden (siehe Fig. 2), welche einen Low Noise Amplifier (LNA) zum Verstärken vom Empfangssignal, zwei Filter/Duplexer (einen im Sendezug und einen im Empfangszug liegend) und eine Switch Schaltung aufweist. Alle Empfängerkanäle und ein Test-Loop Kreis besitzen eine gesteuerte Spannungsversorgung zum Ein-, Aus- und Umschalten des Low Noise Amplifiers (LNA), der Switch- Schaltung sowie der beiden Filter/Duplexer. Die Switch Schaltung kann den Sendezug und den Empfangszug entweder am Moduleingang oder nach dem Filter/Duplexer samt LNA kurzschließen. Des Weiterem kann auch der Test-Loop Kreis mit dem Empfangszug kurzgeschlossen werden. Zusammen mit einem OTA-Test (over the air) werden einzelne Elemente (Kabel, Filter/Duplexer, LNA, Stecker, Antenne) auf ihre korrekte Funktionalität geprüft. Der Aufbau der erfindungsgemäßen Sende-/Empfangsanlage ermöglicht einen Fehler zwischen dem Modul GSZ und einer Antenne A selektiv zu bestimmen. Der Zeitaufwand für die Wartung und Fehleranalyse ist dadurch stark reduziert, weil lediglich Elemente ausgetauscht oder repariert werden, die einen Fehler aufweisen.

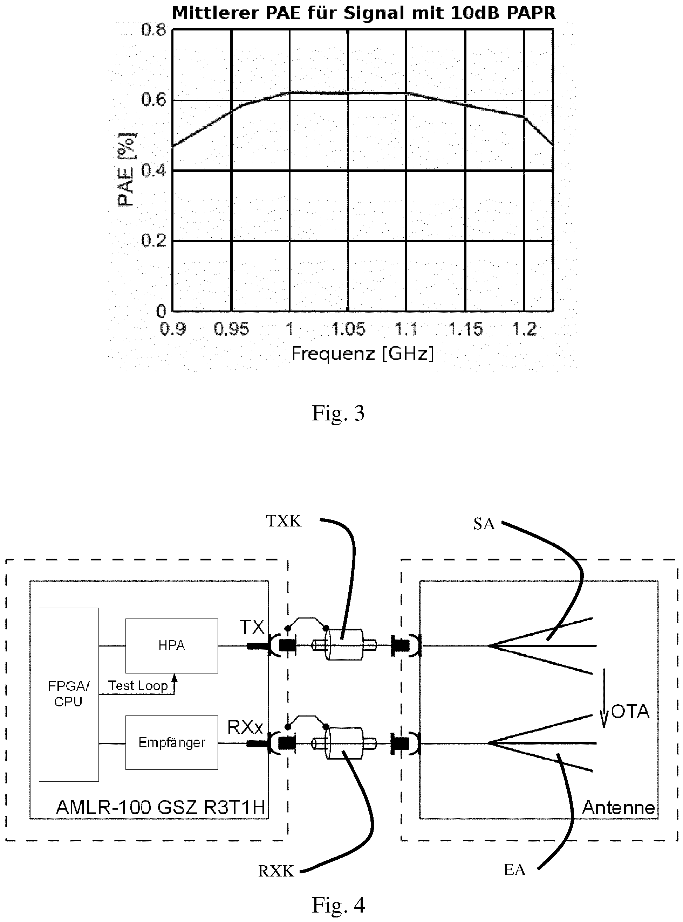

Zusammenfassend ist die Funktionalität von LNA/Switch/Duplexer im Modul LNA wie folgt. Das Modul LNA (schaltbare rauscharme Verstärkerschaltung) beinhaltet den LNA (Low-Noise-Amplifier), welcher im Empfangszug integriert ist. Im Empfangsbetrieb kann LNA entweder ein- oder ausgeschaltet werden. Wenn der LNA eingeschaltet ist wird das Empfangssignal zusätzlich verstärkt. Dies kann entweder bei einer schwachen Empfangssignalleistung oder zum Ausgleich der Verluste auf den Kabeln (z.B. RX-Kabel RXK oder TX-Kabel TXK, siehe Fig. 4) zwischen dem Modul GSZ und dem Antennenmodul A erfolgen.

Des Weiteren umfasst das Modul LNA entweder einen Duplexer oder ein Filter, jeweils im Sende- und Empfangszug. Duplexer bzw. Filter sind rein passive Bauelemente.

Für die Test und Wartungszwecke sind im LNA Modul mehrere Switches verbaut Die Switches erlauben den Sendezug mit dem Empfangszug kurzzuschließen. Wenn der Switch am Eingang von LNA Modul kurzgeschlossen ist, kann eine Analyse des Kabels zwischen Modul GSZ und LAN Modulen durchgeführt werden. Die Switch-Matrix erlaubt einen Kurzschluss von und nach dem LNA zu erzeugen. Dadurch kann die Qualität und die Verstärkung von LNA online oder in bestimmten Zeitabständen durchgeführt werden. Außerdem ermöglicht die Switch-Matrix einen Antennentest. Dabei wird das Sendesignal über die Testloop in die Sendeantenne SA herausgeschickt und über die Freiraumkopplung an der Empfangsantenne EA empfangen. Die Sendeleistung von der Testloop kann auf den erlaubten kleinen Pegel eingestellt werden, so dass keine Kommunikationsstörungen beim Antennentest erzeugt wird.

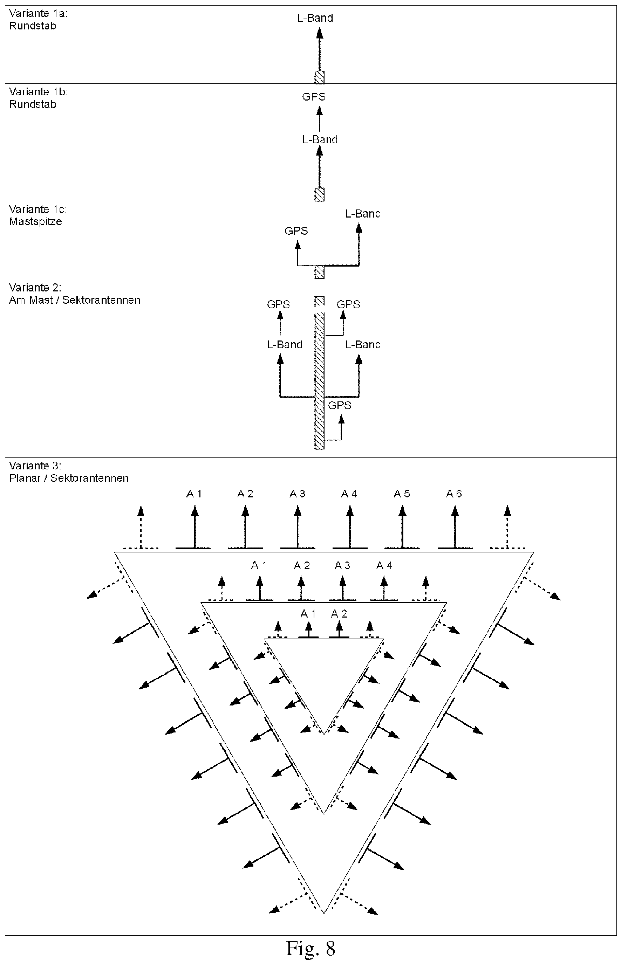

Der Aufbau der Antenne A ist von der Konfigration des Moduls GSZ abhängig, welche parallel geschaltet werden können, so dass sich dadurch die Anzahl der möglichen Antennenkonfigurationen steigert. Somit ist der Betrieb von Antennen im planaren Aufbau ermöglicht. Verschiedene Antennenkonfigurationen sind in Fig. 8 dargestellt.

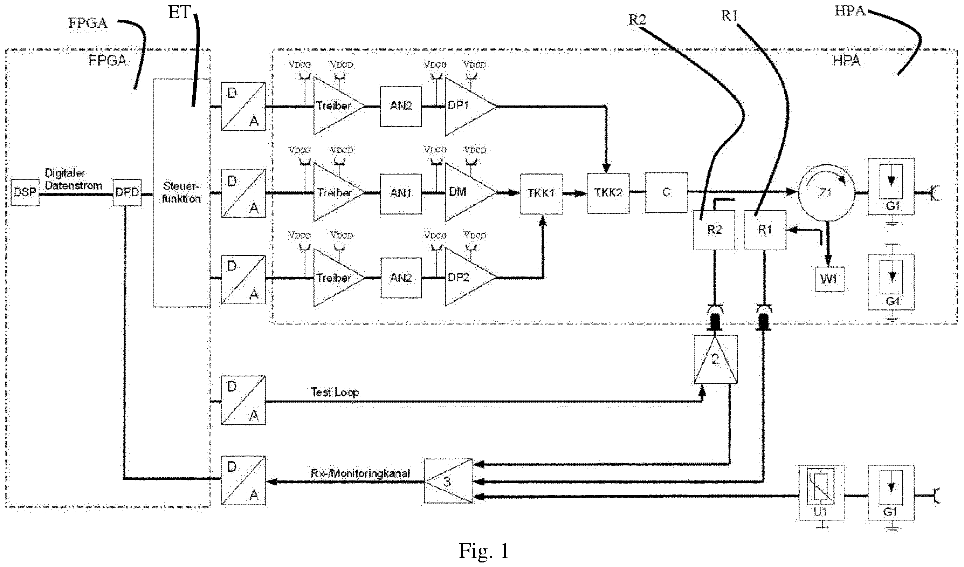

Der HF-Hochleistungsverstärker HPA als Teil des Moduls GSZ wird im Folgenden anhand der Fig. 1 für den Anwendungsfall Flughafen, insbesondere für das derzeitige aeronautische L-Band (derzeit 1 GHz bis 2,6 GHz) bei einem Ortungsverfahren mit Laufzeitmessung (Sekundärradarprinzip) näher beschrieben und erläutert. Die Sender der Sekundärradargeräte sind in der Flugsicherung meist für eine Impulsleistung von 2000 Watt ausgelegt, können jedoch in -3dB Schritten in der Sendeleistung reduziert werden. Im Rahmen der Erfindung ist der Einsatz bei dem derzeitigen Mobilfunkstandard der dritten Generation LTE (Long Term Evolution auch 3.9G genannt) oder der zukünftigen Erweiterung LTE-Advanced bzw. 4G genannt, im Projekt Next Generation Mobile Networks (NGMN) oder im VHF-Flugfunkband, derzeit 117,975 MHz bis 137 MHz für den Navigationsfunkdienst mit Drehfunkfeuer (Very High Frequency Omnidirectional Radio Rang VOR), oder dem Instrumentenlandesystem (Instrument Landing System ILS), derzeit 108 MHz bis 117,975 MHz, möglich.

Die Effizienz des Moduls GSZ ist abhängig von der PAE (Power Added Efficiency) des HF-Hochleistungsverstärker HPA. Klassische HF-Hochleistungsverstärker mit hoher Leistungseffizienz PAE weisen eine schlechte Linearität auf. Niedrige Linearität führt dazu, dass die Sendesignale leistungsabhängige Amplituden- und Phasen-Modulationen erfahren. Modulationen erzeugen Sendesignal-Verzerrungen sowie In- und Außerbandstörungen. Bei einem Modulationsschema wie OFDM (Orthogonal Frequency Division Multiplex) kann die Sendesignal-Verzerrung dazu führen, dass das empfangsseitige Signal nicht demoduliert werden kann was eine Unterbrechung der Kommunikation bedeutet.

Um hohe PAE-Werte und eine lineare Ausgangskennlinie des HF-Hochleistungsverstärker HPA zu erreichen, wurde der HF - Endstufenverstärker als Drei-Wege Doherty Verstärker mit der maximalen Ausgangsleistung von 63 dBm ausgestaltet. Der HF-Hochleistungsverstärker HPA hat eine durchschnittliche Leistungseffizienz PAE von 56 % (siehe Fig. 3: mittlere PAE für Signal mit 10db PAPR) und eine lineare Ausgangskennlinie mit zwei Leistungs-Backoff-Punkten und ist in Klasse-JFont Betrieb implementiert. Durch einen mit den drei Verstärkerausgängen verbundenen Ausgangskombinierer C wird eine Impedanz für HF-Bandbreite des HF-Hochleistungsverstärkers HPA dargestellt. Die Impedanz am Ausgangsanschlussknoten des Ausgangskombinierers C beträgt 50 Ω.

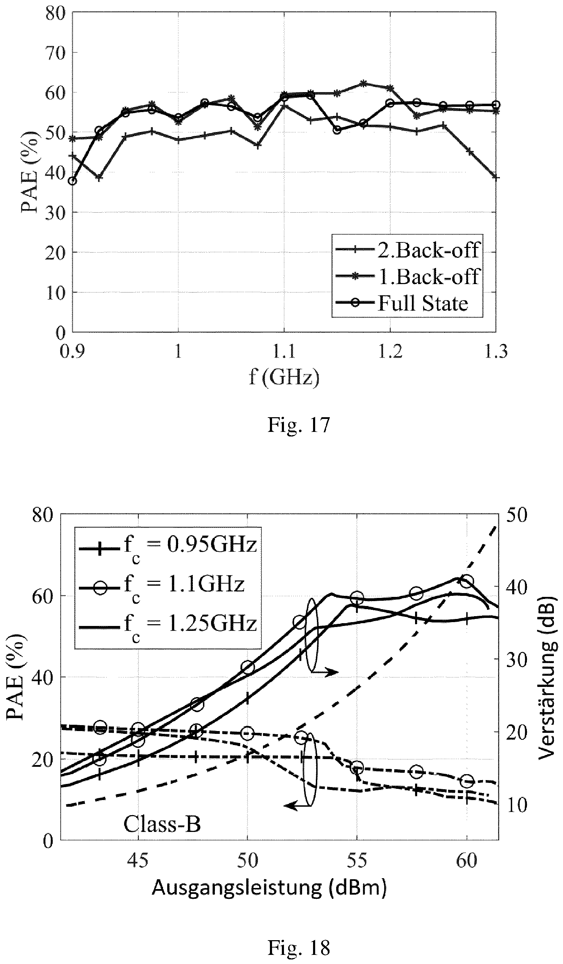

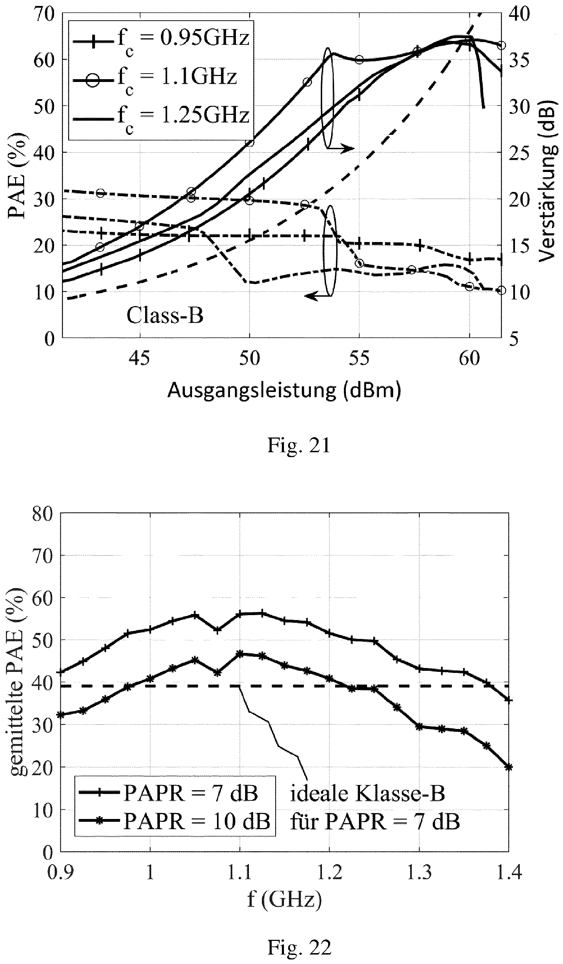

Gemäß dem Doherty-Prinzip sind drei Verstärker, nämlich Hauptleistungsverstärker DM, erster Spitzenleistungsverstärker DP1 und zweiter Spitzenleistungsverstärker DP2 im Betrieb, wenn das Sendesignal den Spitzenwert erreicht und sind jeweils mit einer Lastmodulation versehen, welche höchste Ausgangsleistungen erlaubt. Wenn die Leistung des Sendesignals abnimmt, schaltet sich der zweite Spitzenleistungsverstärker DP2 ab und es arbeiten nur zwei Verstärker (nämlich Hauptleistungsverstärker DM, erster Spitzenleistungsverstärker DP1), was als erstes Leistungs-Backoff bezeichnet wird. Wenn die Leistung des Sendesignals weiterhin sinkt, schaltet sich der erste Spitzenleistungsverstärker DP1 ab und es arbeitet nur noch der Hauptleistungsverstärker DM, was als zweites Leistungs-Backoff bezeichnet wird. Die Spitzenleistungsverstärker DP1, DP2 schalten bei reduzierter Sendeleistung ab, um eine optimale Lastmodulation zu erreichen. Damit werden ein hoher Wirkungsgrad und eine hohe Verstärkung gewährleistet. Der HF-Hochleistungsverstärker HPA verstärkt nur die Grundwelle des modulierten Sendesignals und die höheren harmonischen werden möglichst breitbandig kurzgeschlossen (gegenläufiges Verhalten, d.h. Grundwelle kapazitiv und Oberwelle induktiv). Auf diese Weise werden sowohl ein hohe Bandbreite als auch ein hoher Wirkungsgrad erreicht. Die hohe Linearität ist somit ein weiteres Merkmal des erfindungsgemäßen HF-Hochleistungsverstärkers HPA (siehe Fig. 18 und Fig. 21). Damit kann man sämtliche Modulationsverfahren bei der Erzeugung von Sendesignale verwenden, z.B. AM, GPSK, OFDM (andere Verfahren sind auch denkbar) und das über das komplette aeronatical L-Band. Die Festlegung von Verfahren auf die bestimmte Frequenz innerhalb vom L-Band ist nur durch die Standards bedingt.

Der aeronatical L-Band liegt zwischen 960 MHz und 1215 MHz. Der erfindungsgemäße HF-Hochleistungsverstärker HPA (High-Power-Amplifier) erreicht im kompletten L-Band hohe Effizienz und Linearität, was nicht so trivial ist. Die parasitären Induktivitäten und Kapazitäten von GaN-Transistoren sowie die Leiterbahnstrukturen (Absorbtionsnetzwerk ABN, Impedanzwandler AN1, $\lambda$/2- und $\lambda$/4-Mikrostreifenleitungen, Ausgangskombinierer C) besitzen eine frequenzabhängige Impedanz. Zudem ist die Impedanz bei den hochfrequenten Signalen eine Funktion des Ortes. Das stellt eine weitere Herausforderung, weil die Oberwellen (mindestens 2.) beim erfindungsgemäßen HF-Hochleistungsverstärker HPA kurzgeschlossen werden. Die Implementierung vom erfindungsgemäßen HF-Hochleistungsverstärker HPA ist nun so gestaltet, dass er im L-Band eine impedanzangepasste Leiterbahnstruktur besitzt. Insbesondere ist der erfindungsgemäße HF-Hochleistungsverstärker HPA nicht nur für eine Designfrequenz angepasst, sondern auch für kompletten L-Band einschließlich Bandgrenzen (wobei um dies zu erreichen eine geeignete Steuerfunktion notwendig ist). Damit ist der erfindungsgemäße HF-Hochleistungsverstärker HPA breitbandig was ein Merkmal im Vergleich zum Stand der Technik ist.

Die relative Bandbreiteneffizienz ist eine Größe um unterschiedliche Verstärker oder Filter miteinander zu vergleichen, siehe insbesondere Seite 43 oder Seite 32 der Beschreibung.

Weiterhin ist in der vorliegenden Beschreibung auf der Seite 45/46 eine relative Bandbreiteneffizienz BE vom erfindungsgemäßen HF-Hochleistungsverstärker HPA angegeben, die deutlich höher ist als z.B. aus den eingangsseitig beschriebenen Veröffentlichungen bekannt (siehe Seite 2 der Beschreibung). Die Bandbreiteneffizienz BE ist ein Verlust von 10% - Punkten zu der maximalen Effizienz und kann berechnet werden als:

$$BE = 2*(fo-fu)/(fo+fu).$$

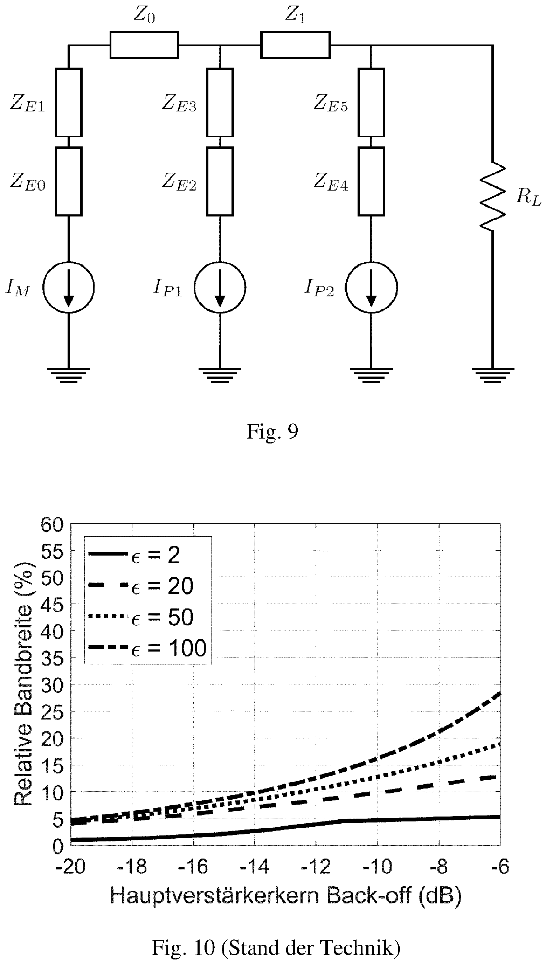

Der klassische "barebone" Drei-Wege Doherty Power Amplifier DPA wird durch Anbringen zusätzlicher $\lambda$/4 Impedanzinverter an den Spitzenleistungsverstärkerkernen DP1, DP2 sowie am Hauptverstärkerkern DM erweitert. Die Architektur eines 3-Wege-Doherty mit zusätzlichen Mikrostreifenleitungen ist in Fig. 9 dargestellt. Alle Mikrostreifenleitungen besitzen die Länge L = $\lambda_d$/4

Die Gleichungen sind durch Verwendung von ABCD Parametern (auch Kettenmatrizen genannt) abgeleitet. Um das gegebene Netzwerk für die Frequenz des Entwurfs aufzulösen wird es in drei verschiedene Subnetzwerke zerlegt. Das erste Subnetzwerk A verbindet den Hauptverstärker DM mit dem ersten Spitzenleistungsverstärker DP1. Das zweite Subnetzwerk B verbindet den Hauptverstärker DM mit dem zweiten Spitzenleistungsverstärker DP2, wohingegen C zwei Spitzenleistungsverstärker DP1, DP2 miteinander verbindet. Die ABCD-Matrizen der Subnetzwerke sind folgendermaßen gegeben:

$$\mathbf{A} = \begin{bmatrix} \frac{R_L\, Z_0\, Z_{E0}\, Z_{E3}\, i}{Z_1^2\, Z_{E1}\, Z_{E2}} & \frac{Z_0\, Z_{E0}\, Z_{E2}\, i}{Z_{E1}\, Z_{E3}} \\ \frac{Z_{E1}\, Z_{E3}\, i}{Z_0\, Z_{E0}\, Z_{E2}} & 0 \end{bmatrix} \quad (1)$$

$$\mathbf{B} = \begin{bmatrix} -\frac{Z_0\, Z_{E0}\, Z_{E5}}{Z_1\, Z_{E1}\, Z_{E4}} & 0 \\ -\frac{Z_1\, Z_{E1}\, Z_{E5}}{R_L\, Z_0\, Z_{E0}\, Z_{E4}} & -\frac{Z_1\, Z_{E1}\, Z_{E4}}{Z_0\, Z_{E0}\, Z_{E5}} \end{bmatrix} \quad (2)$$

$$\mathbf{C} = \begin{bmatrix} \infty & j\frac{Z_1\, Z_{E4}^2}{Z_{E5}^2} \\ \infty & j\frac{Z_1}{R_L} \end{bmatrix} \quad (3)$$

Der nächste Schritt ist die Berechnung der Impedanzen an den Anschlüssen der Stromquellen:

$$Z_m = \frac{\mathbf{A}_{1,1}}{\mathbf{A}_{2,1}} + \frac{1}{\mathbf{A}_{2,1}}\frac{I_{p1}}{I_m} + \frac{1}{\mathbf{B}_{2,1}}\frac{I_{p2}}{I_m} \qquad (4)$$

$$= \frac{R_L Z_0^2 Z_{E0}^2}{Z_1^2 Z_{E1}^2} - \frac{I_{p2} R_L Z_0 Z_{E0} Z_{E4}}{I_m Z_1 Z_{E1} Z_{E5}} \qquad (5)$$

$$-j\frac{I_{p1} Z_0 Z_{E0} Z_{E2}}{I_m Z_{E1} Z_{E3}} \qquad (6)$$

$$Z_{p1} = \frac{\mathbf{A}_{2,2}}{\mathbf{A}_{2,1}} + \frac{1}{\mathbf{A}_{2,1}}\frac{I_m}{I_{p1}} + \frac{1}{\mathbf{C}_{2,1}}\frac{I_{p2}}{I_{p1}} \qquad (7)$$

$$= -j\frac{I_m Z_0 Z_{E0} Z_{E2}}{I_{p1} Z_{E1} Z_{E3}} \qquad (8)$$

$$Z_{p2} = \frac{\mathbf{B}_{2,2}}{\mathbf{B}_{2,1}} + \frac{1}{\mathbf{B}_{2,1}}\frac{I_m}{I_{p2}} + \frac{1}{\mathbf{C}_{2,1}}\frac{I_{p1}}{I_{p2}} \qquad (9)$$

$$= \frac{R_L Z_{E4}^2}{Z_{E5}^2} - \frac{I_m R_L Z_0 Z_{E0} Z_{E4}}{I_{p2} Z_1 Z_{E1} Z_{E5}} \qquad (10)$$

Die charakteristischen Impedanzen $Z_0$, $Z_1$ und der Lastwiderstand $R_L$ müssen bestimmt werden. $Z_0$ erhält man durch Definition des zweiten Back-off Punktes. In diesem Zustand arbeitet nur der Hauptverstärker DM, demnach $I_{p1}$ = 0 und $I_{p2}$ = 0. Ohne die Allgemeingültigkeit zu verlieren wird die Phase von $I_m$ auf null gesetzt. Die folgende Gleichung muss erfüllt werden:

$$\left| Z_m I_{m\,2.\mathrm{Back\text{-}off}} \right| = U_{DS\,m} \qquad (11)$$

mit $I_{m2.Back\text{-}off}$ als der Strom des Hauptverstärkers DM am zweiten Back-off. Die Gleichung ist nach $Z_0$ aufzulösen und es wird erhalten:

$$Z_0 = \frac{\sqrt{U_{DS\,m}}\,Z_1\,Z_{E1}}{\sqrt{I_{m\,\mathrm{State0}}}\,R_L\,Z_{E0}} \qquad (12)$$

Als nächstes wird das erste Back-off betrachtet, wobei der Haupt- und die ersten Spitzenleistungsverstärker DM, DP1, DP2 angeschaltet sind, und $I_{p2}$ = 0. Da die Impedanz $Z_m$ immer einen positiven nicht-komplexen Wert haben soll, muss die Phase von $I_{P2}$ $-\pi/2$ sein. Die folgende Relation muss erfüllt werden:

$$\left| Z_{p1} I_{p1\,1.\mathrm{Back\text{-}off}} \right| = U_{DS\,p1} \qquad (13)$$

Aufgelöst nach $Z_1$:

$$Z_1 = \frac{\sqrt{I_{m\,2.\mathrm{Back\text{-}off}}}\,\sqrt{R_L}\,\sqrt{U_{DS\,p1}}\,Z_{E3}}{I_{m\,1.\mathrm{Back\text{-}off}}\,Z_{E2}} \qquad (14)$$

Im Allgemeinen ist der Strom $I_{P2}$ ein komplexer nicht-Null Wert. Für die Frequenz des Entwurfs ist die Phase

$\pi$. Schließlich kann $R_L$ abgeleitet werden. Die Gleichungen sollen mit der Verwendung einer individuellen Spitzenleistung der Verstärkerkerne DM, DP1, DP2 (bzw. $P_m$, $P_{p1}$ und $P_{p2}$ in den Gleichungen (15), (16) und (17)) präsentiert werden:

$$Z_0 \ = \ \frac{U_{DS\,m}\,U_{DS\,p1}}{2\,P_m}\,\frac{Z_{E1}\,Z_{E3}}{Z_{E0}\,Z_{E2}} \qquad (15)$$

$$Z_1 \ = \ \frac{U_{DS\,p1}\,U_{DS\,p2}}{2\,(P_m + P_{p1})}\,\frac{Z_{E3}\,Z_{E5}}{Z_{E2}\,Z_{E4}} \qquad (16)$$

$$R_L \ = \ \frac{U_{DS\,p2}^2}{2\,(P_m + P_{p1} + P_{p2})}\,\frac{Z_{E5}^2}{Z_{E4}^2} \qquad (17)$$

Für den Fall, dass $Z_{E0} = Z_{E1}$, $Z_{E2} = Z_{E3}$ und $Z_{E4} = Z_{E5}$, oder für den Fall der vollständigen Vernachlässigung der impedanztransformierenden Offset-Leitungen LAH reduzieren sich die Gleichungen auf den klassischen "bare-bone" Drei-Wege DPA.

Der erfindungsgemäße HF-Hochleistungsverstärker HPA unterscheidet sich vom grundlegenden Doherty-Verstärker durch Versatzleitungen LAH mit den charakteristischen Impedanzen $Z_{E0}$ bis $Z_{E5}$ was nachfolgend näher erläutert wird. Die einzelnen Versatzleitungen LAH haben jeweils die Länge $\lambda/4$, wobei $\lambda$ die geführte Wellenlänge (nicht Freiraumwellenlänge) ist.

Die Gleichungen (15), (16) und (17) ermöglichen die Berechnung dreier Impedanzen unter der Verwendung der Leistung des Hauptleistungsverstärkers DM und die der beiden Spitzenleistungsverstärker DP1 und DP2; in vorstehenden Gleichungen als aktive Lastmodulatoren Pp1 und Pp2 genannt. Die charakteristischen Impedanzen ZE0 bis ZE5 bilden Freiheitsgrade, welche zur Optimierung der relativen Bandbreite des HF-Hochleistungsverstärkers HPA genutzt werden können.

Der Begriff Freiheitsgrad wird im Folgenden näher definiert. Die für die Versatzleitungen LAH verwendeten Mikrostreifenleitungen lassen sich in ihrer charakteristischen Impedanz und transformierenden Eigenschaft variieren. Hohe charakteristische Leitungsimpedanzen werden durch schmale Mikrostreifenleitungen erzeugt, während breite Mikrostreifenleitungen geringe charakteristische Leitungsimpedanzen generieren.

Zusätzlich besitzt jede Mikrostreifenleitung, aufgrund der Länge $\lambda/4$, eine impedanztransformierende Eigenschaft.

Die Verwendung von Versatzleitungen (auch Offset line genannt) ist in der Literatur bekannt und wurde schon in folgenden Publikationen verwendet (siehe vorstehend), beispielsweise R. Giofrè, L. Piazzon, P. Colantonio, F. Giannini: "A closed-form design technique for ultra-wideband Doherty power amplifiers" IEEE Transactions on Microwave Theory and Techniques, Volume: 62, Issue:12, December 2014 oder A. Barakat, M. Thian, V. Fusco : "Towards generalized Doherty power amplifier design for wideband multimode operation" SBMO/IEEE MTTS International Microwave and Optoelectronics Conference (IMOC), 2015 oder A. Barakat, M. Thian, V Fusco, S. Bulja, L. Guan: "Toward a More Generalized Doherty Power Amplifier Design for Broadband Operation" IEEE Transactions on Microwave Theory and Techniques, Volume: 65, Issue: 3, March 2017. In den genannten Publikationen wurden Versatzleitungen an den aktiven Lastmodulatoren (nachfolgend auch Spitzenleistungsverstärker DP1, DP2 genannt) verwendet, um die relative Bandbreite der Verstärker bei einer bestimmten Frequenz zu erhöhen. Diese Versatzleitungen sind eine Mikrostreifenleitung ($\lambda/4$-Leitung) mit der Eigenschaft das Signal bei der Designfrequenz (d.h. bei einer bestimmten Frequenz) auf ein bestimmtes Phasen-Offset zu setzen.

Der entscheidende Unterschied des erfindungsgemäßen HF-Hochleistungsverstärker HPA gegenüber dem Stand der Technik liegt in der Anbringung einer zusätzlichen Versatzleitung/ Mikrostreifenleitung LAH (welche keine transparente Leitung ist, wie nachfolgend näher beschrieben wird) am Hauptleistungsverstärker DM und an den Spitzenleistungsverstärkern DP1, DP2. Diese Erweiterung bietet große Vorteile in Bezug auf die Verstärkereffizienz, bei Verwendung modulierter Wellenformen und Vorteile für die relative Bandbreite bei großen Spitzenleistungen. Durch die zusätzlichen Freiheitsgrade (gemeint sind die charakteristischen Impedanzen ZE0 und ZE1, nämlich zwei Freiheitsgrade) kann erfindungsgemäß beim Design von Versatzleitungsstrukturen ein Optimum gefunden werden, bei dem die Bandbreite erweitert bzw. erhöht wird und eine entsprechende Flexibilität gegeben ist. Hierfür lassen sich zwei Grenzfälle finden.

Beim ersten Grenzfall besitzt der HF-Hochleistungsverstärker HPA im Back-off eine sehr hohe Bandbreite.

Dies wird durch das Setzen von Z0 _ Z1 _ RL erreicht. Natürlich besitzen die Versatzleitungen LAH der aktiven Lastmodulatoren parasitäre Einflüsse, wodurch deren charakteristische Impedanzen geeignet gewählt werden müssen, um die Gesamtbandbreite des HF-Hochleistungsverstärkers HPA zu maximieren. Um den HF-Hochleistungsverstärker HPA an eine 50 Ω Terminierung anzupassen, wird insbesondere ein zusätzlicher Impedanztransformator verwendet. Je nach Leistungsbereich kann dieser Transformator mehr oder weniger aufwendig sein und dementsprechend mehr oder weniger Platz auf der Leiterplatte benötigen.

Der zweite Grenzfall benötigt keinen zusätzlichen Impedanztransformator am Ausgang. Die transformierenden Eigenschaften der Versatzleitungen LAH können verwendet werden, um den Ausgang des HF-Hochleistungsverstärker HPA direkt für RL = 50 Ω (oder jede andere beliebige Terminierungsimpedanz) anzupassen. Insbesondere werden gleiche, vorzugsweise HEMT - Transistoren für Treiberstufe und gleiche Transistoren als Haupt- und Spitzenleistungsverstärker (DM, DP1, DP2, ..) verwendet. Dadurch sollen die Temperatur-, Alterung- und ähnliche Abhängigkeiten (nicht nur von Transistoren, sondern auch von der Spannungsversorgung) in die gleiche Richtung wegdriften. Dabei bleiben Freiheitsgrade übrig, welche für die Optimierung der Gesamtbandbreite des HF-Hochleistungsverstärker HPA genutzt werden können.

Bezüglich der maximalen relativen Bandbreite liegt die optimale Wahl zwischen den beiden Grenzfällen. Je nach Anwendungsfall und Randbedingungen kann der HF-Hochleistungsverstärker HPA zwischen den beiden Grenzfällen positioniert werden. Dadurch wird nur ein einfacher und platzsparender Ausgangstransformator benötigt, anstatt eines großflächigen Ausgangstransformators.

Der Vorteil ist eine höhere relative Gesamtbandbreite des HF-Hochleistungsverstärkers HPA.

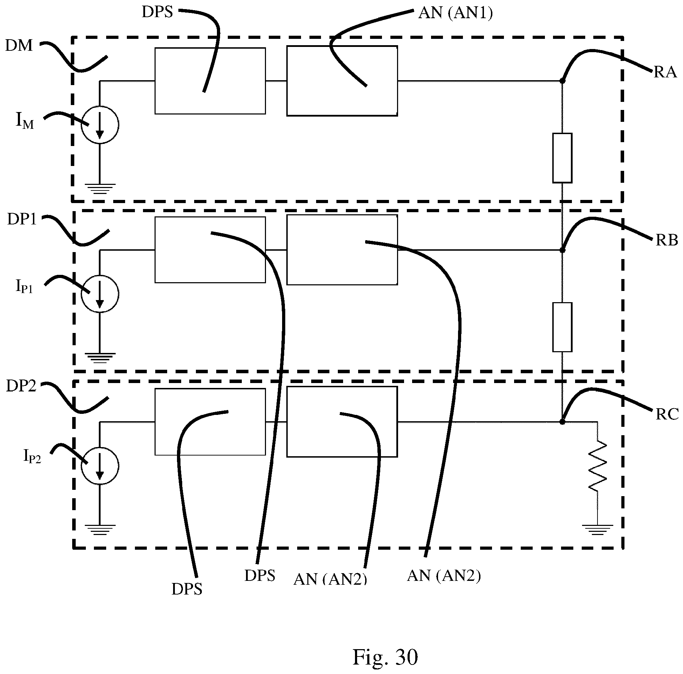

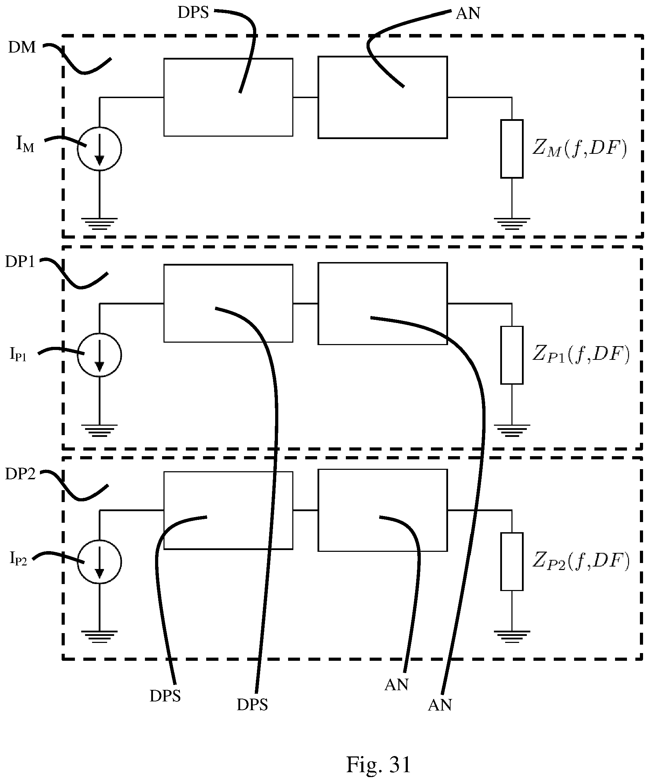

Ein weiterer Vorteil des erfindungsgemäßen HF-Hochleistungsverstärker HPA ist die Absorption der Transistorparasiten (siehe Fig. 30, Fig. 31). Transistoren besitzen an ihren Anschlüssen parasitäre Kapazitäten und Induktivitäten. Transistorparasiten reduzieren die relative Bandbreite eines Verstärkers. Diese müssen geeignet absorbiert werden, um die angestrebte Funktionalität und hohe relative Bandbreite eines Verstärkers zu garantieren.

Die Versatzleitung LAH am Hauptleistungsverstärker DM und die aktiven Spitzenleistungsverstärker DP1 und DP2 / aktiven Lastmodulatoren Pp1 und Pp2 ermöglichen die Absorption großer Parasiten und erlauben zusätzlich eine multi-harmonische Terminierung (in der Literatur wird die Versatzleitung auch als Offset-Leitung bezeichnet, in der vorliegenden Anmeldung wird diese auch "multiharmonische Transformationsleitung" genannt), was eine hohe relative Bandbreite ermöglicht. Diese Eigenschaften machen multiharmonische Transformationsleitungen (Versatzleitungen) LAH zu einem wichtigen Tool. Die multiharmonische Transformationsleitung/Offset Leitung LAH hat im Rahmen der Erfindung drei Aufgaben gleichzeitig zu erfüllen:

a) Open bereitstellen. Wenn die Peak Transistoren "aus" sind, weisen sie eine Restkapazität auf. Diese wird in einen Open am Eingang der Offset Leitung LAH transformiert (Grundwelle). Hierdurch ist die Offset Leitung LAH auch kürzer als eine λ/2 Leitung.

b) Multiharmonic Matching. Den Transistoren müssen bei den Harmonischen bestimmte komplexe frequenzabhängige Abschlussimpedanzen präsentiert werden, um die Effizienz und Bandbreite zu steigern. Hier trifft der Begriff "λ/2 Leitung" nicht den Kern der Sache, weil sich der Begriff nur auf die Grundwelle bezieht.

c) Transformation. Die Offset-Leitung LAH transformiert auch die Impedanzen bei der Grundwelle, um sie am eigentlichen Ausgangskombinierer C optimal auslegen zu können.

Bei einer rein theoretischen Betrachtung des Verstärkers ist es üblich den Hauptverstärker (DM) und die aktiven Lastmodulatoren (DP1, DP2) in einem breitbandigen Klasse-B Betrieb zu betreiben (z.B. wie in dieser Publikation dargestellt: J. H. Qureshi: "A Wide-Band 20W LMOS Doherty Power Amplifier" IMS 2010). Durch diese Vorgehensweise ist es möglich die Verstärker zu charakterisieren und untereinander zu vergleichen. Diese Analyse wird nachfolgend für einen Zwei-Wege (Stand der Technik) und einem Drei-Wege Doherty Leistungsverstärker mit multiharmonischen Transformationsleitungen/Versatzleitungen LAH (Erfindung) vorgenommen.

Fig. 10 zeigt die relative Bandbreite eines rudimentären Zwei-Wege Dohertys nach dem Stand der Technik ohne Transformatoren auf (Kurvenschar in Abhängigkeit von ε gemäß Gleichung (18)).

$$\epsilon = \frac{U_{DS}^2}{P_{tot}} \qquad (18)$$

In Gleichung (18) wird die Drainspannung der Verstärkerkerne DM, DP1, DP2 mit $U_{DS}$ bezeichnet, während $P_{tot}$ die spitze Ausgangsleistung des Verstärkers repräsentiert. Wird $U_{DS}$ auf einen Wert festgelegt, stellt die Kurvenschar die relative Bandbreite für verschiedene Spitzenleistungen dar. Je kleiner ε desto höher die Spitzenleistung.

Zum Beispiel repräsentiert die Kurve ε = 2 für $U_{DS}$ = 50V einen HF-Hochleistungsverstärker HPA mit einer Spitzenleistung von 1250 W. Aus der Graphik lässt sich erkennen, dass ein abnehmendes ε (was zunehmende Spitzenleistung bedeutet), zu abnehmender relativer Bandbreite führt.

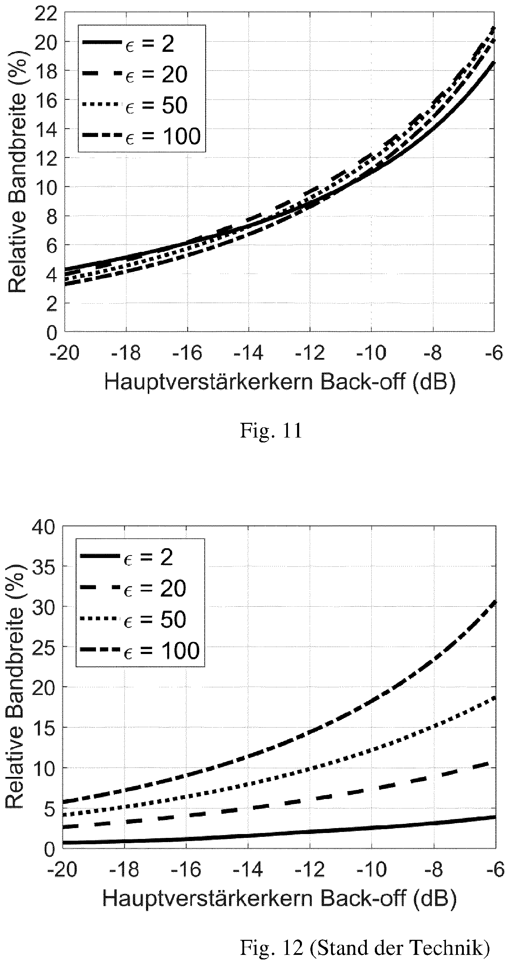

In Fig. 11 ist die Performanz eines Zwei-Wege Doherty, d.h. die relative Bandbreite eines rudimentären Zwei-Wege Dohertys mit Versatzleitungen am Hauptleistungsverstärker DM und den aktiven Spitzenleistungsverstärker DP1 und DP2 / aktiven Lastmodulatoren Pp1 und Pp2 dargestellt. Der HF-Hochleistungsverstärker HPA wurde jeweils unter Verwendung der vorhandenen Freiheitsgrade optimiert, um die relative Bandbreite zu maximieren. Es ist klar zu erkennen, dass die Kurvenschar dicht zusammen liegt und im Allgemeinen eine erhöhte relative Bandbreite aufweist.

In Fig. 12 ist die relative Bandbreite für den rudimentären Drei-Wege Doherty nach dem Stand der Technik abgebildet.

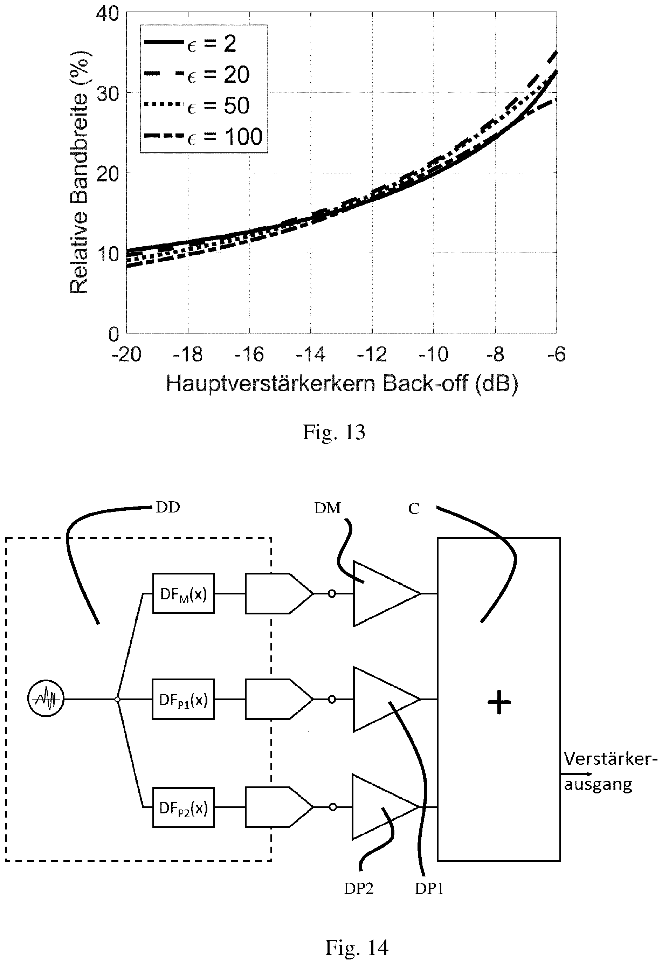

In Fig. 13 ist die Performanz für einen erfindungsgemäßen Drei-Wege Doherty, d.h. die relative Bandbreite eines rudimentären Drei-Wege Dohertys mit multiharmonischen Transformationsleitungen/Versatzleitungen LAH am Hauptleistungsverstärker DM und den aktiven Spitzenleistungsverstärker DP1 und DP2 / aktiven Lastmodulatoren Pp1 und Pp2 dargestellt. Der HF-Hochleistungsverstärker HPA wurde jeweils unter Verwendung der vorhandenen Freiheitsgrade optimiert, um die relative Bandbreite zu maximieren. Es ist klar zu erkennen, dass die Kurvenschar dicht zusammen liegt und im Allgemeinen eine erhöhte relative Bandbreite aufweist.

Für große Spitzenleistungen oder allgemeiner gesagt für geringe ε Werte wird die relative Bandbreite für Zwei-Wege und erfindungsgemäße Drei-Wege Dohertys erhöht, was allgemein für N-Wege Doherty gilt.

Hohe Spitzenleistung verursacht durch plötzliche thermische Erwärmung eine physikalische Belastung. Bei Versuchsaufbauten wurden Mikrostreifenleitungen mit 70 μm Kupfermantel und einer Dielektrizitätskonstante von $\varepsilon_r$ = 6,3 für die hohe thermische Beständigkeit verwendet. Weiterhin wurden GaN HEMT Transistoren für alle drei Verstärkerkerne DM, DP1 und DP2 des HF-Hochleistungsverstärker HPA mit beispielsweise 500W verwendet, wofür auch hochpräzise Modelle für ADS (Advanced Design System, eine spezielle Simulationssoftware) zur Verfügung stehen. Diese Modelle wurden während des gesamten Entwurfsprozesses hindurch verwendet. Die Gate Vorspannung des Hauptleistungsverstärkers DM wurde auf $U_{gM}$ = -2,7V eingestellt, die der Spitzenleistungsverstärker DP1 und DP2 hingegen auf $U_{gP}$ = -4,5V Die Drain-Spannung für alle Verstärker DM, DP1 und DP2 ist $U_{DS}$ = 50V.

Entgegen einem Doherty Power Amplifier DPA nach dem Stand der Technik mit Einfach-Eingang und Einfach-Ausgang, welcher aus einem statischen Leistungsteiler besteht und das Eingangssignal entsprechend auf den Haupt- und die Spitzenleistungsverstärkerkerne DM, DP1 und DP2 aufteilt, wurde erfindungsgemäß im HF-Hochleistungsverstärker HPA ein digitaler Eingangssignalteiler ET mit mehreren Ausgängen verwendet. Diese Art von Teiler erhält man durch Verschieben des statischen Leistungsteilers aus dem analogen Bereich in den digitalen Bereich. Der digitale Eingangssignalteiler ET ermöglicht für jede Frequenz und jedes Eingangstreiberlevel ein Optimum des Leistungsteilungsverhältnisses und der Ansteuerung der einzelnen Verstärkerkerne. Somit kann jeder Verstärkerkern in seiner Leistung und Phasenlage einzeln angesteuert werden; dies führt zu einer höheren Bandbreite und besseren Effizienz. Im Folgenden wird der digitale Eingangssignalteiler ET als Steuerfunktion bezeichnet.

Die Steuerfunktion ET ist als Look-Up Tabelle im FPGA (siehe Fig. 1) implementiert. Weitere Komponenten des FPGA (Field Programable Gate Array), nämlich DSP (Digital Signal Prozessor Block) und DPD (Digital Pre Distoration, digitale Vorverzerrung des Sendesignals) werden weiter unten im Detail beschrieben. Der Steuerfunktion ET ist ein Multiplexer (mehrere Eingänge und ein Ausgang, in der Zeichnung nicht dargestellt) vorgeschaltet; dieser bekommt am Mehrfach-Eingang unterschiedlich modulierte Signale wie z.B. AM (Amplituden-Moduliert), GPSK (Gaussian Phase Shift Keying), OFDM, d.h. dass die Steuerfunktion/ digitaler Eingangssignalteiler ET am Eingang eine Vielzahl an Modulationsverfahren in die Ansteuerung von Doherty Power Amplifier umsetzen kann. Es können auch Steueralgorithmen für andere Modulationsverfahren per Software erweitert werden. Des weiterem ermöglicht die Steuerfunktion ET einen effizienten und breitbandigen Betrieb des HF-Hochleistungsverstärkers HPA bei unterschiedlichen Designfrequenzen. Die Steuerfunktion ET ist eine Funktion mit Bezug auf Frequenz und Eingangsleistung und der Aufbau eines digitalen Dreifach-Eingangssignalteilers ET mit Treiberfunktion /Steuerfunktion ist in Fig. 14 dargestellt.

Bestimmte Arten von Quellen erzeugen im Digitalbereich DD (digitale Domäne) ein willkürliches Signal, das in die Steuerfunktion/ Eingangssignalteiler ET, welche zu den jeweiligen Verstärkerkernen DM, DP1 und DP2 gehört, eingespeist wird. Die Steuerfunktion ET erzeugt eine entsprechende Ausgabe und übergibt diese in Richtung der Digital-Analog-Umsetzer DAC (digital-to-analog converter als integrierter Schaltkreis ausgeführt), welche die Verstärkerkerne DM, DP1 und DP2 antreiben. Wohingegen die Steuerfunktion ET eine nicht-lineare Funktion darstellt, ist die übergeordnete Übertragungsfunktion, bestehend aus der Steuerfunktion ET, den Verstärkerkernen DM, DP1 und DP2 und einem Ausgangskombinierer C, hinsichtlich kontinuierlicher Wellen eine lineare Funktion. Für modulierte Wellen kann im Rahmen der Erfindung ein DPD-Modul (digital predistortertion) vorgesehen werden (siehe Fig. 1), um Memory-Effekte zu bekämpfen. Die Nicht-Linearität der Steuerfunktion ET kann für die Digital-Analog-Umsetzer DAC eine Herausforderung darstellen, da sie die Anforderungen der vergrößerten Bandbreite abdecken müssen.

Um die Steuerfunktion ET zu identifizieren wurden harmonische Ausgleichssimulationen durchgeführt. Jeder Eingang des HF-Hochleistungsverstärker HPA besitzt zwei Freiheitsgrade bestehend aus Amplitude und Phase. Insgesamt erstreckt sich dadurch ein sechs-dimensionaler Raum, in welchem die Optimierung stattfindet. Eine geeignete Lösung zur Simulation der Hardware besteht in der Durchführung eines gestuften Identifikationsprozesses, wobei die Ausgangsleistung mittels kleinen Änderungen am Eingangs von Null auf ein Maximum erhöht wird, und dabei insbesondere die Ausgangsleistung, Phase, Effizienz, die Verstärkung beobachten werden. Aufgrund der kleinen Änderungen stellt dies einen virtuellen risikofreien Prozess dar, wodurch die Zerstörung der Verstärkerkerne vermieden wird.

Es existiert nicht nur eine, sondern eine unendliche Fülle an möglichen Steuerfunktionen/digitalen Eingangssignalteilern ET. Deren Verhalten hängt von dem Satz an Messungen ab, welche während des Identifikationsprozesses berücksichtigt wurden, und auch der Gewichtung, in welcher sie gegeben sind. Beispielsweise ist es möglich eine Steuerfunktion ET zu erzeugen, welche auf ein Maximum an Effizienz fokussiert ist. Diese Steuerfunktion ET unterscheidet sich von einer, welche mit dem Ziel einer Erweiterung der kleinen Bandbreite, welche an den Digital-Analog-Umsetzer DAC erzeugt wurde, oder von einer, welche auf niedrige Kompressionslevel an den Verstärkerkernen fokussiert ist. Daher erzeugt das Setzen der Ziele und deren Gewichtung für den Identifikationsprozess diverse Steuerfunktionen, welche zu einem unterschiedlichen Betriebsverhalten führen.

Die folgende Steuerfunktion/digitaler Eingangssignalteiler ET wurde in ADS (Advanced Design System, eine spezielle Simulationssoftware) für mehrere Zielausgangsleistungen im Bereich von Null bis 61dBm identifiziert. Für jede Zielausgangsleistung wurde ein Eingangssteuerprofil mit Maximaleffizienz identifiziert. Folgende Punkte stellen zwei wichtige Nebenziele dar:

- Kompressionslevel: Der Kompressionslevel von jedem Verstärkerkern DM, DP1 und DP2 wurde mittels Beobachtung des Gate-Stroms indirekt überwacht. Entsprechend dem Datenblatt des benutzten GaN HEMT Transistors (high-electron-mobility transistor, Transistor mit hoher Elektronenbeweglichkeit, welcher eine spezielle Bauform eines Feldeffekttransistors für sehr hohe Frequenzen ist) beträgt der maximale Gate-Strom 80mA. Der maximal erlaubte Strom für den Identifikationsprozess wurde auf 40mA festgelegt.
- Inhärente Drain-Spannung: Entsprechend dem Datenblatt beträgt die inhärente Drain-Spannung 125 V. Um eine lange Ausfallssicherheit zu gewährleisten, wurde die maximale Spannung während des Identifikationsprozesses in der ADS-Entwurfsumgebung auf 120V festgelegt.

Eine laufende Kompressionskontrolle von Hauptleistungsverstärker DM und aktiven Spitzenleistungsverstärkern/Lastmodulatoren DP1, DP2 gestaltet sich bei N-Wege Doherty Leistungsverstärker schwierig. Jedoch ist die Kompressionskontrolle wichtig, da Lebensdauerverlust und potentielle Zerstörung des Transistors drohen. Durch die Lastmodulation ist es nicht möglich, wie bei einem Einkernverstärker nach dem Stand der Technik, die Eingangsleistung zu variieren, um daraus das Kompressionsniveau der Verstärkerkerne zu ermitteln. Auch eine vollständige Identifizierung des Gesamtverstärkers ist durch den Multi-Dimensionalen Raum der Steuerfunktion/digitaler Eingangssignalteiler ET nicht oder nur im begrenzten Umfang möglich. Hinzu kommen Alterungsprozesse, welche eine regelmäßige Neuidentifikation nötig machen würden. Bei einem Verstärker mit zwei Verstärkerkernen mag es noch möglich sein, über sorgfältige Wahl der Ansteuerung starke Kompression zu vermeiden. Dies wird jedoch mit zunehmender Anzahl von Verstärkerkernen laufend schwieriger bis unmöglich, da nicht mehr zu garantieren ist, dass kein Verstärkerkern sich in zu starker Kompression befindet.

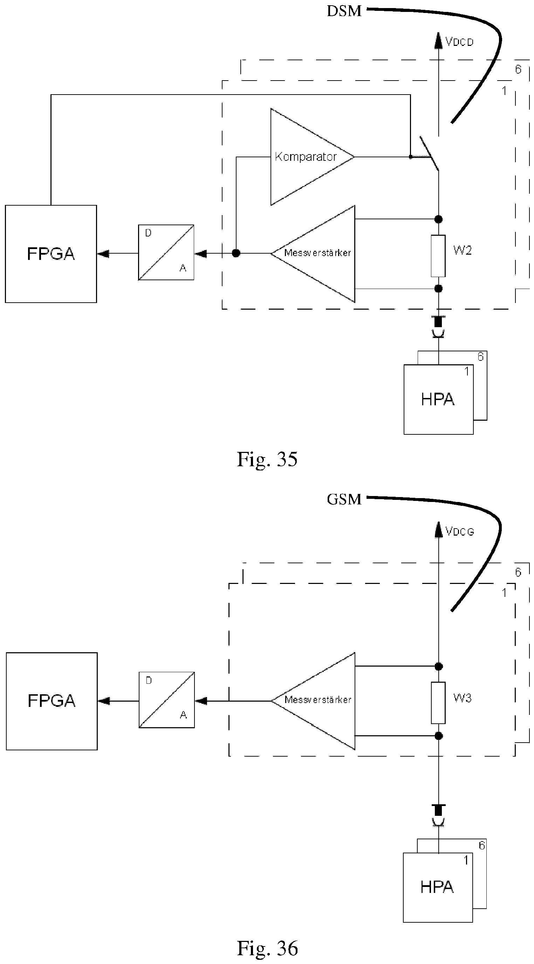

Wie bereits erläutert, werden beim erfindungsgemäßen HF-Hochleistungsverstärker HPA die Gate-Ströme als Maß für das Kompressionsniveau des Hauptleistungsverstärkers DM und der aktiven Lastmodulatoren DP1, DP2 genutzt. Alle Gate-Ströme werden einzeln mit Hilfe eines elektrischen Bauteils gemessen. Dieses Bauteil kann durch Shuntwiderstände oder anderen Methoden realisiert werden. In Fig. 35 ist das Blockschaltbild einer Ausführungsform zur Drain-Strom-Messung DSM und in Fig. 35 ist eine Ausführungsform zur Gate-Strom-Messung GSM dargestellt. Die DC-Stromversorgung für das Modul DSM ist mit $V_{DCD}$ bezeichnet. Jedes Modul Drain-Strom-Messung DSM weist einen Komparator, einen Messverstärker, einen Schalter und einen Widerstand 2 W2 auf. Jedes Modul Gate-Strom-Messung GSM weist einen Messverstärker und einen Widerstand 3 W3 auf und die DC-Stromversorgung für das Modul GSM ist mit $V_{DCG}$ bezeichnet.

Im Rahmen der Erfindung wurde die Architektur derart gewählt, dass die Videobandbreite des Bauteils ungefähr der Instantanbandbreite des Sendesignals entspricht, damit eine in-situ Messung möglich ist. Liegt die Videobandbreite darunter wird das Maß für das Kompressionsniveau gemittelt.

Die Erfindung wird am Beispiel von GaN-HEMTs beschrieben, ist jedoch auf alle Leistungstransistoren übertragbar, welche hohe Gate- Ströme aufweisen. GaN-HEMT Gate Terminals basieren auf einer Schottky Diode, die höhere Gate-Ströme aufweisen, als LDMOS oder GaAs basierte Leistungstransistoren. Je nach Spitzenleistung des GaN-HEMT können Gate-Ströme von 5mA bis 80mA entstehen, wenn der Leistungstransistor sich in Kompression befindet.

Um die Elektromigration der Schottkydiode zu verhindern, darf die Stromdichte an der Gateperipherie nicht zu groß werden und daher nicht die Maximalströme überschreiten. Die höheren Ströme von GaN-HEMTs, verglichen mit anderen Technologien, können dafür verwendet werden Rückschlüsse auf das derzeitige Kompressionsniveau des Verstärkerkerns zu ziehen.

Fig. 35 stellt den Gate-Strom für einen 500W GaN-HEMT Transistor zusammen mit dem Gain dar. Mit zunehmender Eingangsleistung steigt das Kompressionsniveau des GaN-HEMT stetig an. Bei einem Eingangspegel von ca.44 dBm liegt das Kompressionsniveau bei 3 dB. Der Gate-Strom ist an diesem Punkt bei ca. 13 mA und steigt mit wachsendem Kompressionsniveau stetig (signifikant) an. Aufgrund der Schottkydiode hat der Strom den Verlauf einer Diodenkennline. Der maximale Gate-Strom (Maximum Forward Gate Current) ist bei dem gewählten Beispiel mit 84mA angegeben.

Mit dieser Methode ist es möglich für jeden Verstärkerkern eine individuelle Kompressionskontrolle zu erreichen, welche nicht durch Alterungsprozesse gestört wird. Zusätzlich ist es dadurch möglich, defekte Verstärkerkerne zu erkennen. Beispielsweise können über die Betriebsdauer des Verstärkers steigende Gate-Ströme Zeichen für einen Defekt sein und somit einen baldigen Ausfall des Verstärkerkerns rechtzeitig anzeigen. Durch rechtzeitig eingeleitete Reparaturen könnten größere Schäden am Gerät oder Betrieb vermieden werden und die Verfügbarkeit der Systeme wird erhöht.

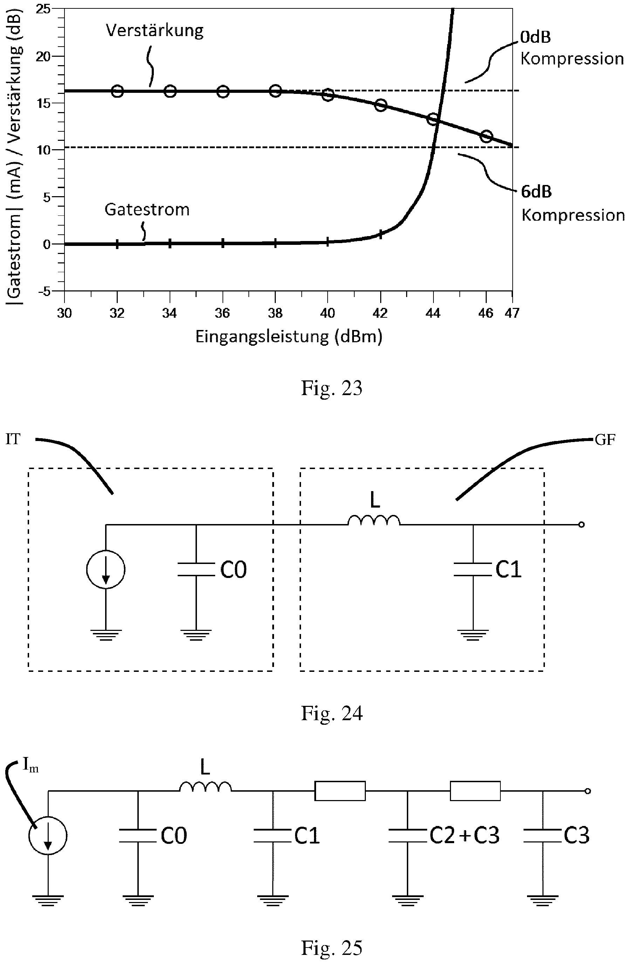

Die Kompensation von Drain-Parasiten DPS wird in der Regel als ein sekundäres Problem angesehen, was für Leistungsverstärker mit hohen Spitzenleistungen nicht ausreichend ist. Versatzleitungen mit oder ohne transformierende Eigenschaft für Doherty Leistungsverstärker werden in der Literatur ausreichend beschrieben und analysiert, siehe vorstehend beispielsweise R. Giofrè et al: "A closed-form design technique for ultra-wideband Doherty power amplifiers" oder A. Barakat et. al.: "Towards generalized Doherty power amplifier design for wideband multimode operation" oder Y Yang et al., "Optimum design for linearity and efficiency of microwave Doherty amplifier using a new load matching technique" oder R. Quaglia et al.: "Offset Lines in Doherty Power Amplifiers: Analytical Demonstration and Design". Beim erfindungsgemäßen ET - Hochleistungsverstärker HPA wird von einem Transistormodel ausgegangen, welches in Fig. 24 dargestellt ist und sich beispielsweise an Veröffentlichungen "A new method for determining the FET small-signal equivalent circuit" IEEE Transactions on Microwave Theory and Techniques, Volume: 36, Issue: 7, Jul 1988 und R.A. Minasian: "Simplified GaAs m.e.s.f.e.t. model to 10 GHz" Electronics Letters, Volume: 13, Issue: 18, September 1977 anlehnt.

Der intrinsische Transistor IT besteht aus einer idealen Stromquelle Im und einer parallelen Drain-Kapazität $C_0$. Das Transistorgehäuse ITG besitzt weitere parasitäre Elemente, welche mit ausreichender Genauigkeit durch eine serielle Induktivität L und einer parallelen Kapazität $C_1$ abgebildet werden können. Die Werte dieser Bauteile werden durch De-embedding Techniken bestimmt. Das Transistormodel, welches in Fig. 24 dargestellt ist bildet die Grundlage für ein versatzleitungsbasiertes Absorptionsnetzwerk ABN, welches in Fig. 25 dargestellt ist.

Fig. 25 zeigt das Transistormodel sowie zusätzliche Mikrostreifenleitungen und Kapazitäten. Die Drain-Parasiten besitzen eine endliche Gruppenlaufzeit größer Null und sorgen somit für eine Verzögerung der durchlaufenden Welle. Diese Verzögerung kann im CW-Betrieb als Phasenverschiebung aufgefasst werden und wirkt sich nachteilig auf die Lastmodulation aus. Eine Kompensation wird durch die zusätzlichen Elemente im Absorptionsnetzwerk ABN erreicht.

Diese haben die Aufgabe die Phasenverschiebung auf eine halbe Wellenlänge anzuheben, wodurch das Absorptionsnetzwerk ABN für die Entwurfsfrequenz transparent wird. Lediglich die transformierende Eigenschaft bleibt bestehen. Unter diesen Bedingungen wurde das Netzwerk gelöst und die Werte der Elemente sind über die folgenden Formeln zu bestimmen:

$$Z_0 = \frac{\cos(\varphi_0)\left(C_0\, L\, w^2 - 1\right)}{w\, \sin(\varphi_0)\left(C_0\, C_1\, L\, w^2 - C_0 - C_1\right)} \qquad (19)$$

$$Z_1 = \frac{\cos(\varphi_0)}{c\, w\, \sin(\varphi_1)\left(C_0 + C_1 - C_0\, C_1\, L\, w^2\right)} \qquad (20)$$

$$C_2 = \frac{C_1\, L\, Z_0\, \cos(\varphi_0)\big|\, w^2 + L\, \sin(\varphi_0)\, w - Z_0\, \cos(\varphi_0)}{C_1\, L\, \sin(\varphi_0)\, Z_0{}^2\, w^3 - \sin(\varphi_0)\, Z_0{}^2\, w - L\, \cos(\varphi_0)\, Z_0\, w^2} \qquad (21)$$

$$C_3 = \frac{c \cos(\varphi_1) \left(C_0 + C_1 - C_0 C_1 L w^2\right)}{\cos(\varphi_0)} \qquad (22)$$

Die Variable $\varphi_n$ bezeichnet die elektrische Länge der Mikrostreifenleitung n. Die Induktivität wird mit L bezeichnet und die Kapazitäten mit C. Die Kreisfrequenz durch $\omega$ ausgedrückt.

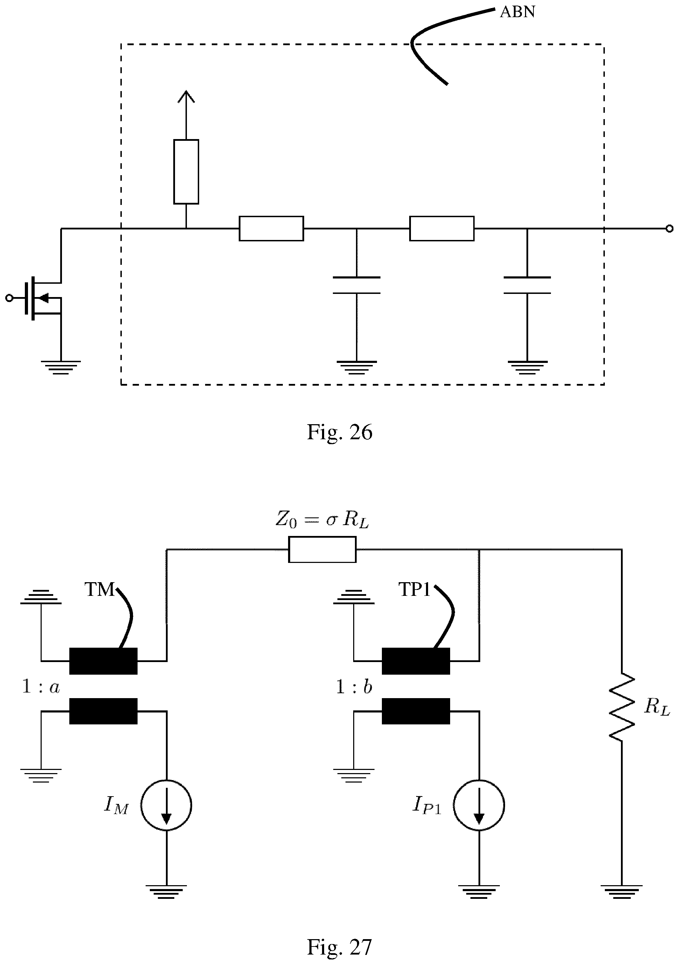

Die Freiheitsgrade im Absorptionsnetzwerk ABN bilden $\varphi_0$ und $\varphi_1$. Diese sind im Bereich ]0; $\pi/2$] zu wählen. Hierdurch sind noch ausreichend Freiheitsgrade vorhanden, um die Bandbreite des erfindungsgemäßen ET - Hochleistungsverstärker HPA zu maximieren. Ein realistisches Absorptionsnetzwerk ABN benötigt noch einen Anschluss für die Spannungsversorgung. Dies kann mit Hilfe einer $\lambda/4$-Mikrostreifenleitung realisiert werden und das versatzleitungsbasierte Absorptionsnetzwerk ABN mit einem Transistor und der Spannungsversorgung ist in Fig. 26 dargestellt.

Gemäß der Erfindung wird ein extrem breitbandiger on-chip basierter Doherty HF-Hochleistungsverstärker HPA realisiert. Ein Transformator-basierter Zwei-Wege Doherty Leistungsverstärker ist in Fig. 27 dargestellt. Die in Fig. 27 dargestellte Mikrostreifenleitung mit der charakteristischen Impedanz $Z_0$ hat die Länge L = $\lambda_d/4$ und die Leistungstransistoren DM und DP1 sind durch Stromquellen $I_{M, IP1}$ substituiert.

Der Hauptleistungsverstärker DM besitzt einen idealen Transformator TM mit einem Transformationsverhältnis von 1 : a und der aktive Lastmodulator DP1 einen idealen Transformator TP1 mit dem Verhältnis 1 : b. Die Transformatoren TM, TP1 sind durch einen Impedanzinverter (hier repräsentiert durch eine $\lambda/4$ Mikrostreifenleitung) verbunden. Durch die Verwendung der idealen Transformatoren TM, TP1 erhält die Erfindung genügend Freiheitsgrade, um eine Abschlussimpedanz RL beliebig festzulegen und gleichzeitig eine hohe Bandbreite zu garantieren. Dieses Prinzip lässt sich ohne Probleme auf N-Wege Doherty Leistungsverstärker erweitern, wobei N für die Anzahl der verwendeten Leistungstransistoren steht. Das Netzwerk für den Zwei-Wege Doherty lässt sich mathematisch beschreiben und durch die Impedanzmatrix Z darstellen.

$$\mathbf{Z} = U_{DS}^2 \begin{pmatrix} \dfrac{g_0^{\,2}}{\sigma^2\, g_1} & \dfrac{g_0}{\sigma}\, \mathrm{e}^{-\frac{\pi f i}{2 f_d}} \\[2em] \dfrac{g_0}{\sigma}\, \mathrm{e}^{-\frac{\pi f i}{2 f_d}} & \dfrac{g_1}{2} + \dfrac{g_1}{2}\, \mathrm{e}^{-\frac{\pi f i}{f_d}} \end{pmatrix} \qquad (23)$$

Mit $g_0$= 1/(2 $P_m$) and $g_1$= 1/(2 $P_m$ + 2 $P_p$).

Die Versorgungsspannung trägt die Bezeichnung $U_{DS}$, während f die Frequenz bezeichnet und $f_d$ für die Designfrequenz steht. Die maximalen Leistungen der Leistungsverstärkerkerne wird mit $P_m$ (Hauptleistungsverstärker) und $P_p$ (aktiver Lastmodulator) bezeichnet.

Die Matrix gemäß Gleichung (23) erfasst den frequenzabhängigen Verlauf in Abhängigkeit von $\sigma$. Der Parameter $\sigma$ ist ein wichtiger Freiheitsgrad, über welchen sich die Performanz der Leistungstransistoren DM und DP1 einstellen lässt. Für eine optimale Performanz muss $\sigma$ geeignet gewählt werden. Die Impedanzmatrix Z enthält keine der beiden Transformationsverhältnisse a und b. Jedoch ist der Freiheitsgrad a indirekt über $\sigma$ enthalten, da $\sigma$ und a über folgende Formel in Beziehung stehen:

$$a = \sigma \frac{\sqrt{R_L\, g_1}}{U_{\mathrm{DS}}\, g_0} \qquad (24)$$

Der Freiheitsgrad b wird durch die Wahl von $R_L$ festgelegt:

$$b = \frac{1}{U_{\mathrm{DS}}} \sqrt{\frac{R_L}{g_1}} \qquad (25)$$

Die Last hat die Bezeichnung $R_L$. Die Architektur besitzt einen Freiheitsgrad welcher mit $\sigma$ bezeichnet ist.

Da weder b noch $R_L$ in der Impedanzmatrix Z enthalten sind, beeinflusst die Wahl von $R_L$ oder b nicht den Frequenzverlauf des Doherty Leistungsverstärkers oder allgemeiner ausgedrückt beeinflusst die Wahl nicht die Performanz des erfindungsgemäßen HF - Hochleistungsverstärkers HPA.

Bei einer rein theoretischen Betrachtung des Verstärkers ist es üblich den Hauptleistungsverstärker und die aktiven Lastmodulatoren in einem breitbandigen Klasse-B Betrieb zu betreiben (z.B. wie in dieser Publikation J. H. Qureshi: "A Wide-Band 20W LMOS Doherty Power Amplifier" IMS 2010 beschrieben ist). Durch diese Vorgehensweise ist es möglich die Verstärker zu charakterisieren und untereinander zu vergleichen.

Dies wird im Folgenden verwendet, um ein Abschätzung der Performanz der erfindungsgemäßen Ausgestaltung zu erhalten. Dabei wird ein rudimentärer Zwei-Wege Doherty ohne Transformatoren mit der Erfindung verglichen, dessen Kurvenschar in Abhängigkeit von $\varepsilon$ in Fig. 10 abgebildet ist (siehe auch Gleichung (18)). Aus Fig. 10 ist zu erkennen, dass je kleiner $\varepsilon$ ist desto höher ist die Spitzenleistung. Zum Beispiel, verwendet man für einen Chip $U_{DS}$ = 3,3V bedeutet dies, dass die Kurve $\varepsilon$ = 2 einer Spitzenleistung von $P_{tot}$ = 5,4W (37,36 dBm) entspricht, während $\varepsilon$ = 100 einer Spitzenleistung von $P_{tot}$ = 0.11W (20.37 dBm) entspricht. Weiterhin lässt sich aus Fig. 10 erkennen, dass ein abnehmendes $\varepsilon$ (was zunehmende Spitzenleistung bedeutet), zu abnehmender relativer Bandbreite führt.

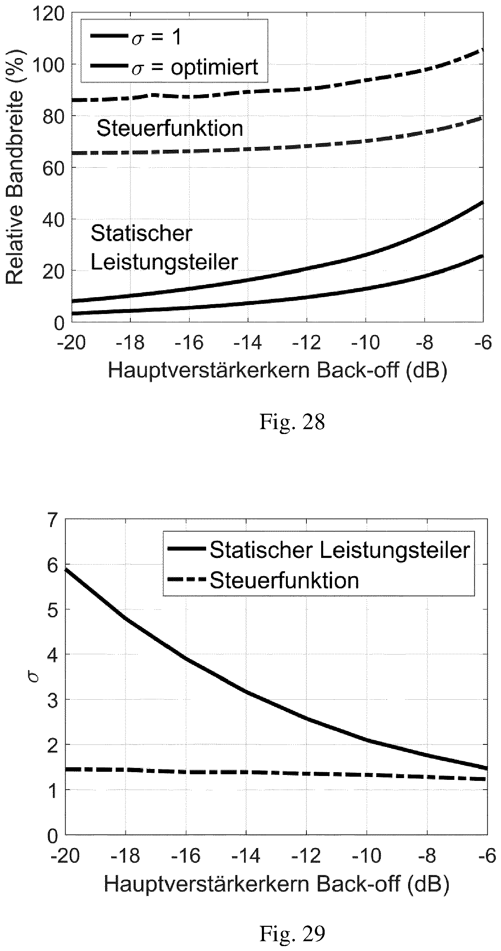

In Fig. 28 wird die relative Bandbreite für einen statischen Splitter und Steuerfunktion (Drive Function, eingeführt in W.C. Edmund Neo et al.: "AMixed-Signal Approach Towards Linear and Efficient N-Way Doherty Amplifiers" IEEE Transactions on Microwave Theory and Techniques, Volume: 55, Issue: 5, May 2007), insbesondere für einen Zwei-Wege Doherty Leistungsverstärkers mit Transformatoren dargestellt Es ist sofort erkennbar, dass die Erfindung nicht von $\varepsilon$ abhängig ist. Dies bedeutet, dass die üblichen Performanzeinbußen bei hohen Spitzenleistungen (Allgemeiner: geringes $\varepsilon$) beim erfindungsgemäßen on-chip basierter Doherty HF-Leistungsverstärker HPA (HF-Hochleistungsverstärker HPA) beseitigt werden.

Lediglich die Wahl von $\sigma$ übt einen starken Einfluss auf die Bandbreite aus, genauso wie die Verwendung einer Steuerfunktion ET, welche die Bandbreite deutlich über eine Oktave anhebt. Bei Verwendung eines statischen Leistungsteilers ist die Bandbreite der Erfindung höher, als die des rudimentären Doherty, bei geeigneter Wahl von $\sigma$.

Die optimierten Werte eines Zwei-Wege HF - Hochleistungsverstärker (HF-Hochleistungsverstärker HPA) mit Transformatoren für $\sigma$ sind in Fig. 29 dargestellt. Dabei ist festzustellen, dass die Mikrostreifenleitung mit der charakteristischen Impedanz $Z_0$ in der Literatur üblicherweise durch einen Transformator realisiert wird. Folglich wird bei einer Implementation der Transformator TM am Hauptleistungsverstärker DM mit der Mikrostreifenleitung zu einem Bauteil verschmolzen. Dies bedeutet, dass der Transformator TM am Hauptleistungsverstärker DM nicht nur die Impedanztransformation, beschrieben durch 1 : a durchführt, sondern auch den Impedanzinverter repräsentiert, so dass ein kompakter und breitbandiger HF-Hochleistungsverstärker HPA realisiert ist.

Da die Steuerfunktion ET jedoch eine Verallgemeinerung des statischen Leistungsteilers darstellt, wird zwecks der Generalität die Steuerfunktion verwendet. Die Entwurfskomplexität eines Doherty Leistungsverstärkerdesigns wächst mit der Anzahl aktiver Lastmodulatoren (DP1, DP2). Damit die Komplexität in einem akzeptablen Rahmen bleibt, wird eine geeignete Entwurfsstrategie benötigt.

Die Grundidee der meisten Entwurfsmethoden ist das Leistungskombinierungsnetzwerk geeignet zu zerlegen, um die Teilstücke einzeln zu entwerfen und schlussendlich diese zu einem Gesamtnetzwerk zu vereinen.

In der Literatur sind hauptsächlich zwei verschiedene Methoden bekannt.

Die erste Methode wird im englischen Sprachgebrauch "Real Frequency Technique" genannt. Bei dieser Methode werden nicht-lineare Optimierungswerkzeuge verwendet, um Anpassungsnetzwerke in einem vorgegebenen Frequenzband zu entwerfen.

Das aktive Element (meist der Leistungstransistor DM, DP1, DP2) wird durch reale Messdaten ersetzt. Dabei werden aus den Messdaten subjektiv ausgewählte Impedanzen zusammen mit einem iterativen mathematischen Prozess genutzt, um breitbandige Netzwerke zu erzeugen. Die grundlegende Methode wurde in H.J. Carlin and J.J. Komiak: "A New Method of Broad-Band Equalization Applied to Microwave Amplifiers" IEEE Transactions on Microwave Theory and Techniques, Volume: 27, Issue: 2, Feb 1979 eingeführt, später vereinfacht, siehe B.S. Yarman and H.J. Carlin: "A Simplified "Real Frequency" Technique Appliable To Broadband Multistage Microwave Amplifiers" IEEE MTT-S International Microwave Symposium Digest 1982 und schließlich für den Zwei-Wege Doherty Leistungsverstärker adaptiert, siehe G. Sun: "Broadband Doherty Power Amplifier via Real Frequency Technique" IEEE Transactions on Microwave Theory and Techniques, Volume: 60, Issue: 1, Jan. 2012. Durch diese Methode lassen sich der Hauptleistungsverstärker DM und die aktiven Lastmodulatoren DP1, DP2 unabhängig voneinander entwerfen.

Die zweite Methode verwendet mehrere geschickt gewählte Referenzebenen, welche das Zerlegen des Leistungskombinierungsnetzwerks erlaubt. Für jede Referenzebene werden wahlweise Impedanzen festgelegt für welche Anpassnetzwerke der Teilstücke entworfen werden. Dies wurde beispielsweise in W.C. Edmund Neo et al.: "A Mixed-Signal Approach Towards Linear and Efficient N-Way Doherty Amplifiers" IEEE Transactions on Microwave Theory and Techniques, Volume: 55, Issue: 5, May 2007 verwendet. Dabei wurden die Impedanzen der Referenzebenen auf 50 Ohm festgelegt.

Eine auf der Referenzebenen-Methode verbesserte Entwurfsmethodik wird nachfolgend beschrieben und erläutert. In den vorstehend genannten Publikationen werden die Referenzebenen lediglich für die Entwurfsfrequenz verwendet. Für einen breitbandigen Entwurf müssen die Impedanzen der Referenzebenen frequenzabhängig sein. Eine beliebige oder subjektive Wahl von Impedanzen über das Frequenzband ist entweder nicht möglich oder führt zu suboptimalen Ergebnissen.

Daher müssen diese Impedanzen vorher geeignet ermittelt werden, um möglichst nahe am späteren physikalischen Verlauf zu sein. Im Kontext digitaler Doherty Leistungsverstärker müssen die Impedanzen nicht nur frequenzabhängig, sondern zusätzlich eine Funktion der Steuerfunktion ET (im engl. Drive Function DF) sein.

Bei der Verwendung eines statischen Leistungsteilers hat die Steuerfunktion ET die Eigenschaften des statischen Leistungsteilers.

Steuerfunktionen können an sich entsprechend gewählt werden, d.h. diese können so gewählt werden, dass sie sich wie ein statischer Leistungsteiler verhalten oder so, dass sie perfekt für ein beliebig gewähltes Kriterium angepasst sind. Die Art der gewählten Steuerfunktion ET ist für sich gesehen für die Funktionalität der Entwurfsmethodik nicht bestimmend. Durch ihre Flexibilität stellen sie jedoch einen Allgemeinfall des üblichen statischen Leistungsteilers dar, weshalb sie bei der verbesserten Entwurfsmethodik verwendet werden.

Die Entwurfsmethodik sieht vor, dass bei einem N-Wege Doherty N Referenzebenen verwendet werden. Die Referenzebenen befinden sich an jedem Ausgang der Anpassnetzwerke AN von Hauptleistungsverstärker DM und aktiven Lastmodulatoren DP1, DP2.

Bei einen Drei-Wege Doherty Leistungsverstärker befinden sich (nach dem Stand der Technik) die drei Referenzebenen RA, RB und RC an den Positionen wie in Fig. 30 dargestellt.

Die Leistungstransistoren sind als Stromquellen ($I_M$, $I_{P1}$, $I_{P2}$) abstrahiert. Um eine realistische Repräsentation zu gewährleisten, werden die Drain-Parasiten DPS in das Modell mitaufgenommen. Bei den aktiven Lastmodulatoren DP1, DP2 muss die Eingangsimpedanz der Referenzebene möglichst hochohmig sein. Im Gegensatz zur Real Frequency Technique müssen hier keine Impedanzen subjektiv gewählt werden. Lediglich die Transistor-Drain-Parasiten DPS müssen bekannt sein, was aufgrund heutiger Transistormodellierungen kein Hindernis darstellt.

Die Impedanzen ZM (f, ET), ZP1 (f, ET) und ZP2 (f, ET) sind frequenz- und steuerfunktionsabhängige Funktionen. Die Impedanzen werden gefunden, indem das in Fig. 30 abgebildete Netzwerk mit einer beliebigen Steuerfunktion ET angesteuert wird und die Spannungen und Ströme an den jeweiligen Referenzebenen A, B, C (RA, RB, RC) ermittelt werden. Aus den Spannungen und Strömen werden die Impedanzen berechnet. Dies wird für alle Frequenzen wiederholt. Prinzipiell ist es möglich für beliebig viele Frequenzen f und Steuerfunktionen ET die Impedanzen an den Referenzebenen A, B, C (RA, RB, RC) zu ermitteln. In der Praxis sollte dies auf eine realistische Anzahl beschränkt werden, da sich mit jeder Frequenz f und Steuerfunktion ET die Simulationsgeschwindigkeit in der Entwurfsphase verringert.

Die verbesserte Entwurfsmethodik sieht vor, sich bei der Steuerfunktion ET auf die N-1 Back-off Punkte und die Spitzenleistung des jeweiligen N-Wege Doherty Leistungsverstärkers DM, DP1, DP2 zu beschränken und dazu eine angemessene Anzahl an Frequenzen f abhängig von der Breite des gewählten Frequenzbandes zu nutzen.

Durch die Verwendung der Referenzebenen A, B, C (RA, RB, RC) kann das Anpassnetzwerk AN (der Ausgangskombinierer C) wie in Fig. 31 dargestellt in Teilnetzwerke aufgeteilt werden. Diese Teilnetzwerke können einzeln entworfen werden. Der Hauptverstärker DM und die aktiven Lastmodulatoren DP1, DP 2 werden nun unabhängig voneinander entworfen und schließlich zu einem Anpassnetzwerk AN (Ausgangskombinierer C) zusammengebaut.

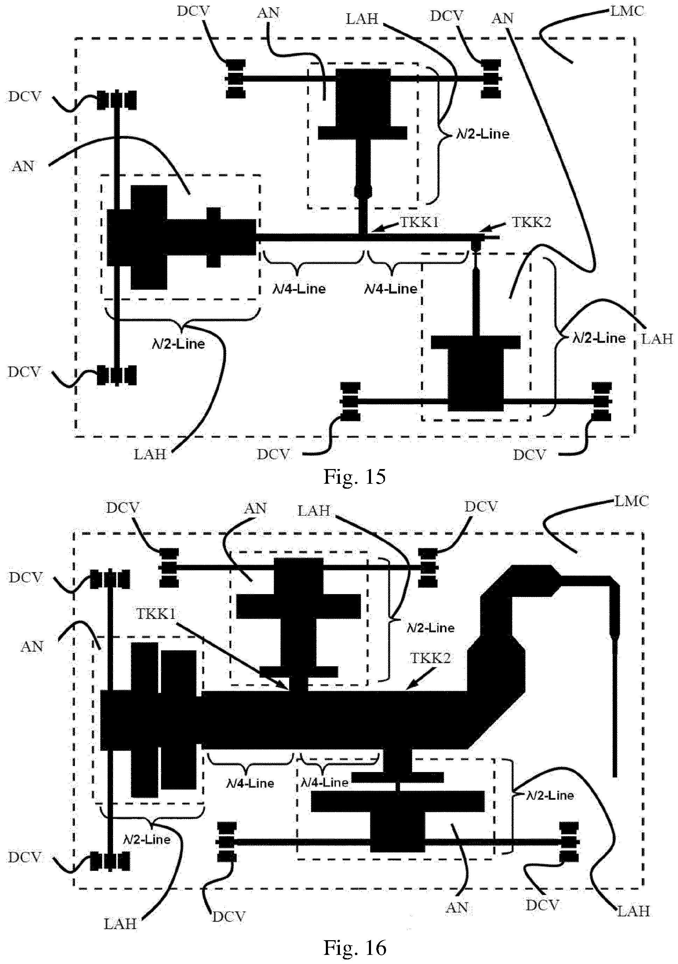

Prinzipiell können der Hauptverstärker DM und die aktiven Lastmodulatoren DP1, DP2 unabhängig voneinander entworfen und schließlich zu einem Anpassnetzwerk AN (Ausgangskombinierer C) zusammengebaut werden. Ist jedoch erhöhte Genauigkeit gefordert, müssen zuerst die Lastmodulatoren DP1, DP2 entworfen werden und zu einem Leistungskombinierungsnetzwerk ohne den Hauptverstärker zusammengebaut werden. Das entspricht Fig. 30, ohne die Stromquelle $I_M$, dessen Drain Parasiten und dem Anpassnetzwerk AN (Ausgangskombinierer C). Nun werden die Impedanzen $Z_M$ (f, ET) an Referenzebene "A" ermittelt. Bei der Messung sollten die Stromquellen ($I_M$, $I_{P1}$, $I_{P2}$) und Drain Parasiten DP durch nicht-lineare Transistormodelle ersetzt werden. Dadurch werden die neue gemessenen Impedanzen ZM (f, ET) exakter als die vorhergehenden Impedanzen, welche lediglich über das lineare Model ermittelt wurden. Durch die "Entwurfsoption" kann die Performanz im Back-off deutlich verbessert werden. Das Layout der so erzeugten zweiten Ausführungsform eines Ausgangskombinierers C ist in Fig. 16 dargestellt.

Mit Hilfe der vorstehend beschriebenen CAD-gestützten Methode wurden zwei HF - Hochleistungsverstärkers HPA entworfen, welche den oben beschriebenen Grenzfällen entsprechen. Das Layout des Ausgangskombinierers C mit einer Länge von ca. 15,1 cm und einer Höhe ca. 9,3 cm vom ersten Grenzfall ist in Fig. 15 (Lastangepasster Kombinierer LMC) und das Layout des Ausgangskombinierers C mit einer Länge von ca. 14,9 cm und die Höhe ca. 10,4 cm vom zweiten Grenzfall ist in Fig. 16 (Breitband Back-off Kombinierer WBC) abgebildet. Beide Verstärker wurden in einem CAD-Tool unter der Verwendung von Steuerfunktionen ET analysiert. Der HF-Hochleistungsverstärker HPA, welcher in Fig. 15 abgebildet ist, hat eine relative Bandbreite von 36,4% während der HF-Hochleistungsverstärker HPA, abgebildet in Fig. 16, eine relative Bandbreite von 43,5% erreicht. Über die gesamte Bandbreite weisen beide HF-Hochleistungsverstärker HPA weniger als ein dB Schwankung in der Spitzenleistung von 61 dBm auf, welche nachfolgend noch näher beschrieben und erläutert werden, wobei der lastangepasste Kombinierer LMC (Fig. 15) genauso wie der Breitband Back-off Kombinierer WBC (Fig. 16) eine Sonderform vom Ausgangskombinierer C sind.

Der in Fig. 15 abgebildete Ausgangskombinierers C soll die Spitzeneffizienz des Zweiten-Backoffs (in welchem nur der Hauptleistungsverstärkers DM arbeitet) über das gesamte Frequenzband erhalten. Er wird nachfolgend als lastangepasster Kombinierer (Load Matched Combiner) LMC bezeichnet. Das Erhalten des hocheffizienten Back-off Punktes über die gesamte Bandbreite steigert die Durchschnittseffizienz für modulierte Wellenformen mit hohem PAPR (Verhältnis von Spitzenleistung zu der mittleren Leistung eines Signal (Peak To Average Power Ratio)).

Es ist allgemein bekannt, dass Mikrostreifenleitung mit hohen Transformationsverhältnissen die Bandbreite verringern, was als "Bode Fano Limit" bekannt ist. Breitband-Verhalten wurde durch Verringerung des Transformations-verhältnisses der $\lambda$/4-Linien erreicht. Unter Berücksichtigung des zweiten Back-off wurde die maximale Bandbreite durch Minimierung der Impedanzänderungen erreicht, wobei $Z_0 \approx Z_1 \approx R_L$. gefordert ist.

Der in Fig. 15 abgebildete Ausgangskombinierer C als LMC kann diese Forderung erfüllen, indem er drei von sechs Freiheitsgraden beansprucht. Aufgrund der zusätzlichen transformierenden Offset-Leitungen LAH am Hauptleistungsverstärker DM verbleiben drei Freiheitsgrade, welche zur Maximierung des Bandbreitenverhaltens genutzt werden können. Im Falle extrem hoher Spitzenausgangsleistung, z.B. größer als 61 dBm, beträgt der Ausgangswiderstand weniger als 6 $\Omega$. Dies Bedarf einem breitbandigen Impedanzinverter mit einem Transformationsverhältnis von mehr als 8,33 für 50 $\Omega$ Lastabgleich. Zum Abgleich des niedrigen Ausgangswiderstands mit 50 S2 Abschluss wird ein breitbandiger, drei-stufen $\lambda$/4 Übertragungsleitung-Impedanzwandler verwendet.

Die Steuerfunktionen ET sind für den Ausgangskombinierer C als LMC von 0,9 GHz bis 1,3 GHz in Stufen von 25 MHz identifiziert, was einer relativen Bandbreite von 36,4 % entspricht. Die Spitzenausgangsleistung für jede Frequenz liegt im Bereich von 60,4 dBm bis 61 dBm. Die Leistungseffizienz PAE (power added efficiency) an den Back-off Punkten ist in Fig. 17 gezeigt.

Die Effizienz und die Verstärkung des HF-Hochleistungsverstärker HPA mit einem Ausgangskombinierer C nach Fig. 15 bei verschiedenen Frequenzen zwischen 0,95 GHz bis 1,25 GHz ist in Fig. 18 dargestellt.

Die Leistung ist vergleichbar mit der Leistung eines idealen Class-B Verstärkers mit einer Maximaleffizienz von $\pi$/4. Der HF-Hochleistungsverstärker HPA zeigt das typische Verhalten eines Doherty mit einem ausgeprägten Effizienzplateau für Ausgangsleistungen größer als 53 dBm oder 54 dBm. Die Steuerfunktionen ET zeigen klar, dass es zu jeder Frequenz eine Spitzeneffizienzstelle gibt, was in Bezug zu dem zweiten Back-off steht. An dieser Stelle ist zu vermerken, dass entgegen der Idealtheorie nur zwei Maximum-Spitzen beobachtet werden. Die Maximum-Effizienzspitze des zweiten Spitzenleistungsverstärkerkerns DP2 ist nicht vorhanden, nicht einmal an der Mittenfrequenz. Aufgrund des allgemeinen Abklingens des Doherty-Prinzips wird dies für nicht-Mittenfrequenzen erwartet. Grund ist der erste Back-off Punkt, welcher auf höhere back-off Werte verschoben ist. Wie die Untersuchungen ergeben haben, hat die fehlende Spitzeneffizienzstelle keinen großen Einfluss auf die Durchschnittseffizienz der modulierten Wellenformen.

Es kann festgestellt werden, dass die verstärkten Kurven einen Abfall erfahren, an der Stelle, wo die Lastmodulation einsetzt. Im Falle eines konventionellen Leistungsverstärkers würden solche abrupten Änderungen am Ausgang starke Nichtlinearitäten erzeugen, welche linearisiert werden müssten. Im Zusammenhang mit dem erfindungsgemäßen digitalen HF-Hochleistungsverstärker HPA ist dies anders. Die Steuerfunktion ET linearisiert den DPA-Ausgang. Die höheren Bandbreitenanforderungen beanspruchen nur die Anforderungen an die Digital-Analog-Umsetzer DAC. Um den Grund für die rapiden Verstärkungsänderungen zu beantworten muss berücksichtigt werden, dass die gegebenen Verstärkungskurven kombinierte Verstärkungen aller drei Verstärkerkerne DM, DP1 und DP2 sind, und nicht die individuelle Verstärkung jedes einzelnen Verstärkerkerns. Die individuellen Verstärkungen erfahren keinerlei derartige spontane Änderungen und haben stattdessen mehr statische Neigungen. Die Gesamtverstärkung sinkt, da die Spitzenleistungsverstärkerkerne DP1 und DP2 als Klasse-C vorgespannt sind und daher eine niedrigere Verstärkung aufweisen, verglichen mit dem Hauptverstärkerkern DM. Die Eingangsleistung der Spitzenleistungsverstärkerkerne DP1 und DP2 überholt schnell die Eingangsleistung des Hauptverstärkers DM, was zu einem rapiden Abfall der Gesamtverstärkung führt.

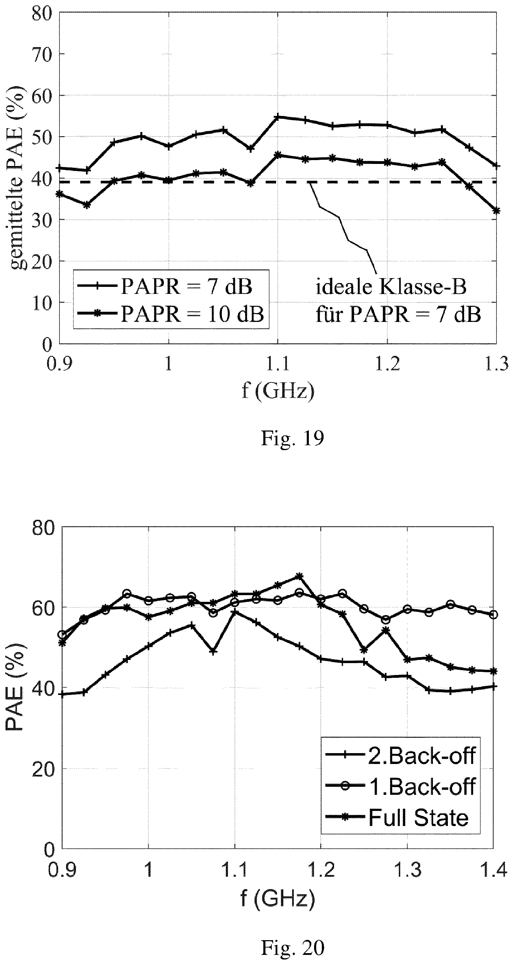

Fig. 19 zeigt die durchschnittliche Leistungseffizienz PAE an den Back-off Punkten für Rayleigh-verteilte Signalformen. Es kann festgestellt werden, dass die PAE für einen weiten Bereich über 40% bleibt. Der in Fig. 15 dargestellte Breitband-Back-off Combiner LMC hat den Vorteil einer klaren hohen Effizienzspitze am zweiten Back-off, was eine hohe Durchschnittseffizienz über die gesamte Bandbreite bereitstellt. Die Kehrseite ist, dass das zusätzliche breitbandige Anpassungsnetzwerk den Flächenbedarf wesentlich erhöht. Ebenso macht die niedrige Impedanzumgebung im Ausgangskombinierer C Schwierigkeiten beim Entwurf des Leiterplattenlayout, da die meisten Mikrostreifenleitungen eine Breite von 13mm bis 16mm aufweisen. Dies reduziert die Zuverlässigkeit in Form von S-Parametern der breiten Ports, da diese weniger genau sind. Selbstverständlich ist dies die hauptsächliche Herausforderung bei Hochleistungsverstärkern mit sehr hoher Leistung, da die Mikrostreifenleitungen mit niedrigerer maximaler Ausgangsleistung dünner werden.

Zusammenfassend kann festgestellt werden, dass der in Fig. 15 dargestellte Breitband Back-off Combiner LMC den Vorteil eines guten Back-off Betriebsverhalten über die gesamte Bandbreite hat, jedoch auch ein paar Nachteile aufweist, insofern er für Aufbauten mit sehr hoher Leistung verwendet wird. Um den breitbandigen Impedanzinverter und auch die Verringerung der Mikrostreifenleitungsbreite im lastabgestimmte Combiner (LMC gemäß Fig. 15) zu vermeiden, muss das Impedanzinverter-Leistungsvermögen im Ausgangskombinierer C ausgenutzt werden.

Bei dem in Fig. 16 dargestellten zweiten Grenzfall wird die Transformationseigenschaft der Combiner-Architektur verwendet, um den Drei-Wege Doherty Power Amplifier DPA direkt auf die gewünschte Lastimpedanz von 50 Ω abzustimmen. Der in Fig. 15 dargestellte lastabgestimmte Combiner (LMC) verwendet dieselbe Architektur wie der in Fig. 16 dargestellte Breitband-Back-off Combiner (WBC), wobei nur die Werte der Komponenten geändert sind.

Die Steuerfunktionen ET sind von 0,9 GHz bis 1,4 GHz in Stufen von 25 MHz identifiziert, was einer relativen Bandbreite von 43,5 % entspricht und sind für das Erreichen der Maximaleffizienz an jedem Leistungslevel identifiziert. Die Spitzenausgangsleistung zu jeder Frequenz liegt im Bereich von 60,3 dBm bis 61 dBm. Fig. 20 zeigt die durchschnittliche Leistungseffizienz PAE an den Back-off-Punkten (1. Back-off, 2. Back-off) sowie bei "Full State" des Ausgangskombinierers C nach Fig. 16. In Fig. 21 ist die Effizienz und die Verstärkung des HF-Hochleistungsverstärker HPA mit einem Ausgangskombinierer C nach Fig. 16 bei verschiedenen Frequenzen ($f_c$=0,95 GHz, $f_c$=1,1 GHz und $f_c$=1,25 GHz) im Frequenzbereich von 0,95 GHz bis 1,25 GHz dargestellt. Weiterhin zeigt Fig. 22 die durchschnittliche Leistungseffizienz PAE an den Back-off Punkten für Rayleigh-verteilte Signalformen für PAPR=7dB und PAPR=10dB. Der ideale Klasse B-Verlauf (horizontale gestrichelte Linie) ist für PAPR=7dB dargestellt.

Der Hauptunterschied zum in Fig. 15 dargestellten lastabgestimmten Combiner (LMC) ist die höhere Bandbreite. Ein weiterer wichtiger Unterschied ist die generelle Erhöhung der durchschnittlichen Leistungseffizienz PAE, speziell innerhalb des Bereichs der Lastmodulation. Die Effizienzkurven beider Combiner LMC für $f_c$ = 1,1GHz sind ähnlich. Für alle anderen Frequenzen betragen die Unterschiede in der durchschnittlichen Leistungseffizienz PAE circa 5 % bis 10 %, meist zugunsten des in Fig. 16 dargestellten Breitband-Back-off Combiner (WBC). Die höhere Effizienz wird nicht erreicht aufgrund, dass der in Fig. 15 dargestellte lastabgestimmte Combiner (LMC) dem in Fig. 16 dargestellten Breitband-Back-off Combiner (WBC) überlegen ist, sondern aufgrund der höheren Präzession während des Entwurfsprozesses. Die Breite der T-Verbindungsports und die Breite aller anderen Verbindungen sind deutlich kleiner. Der breiteste verwendete Port ist 11 mm, verglichen mit den 16 mm beim Breitband-Back-off Combiner (WBC). Daher stellt der in Fig. 16 dargestellte lastabgestimmte Combiner Combiner (LMC) die bessere Option für Hochleistungsverstärker mit sehr hohen Leistungen dar. Insbesondere werden beim erfindungsgemäßen Ausgangskombinierer C sowohl Hauptleistungsverstärker DM als auch Spitzenleistungsverstärkern DP1, DP2 mit der gleichen Drainvorspannung versorgt. Weil nur eine Drainvorspannung benötigt wird, ist der Aufbau sowie der Entwicklungs- und Wartungsaufwand deutlich reduziert. Es werden auch gleiche HEMT - Transistoren verwendet, was zum einen ein wirtschaftlicher Vorteil ist und zum anderen ist davon auszugehen, dass das Temperatur- und Alterungsschwankungen in die gleiche Richtung driften. Hier liegt deutlicher Vorteil zum Stand der Technik.

Zur Messung der Sendeleistung und der Sendesignalqualität weist der HF-Hochleistungsverstärker HPA einen zweiten Richtkoppler R2 (siehe Fig. 1) auf. Die Kopplung zwischen der Sendemikrostreifenleitung und dem zweiten Richtkoppler R2 (siehe Fig. 1) beträgt ca. -40 dB. Richtkoppler (directional coupler) sind elektrisch passive Bauelemente im Bereich der Hochfrequenztechnik, wozu auch Leistungsteiler (power splitter), insbesondere bei Hochfrequenzverstärkern, oder bei inversem Betrieb Leistungskoppler (power combiner) zählen.

Die implementierte Messeinrichtung zur Messung des Sendesignals ist rein induktiv und es entstehen keine zusätzlichen Verluste im Sendesignal, was wiederum den Wirkungsgrad nicht herabsetzt.

Die Schaltung zur Messung von HF-Sendeleistung wird zum OTA-(Over The Air) Test verwendet. Fig. 4 zeigt im Einzelnen den Aufbau für den im HF-Hochleistungsverstärker HPA implementierten OTA-Test. Das Testsignal wird über den zweiten Richtkoppler R2 (siehe Fig. 1) induktiv in den Sendekanal eingekoppelt. Dieser Testaufbau erlaubt alle Sende-und Empfangskomponenten, welche an das Modul GSZ in die Sende- und Empfangsrichtung angeschlossen sind, zu testen, nämlich TX-Kabel TXK, RX-Kabel RXK, Sendeantenne SA und Empfangsantenne EA. Das Sendesignal wird über die Freiraumausbreitung (OTA) an der Empfangsantenne EA empfangen. Der OTA-Test kann entweder zyklisch zu einem bestimmten Zeitpunkt (z.B. täglich) oder in den Sendepausen des Nutzsignals durchgeführt werden.

Am Ausgang des Impedanzwandlers AN1 ist ein Zirkulator Z1 angeschlossen (siehe Fig. 1), welcher als HF-Zirkulator aus Ferriten in Hohlleiter- oder Streifenleitertechnik realisiert werden kann. Im Hinblick auf die gewünschte hohe Bandbreite sollte der Sternpunkt des Ausgangskombinierer C eine verlässliche, konstante Abschlussimpedanz sehen. Dies wird erfindungsgemäß durch den Zirkulator Z1 sichergestellt. Im Stand der Technik sind die passiven Zirkulatoren als flache Bauteile mit einem HF-dichten Gehäuse und drei Koaxialbuchsen (Anschlüsse, Ports) ausgeführt. Im Rahmen der Erfindung kann - abhängig von der Sendeleistung - auch ein breitbandiger, ferrit- und magnetfeldloser Zirkulator oder ein aktiver Zirkulator (beispielsweise aufgebaut mit Operationsverstärkern (spannungsgesteuerten Stromquellen mit Differenzeingang)) eingesetzt werden. Erfindungsgemäß hat der Zirkulator Z1 zwei Funktionen. Zum einen schützt er den vorgeschalteten Doherty Verstärker mit Hauptleistungsverstärker DM, ersten Spitzenleistungsverstärker DP1 und zweiten Spitzenleistungsverstärker DP2 vor ausgangsseitigen Überspannungen und Überstrom, indem der Zirkulator Z1 die Energie, die vom Stecker in die Elektronik fließt, zu einem Sumpfwiderstand W1 ableitet/zirkulieren lässt. Zum anderen wird mit Hilfe des Zirkulator Z1 die rücklaufende HF-Leistung mit einem ersten Richtkoppler R1 (siehe Fig. 1) gemessen. Die Messeinrichtung ist - wie im Sendekanal - mit einem 40 dB Richtkoppler aufgebaut, wobei die rücklaufende HF-Leistung ein Indikator über den Zustand des Steckers S1 bzw. des Antennenkabels/TX-Kabel TXK (siehe Fig. 4) ist.

Die rücklaufende HF-Leistung ist nämlich direkt proportional zum VSWR (Stehwellenverhätnis) am Stecker. Somit kann man einen physikalischen und elektrischen Fehler (z.B. Kabelbruch, Kurzschluss, Leerlauf und etc.) am Stecker sowie am TX-Kabel TXK erkennen. Das erlaubt eine effiziente Fehlerüberwachung ohne dass man in einen Testmodus, während dem die Nutzsignalübertragung unterbrochen wird, wechselt. Die Fehlerüberwachung erfolgt entweder zyklisch oder zum einen beliebigen Zeitpunkt.

Der Ausgangskombinierer C besitzt somit mehrere Funktionen.

Zum Einem soll er über das gesamte Bandbreite des Verstärkers die Spitzeneffizienz im zweiten Back-off Punkt gewährleisten, d.h. nur der Hauptleistungsverstärker DM arbeitet und die Spitzenleistungsverstärker DP1, DP2 sind lediglich am Gate vorgespannt, ohne dass am Eingang ein HF-Signal eingespeist wird (vorerst keine Lastmodulation). Diese Funktion wird durch Implementierung einer breitbandigen Mehrstufen-Transformationsleitung Multiharmonische Transformationsleitung (Offset-Leitung) für die Lastanpassung erreicht.

Des Weiteren soll der Ausgangskombinierer C auch beim ersten Back-off Punkt und bei der Vollaussteuerung eine Impedanztransformation von niederohmiger Impedanzumgebung von Verstärkerausgängen (DM, DP1 und DP2) an die Ausgangsimpedanz vom HF-Hochleistungsverstärker HPA (50 Ohm) transformieren. Da das Signal als vorwärts propagierende Wellen zu betrachten ist, muss man auch die Reflexionen und daraus die durch das Superimpositionsprinzip (Überlagerungsprinzip) bedingten Verluste betrachten. Demzufolge benötigt der Ausgangskombinierer C einen 50 Ohm-Abschluss, um die Reflexionen zu vermeiden.

Der Zirkulator Z1 weist über die komplette Bandbreite von HPA eine 50 Ohm kontrollierte Abschlussimpedanz auf. Dementsprechend ist der Zirkulator Z1 nicht nur als Schutzelement und Meßinstrurment zu betrachten, sondern auch als ein Abschluss für den Ausgangskombinierer C.

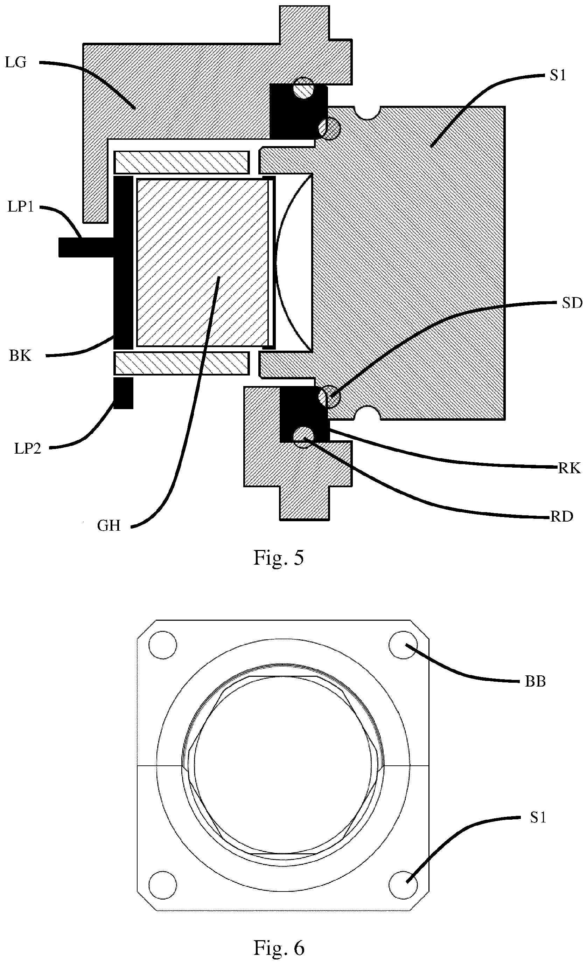

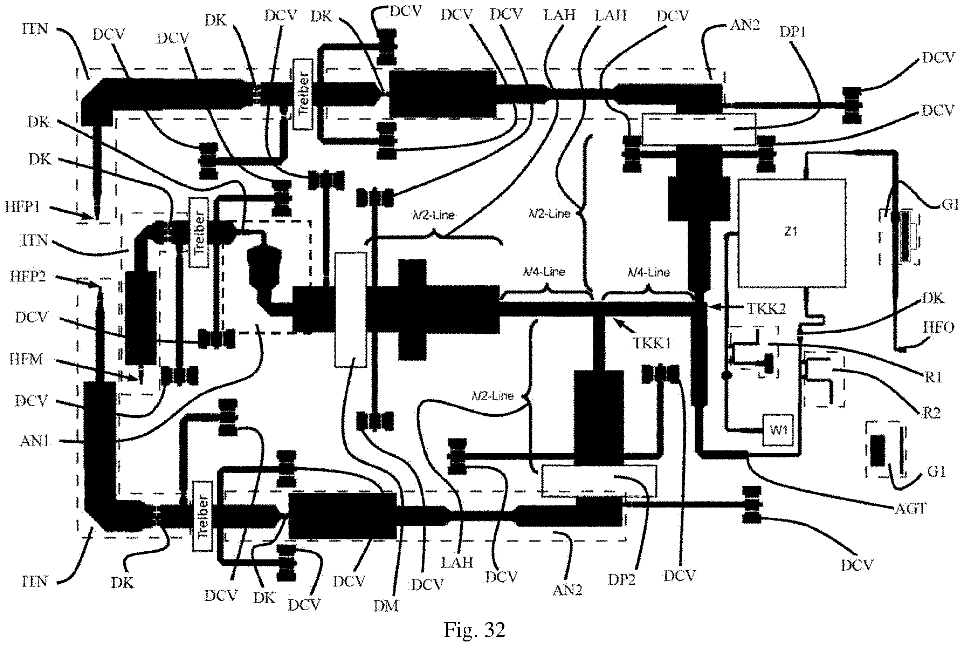

Der Ausgang des HF-Hochleistungsverstärker HPA ist gegen Blitzeinschläge mit einem Gasableiter G1 geschützt (siehe Fig. 1). Der Gasableiter G1 ist auf einer Leiterplatte HFL des HF-Hochleistungsverstärker HPA integriert; das Layout der ein- oder zweiseitigen HF-Leiterplatte ist in Fig. 32 dargestellt. Erfindungsgemäß handelt es sich um ein Leiterplattengehäuse LG, welches direkt auf der Leiterplatte HFL in SMD-Technik gelötet wird und der Schutzklasse IP67 entspricht, siehe Fig. 5. Die Gasentladungshülse GH des Gasableiters G ist über eine Schraube S 1 zu entnehmen bzw. einzusetzen. Die Schraube S 1 hat das Erdpotential und drückt flächig mit einer Feder gegen den linken Anschlusspol der Gasentladungshülse GH. Die Schraube S1 wird in einen Ringkontakt RK, der auf der Leiterplattenkante gelötet werden kann, geschraubt. Eine Schraubendichtung SD drückt einerseits gegen die Schraube S1 andererseits gegen den Ringkontakt RK, um ein Eindringen von Nässe, Staub und Verschmutzung zu verhindern. Auf der Außenfläche des Ringkontakts RK befindet sich eine Nut in die eine Ringdichtung RD (vorzugsweise eine Runddichtung) eingelegt ist. Die Dichtung RD sorgt dafür, dass keine Nässe, Staub und Verschmutzung ins Innere des Leiterplattengehäuses LG eindringen kann.

Die Front des Leiterplattengehäuses LG ist so entworfen, dass das Leiterplattengehäuse LG dicht mit einer Frontplatte des Gerätegehäuses zusammengeschraubt (Schraube S1 und Befestigungsbohrung BB) werden kann, wie dies in Fig. 6 dargestellt ist. Der rechte Anschlusspol der Gasentladungshülse GH ist mit einem als Basiskontakt BK bezeichneten elektrischen Kontakt mechanisch verbunden. Der Basiskontakt BK besitzt zwei Lötpads LP1, LP2 und ist entweder mit dem 1. Lötpad LP1 oder mit dem 2. Lötpad LP2 der zu schützende Leitung verbunden, jedoch nicht mit zwei gleichzeitig. Erfindungsgemäß steht mit zwei Lötpads ein Freiheitsgrad beim Design des Gerätegehäuses zur Verfügung, denn damit kann die Höhe des Leiterplattengehäuses LG bezüglich der Leiterplatte HFL ausgewählt werden.

Das Leiterplattengehäuse LG weist gegenüber den üblichen Blitzschutzpatronen den folgenden Vorteil auf. Erfindungsgemäß ist der Basiskontakt BK direkt mit der Leiterbahn, welche gegen den Blitzeinschlag geschützt werden soll, verbunden wohingegen handelsübliche Blitzschutzpatrone zwischen dem Ausgangsstecker des HF-Leistungsverstärkers und dem Antennenkabel installiert werden. Demzufolge erfährt das HF-Sendesignal eine zusätzliche Dämpfung an jedem Verbindungsstecker der Blitzschutzpatrone. Mit einer Durchgangsdämpfung des Steckers von 0,8dB bis 1dB ergibt sich bei zwei Verbindungssteckern eine Gesamtdämpfung zwischen 1,6dB und 2dB. Das entspricht einer Reduktion der Sendeleistung um 31% bzw. 37%. Der Einsatz des erfindungsgemäßen Leiterplattengehäuses LG für die Gasentladungshülse GH anstatt der Blitzschutzpatrone reduziert die Verlustleistung enorm und steigert die Effizienz des Moduls GSZ/ HF-Hochleistungsverstärker HPA sowie der gesamten Sende- und Empfangseinrichtung. Das Leiterplattengehäuse LG wird auch in den drei Empfangsleitungen eingesetzt.

Die Schutzbeschaltung des Rx-Eingangs (HF-Hochleistungsverstärker HPA) ist zweistufig implementiert. (siehe Fig. 1 rechts unten) Der Gasableiter G1 schützt das Gerät vor antennenseitige Blitzeinschläge - Grobschutz. Beim Blitzeinschlagereignis wird der Strom (Energie) auf das Erdpotential abgeleitet (Erdschiene ES). Eine zweite Stufe U1 schützt den Rx-Eingang gegen transiente Überspannung - Feinschutz U1. Dabei wird die Energie auf das Bezugspotential abgeleitet. Der Feinschutz U1 löscht sowohl bei Transienten, die extern entstehen z. B. von externen LNA (Low Noise Amplifier), als auch bei Transienten, die von der internen Elektronik kommen, aus.

Der Tx-Ausgang besitzt zwei Gasableiter G1 (siehe Fig. 1 rechts oben). Erster Gasableiter G1 ist zwischen TX - Nutzsignalleitung und Erdpotential angeschlossen, der zweite Gasableiter G2 ist zwischen Bezugspotential und Erdpotential angeschlossen. Auf diese Weise ist der HF-Hochleistungsverstärker HPA sowohl gegen Blitzeinschlag in die Antenne A bzw. Antennenkabelinnenader als auch gegen Blitzeinschlag ins Bezugspotential geschützt. Einen Feinschutz im klassischen Sinne besitzt der Tx-Ausgang nicht. Der Schutz gegen externe transiente Überspannung wird mit dem Zirkulator Z1 realisiert. Transiente Spannungen im Durchgangsbereich des Zirkulator Z1 werden auf den Sumpfwiderstand W1 abgeleitet. Transienten Spannungen außerhalb des Durchgangsbereichs werden von Zirkulator Z1 stark gedämpft.

Das erfindungsgemäße Modul GSZ/der HF-Hochleistungsverstärker HPA muss bei der Inbetriebnahme kalibriert werden. Zum Kalibrieren wird ein Empfangs-/Monitoringkanal zusammen mit dem zweiten Richtkoppler R2 (siehe Fig. 1) verwendet. HF-Leistung, DC-Leistung (Drain-Source Spannung, Drain Strom und Gate Strom), Signalqualität und Effizienz werden dabei erfasst.

Aus dem Datensatz wird eine Steuerfunktion ET für den Hauptleistungsverstärker DM und die zwei Spitzenleistungsverstärker DP1, DP2 generiert. Im laufenden Sendebetrieb wird die Feinkalibrierung, die parallel im Hintergrund läuft, durchgeführt, um Effekte wie Temperaturschwankungen, Alterung und Sendefrequenzänderung zu kompensieren, so dass höchste Effizienz und beste Signalqualität immer gewährleistet sind. Kompressionskontrolle von mehreren Leistungsverstärkerkernen gestaltet sich in Anwendungen, welche auf aktive Lastmodulation Basis beruhen, sehr schwierig. Die Kompressionskontrolle ist für die Lebensdauer und sogar eventuelle Zerstörung der Leistungstransistoren sehr wichtig. Eine initiale Identifizierung des Verstärkers mit drei Leistungsverstärkerkernen (DM, DP1, DP2) in einem Fünf-dimensionalen Raum ist nur im begrenzten Umfang möglich. Durch die Alterungsprozesse ist dann eine Neuidentifizierung unabdingbar, was einen sicheren und kontinuierlichen Betrieb des Verstärkers widerspricht.

Erfindungsgemäß werden jeweils die Gate-Ströme zum Bestimmen des Kompressionsniveaus des Leistungsverstärkerkerns (DM, DP1, DP2) verwendet. Leistungstransistoren, basierend auf einer Schottky Diode, weisen hohe Gate-Ströme auf, z.B. GaN-HEMT Transistoren (highelectron-mobility transistor, d.h. Transistoren mit hoher Elektronenbeweglichkeit). Der benutzte GaN-HEMT (Galliumnitrid) ist aufgrund der hohen Ladungsträgermobilität für Hochfrequenzanwendungen gut geeignet. Die Steuerung des Bauelementes erfolgt, ähnlich wie beim Metall-Halbleiter-Feldeffekttransistor, über ein Metall-Gate, das mit der Galliumnitrid-Schicht verbunden ist. Die hohen Gate-Ströme werden zum Überwachen des momentanen Kompressionslevels der Leistungsverstärkerkerne verwendet. Fig. 23 zeigt das Verhältnis zwischen Gate-Strom und Kompressionsniveau anhand eines GaN-HEMT Leistungsverstärkers. Auf diese Weise wird eine in-situ Kompressionskontrolle für jeden Leistungsverstärkerkern DM, DP1, DP2 realisiert, ohne eine initiale Identifizierung und ohne nachfolgende Neuidentifizierungen durchzuführen. Dieser Art der Kompressionskontrolle wird durch Alterungsprozesse nicht gestört und ermöglicht defekte Verstärkerkerne oder Verstärkerkerne, die kurz vor Ausfall stehen, zu detektieren. Der Wartungsaufwand sowie die Investitionskosten werden dadurch verringert und die Lebensdauer des jeweiligen HF-Leistungsverstärkers DM, DP1, DP2 verlängert. Alternativ kann auch ein Materialsystem mit Aluminiumgalliumnitrid (AlGaN) oder Aluminiumindiumnitrid (AlInN) benutzt werden, das aufgrund seines vergleichsweise hohen Bandabstands eine höhere Betriebsspannung ermöglicht, bevor es zum Felddurchbruch kommt. Besonders für die Herstellung von Leistungstransistoren erweist sich diese Materialkombination als vorteilhaft, da die Ausgangsimpedanz bei gleicher Leistung steigt und somit die Auskopplung der Leistung vereinfacht wird (Anpassung). Auf Siliciumcarbid (SiC) abgeschieden, weist es zusätzlich einen geringeren thermischen Widerstand als GaAs-Materialkombinationen auf, was sich positiv auf die maximale Verlustleistung bzw. Lebensdauer und Zuverlässigkeit auswirkt.

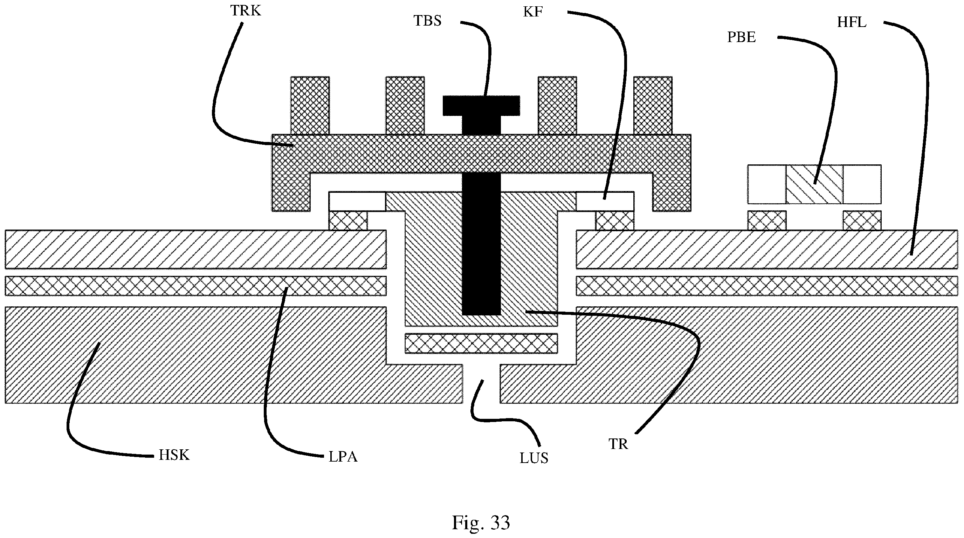

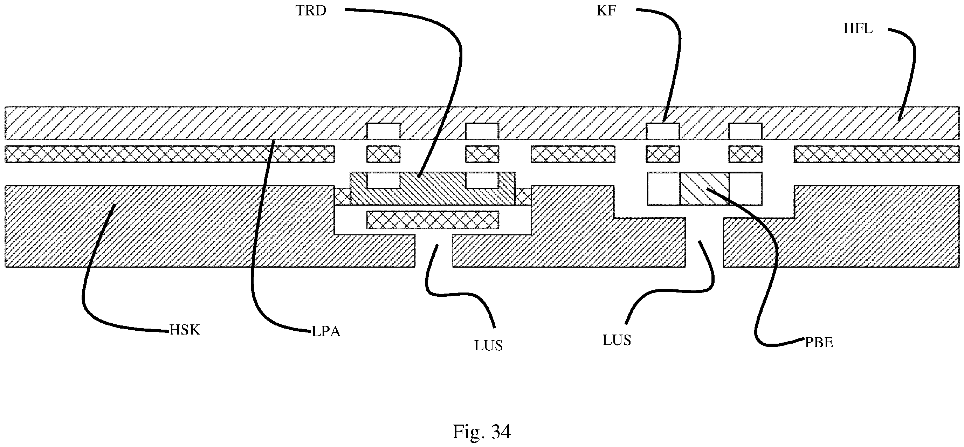

Der Aufbau des HF-Hochleistungsverstärker HPA erhöht die Effizienz, wobei die thermische Verlustleistung reduziert wird. Die Hotspots sind der Hauptleistungsverstärker DM und die beiden Spitzenleistungsverstärker DP1, DP2. Alle drei Leistungsverstärker DM, DP1, DP2 sind mechanisch und elektrisch mit dem Source-Anschluss an einem Kühlkörper HSK, insbesondere einem Kupfer-Kühlkörper (Heatsink) angeschlossen. Der Kühlkörper HSK (siehe Fig. 33, Fig. 34) ist über eine Lötpaste / Klebefolie / Kleber oder Wärmeleitfolie LPA, die elektrisch isolierend ist, großflächig mit dem Gerätegehäuse des Moduls GSZ verbunden. Die Wärme wird auf diese Weise über das Gerätegehäuse abgeführt. Dieses Wärmemanagementdesign erlaubt einen lüfterlosen Aufbau vom Modul GSZ, sowohl für Innenraum- als auch für Freiluft-/Außeneinsatz, was wirtschaftliche Vorteile hat und den Wartungsaufwand senkt.

Fig. 33 zeigt im Schnitt ein Detail des konstruktiven Aufbaus des erfindungsgemäßen HF-Hochleistungsverstärker HPA zur Verdeutlichung des Wärmemanagements. Hohe Effizienz vom HF-Hochleistungsverstärker HPA wird unter anderem durch den Aufbau erreicht. Der Aufbau soll dazu dienen, die Wärme vom HF-Hochleistungsverstärker HPA und insbesondere von Transistoren TR besonders gut abzuleiten. Die Baugruppe/das Modul GSZ ist so aufgebaut, dass sämtliche Bauteile (passive Bauelemente PBE, Stecker, Transistoren TR und Leiterbahnstrukturen) eine gute thermische Anbindung an die einzige Kupferkühlfläche HSK aufweisen. Die Kontaktflächen für die Transistoren TR, die passiven Bauelemente PBE u.a. sind mit KF bezeichnet und die Leiterplatte HFL kann einen 1- oder 2-seitigen Aufbau haben. Jeder Transistor TR besitzt zusätzlich einen Kühlkörper TRK, der mit den Transistoren TR über Transistorbefestigungsschrauben TBS verbunden ist. Ferner sind Entlüftungslöcher/Luftspalt(e) LUS im Kühlkörper HSK (auch für die Lötpaste LPA bzw. für einen sich infolge des Fluxmittels aufbauenden Überdruck und Lunker bei der Fertigung) vorgesehen. Diese Aufbautechnik sorgt dafür, dass die Wärmehotspots (Transistor-Chips) eine hohe Wärmeableitung vorweisen können. Hohe Wärmeableitung von Transistor-Chips bringt den Vorteil, dass die Effizienz vom HF-Hochleistungsverstärker HPA steigt.

Eine weitere Aufbaumöglichkeit ist, die Bauelemente auf der Lötseite der Leiterplatte anzubringen und mit Transistor-Dies TRD zu arbeiten (siehe Fig. 34). Die Transistor-Dies TRD sind mit der Flip-Chip-Technik angebracht, wobei Entlüftungslöcher im Kühlkörper HSK (auch für die Lötpaste LPA bzw. für einen sich infolge des Fluxmittels aufbauenden Überdruck und Lunker bei der Fertigung) vorgesehen sind. Dadurch werden zwei wesentliche Vorteile gegenüber der Standardaufbautechnik erreicht. Mit der Flip-Chip-Technik wird die parasitäre Induktivität vom Transistor-Chip reduziert, was die Qualität des Sendesignals steigert und die Entwicklungszeit für die Leiterbahnstruktur verkürzt wird. Das Transistor-Die TRD werden mit der Kupferkühlfläche (des Kühlkörpers TRK) direkt oder mittels der Lötpaste LPA elektrisch und thermisch verbunden. Auf diese Weise wird der thermische Widerstand vom Transistorgehäuse eliminiert. Dadurch bekommt man bessere Wärmeableitung des Transistor-Dies TRD und infolgedessen kann mehr Strom über den Transistor TR fließen, d.h. man erhöht die Effizienz des Transistors TR und verschiebt den Transistorsättigungspunkt weiter nach oben.

Das Gerätegehäuse des Moduls GSZ ist isolierend aufgebaut, d.h. es kann sowohl das Erdpotential besitzen als auch potentialfrei (Faradaykäfig-Prinzip) sein. Sämtliche Stromversorgungsanschlüsse, Antennenstecker und Kommunikationsstecker sind von Gerätegehäuse isoliert, was das SNR verbessert, da keine Störsignaleinkopplung untereinander und von der PE-Leitung stattfindet (siehe Fig. 2).

Der integrierte DLC-3AD (ASIC) der Anmelderin übernimmt die Powerline Communication-, Mess- und Diagnoseaufgaben der erfindungsgemäßen Sende- und Empfangsvorrichtung. DLC-3AD ist eine redundante Kommunikationsschnittstelle (mittels Software konfigurierbar) und damit eine zusätzliche Zeitsynchronisation. Der Einsatz von DLC-3AD reduziert die Anzahl der Kabel und folglich der Steckverbindungen. Die Qualität und die Lebensdauer des Gesamtsystems werden damit erhöht.

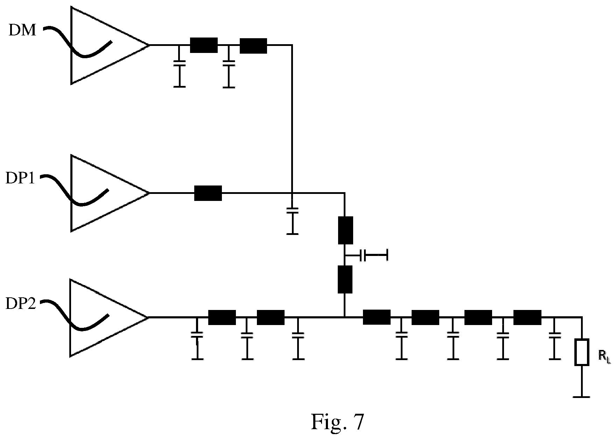

Wie bereits erläutert ist der HF-Hochleistungsverstärker (HPA) ein elektronisches Gerät, welches einen aktiven lastmodulierten HF-Leistungsverstärker (nach dem Doherty-Prinzip) darstellt. Der genannte HF-Hochleistungsverstärker (HPA) besitzt drei Ansteuerungseingänge, welche jeweils mit einem Leistungstransistor verbunden sind, einen für den Hauptleistungsverstärker DM und zwei für die beiden Spitzenleistungsverstärker DP 1, DP2 als aktive Lastmodulatoren. Die Ausgänge der Leistungstransistoren DM, DP1, DP2 sind an ein multiharmonisches Leistungskombinierungsnetzwerk/Ausgangskombinierer C angeschlossen, welches/welcher einen Ausgang besitzt an dem die Last/Stecker/Antenne A angeschlossen wird, wie im Ersatzschaltbild Fig. 7 dargelegt. Die Art und Weise, wie die Leistungstransistoren ihre Leistung an das Netzwerk abgeben, wird über die Amplitude und Phase an den Ansteuerungseingängen bestimmt.

Der HF-Hochleistungsverstärker (HPA) besitzt drei Eingänge, die individuell in Betrag und Phase angesteuert werden (siehe Fig. 14). Die Ansteuerungseinheit bildet die Funktionalität der Steuerfunktion ab/digitaler Eingangssignalteiler ET. Da jeder Leistungsverstärker individuell angesteuert wird, besitzt die Steuerfunktion sechs Freiheitsgrade (ein fünf-dimensionaler Raum). Im Gegensatz zu klassischen Doherty-Verstärkern bei denen die Steuerfunktion mit einem analogen Leistungsteiler realisiert ist, wurde die Steuerfunktion ET des erfindungsgemäßen HF-Hochleistungsverstärker (HPA) in den digitalen Bereich DD (digitale Domäne) ausgelagert. Auf diese Weise kann ein beliebiger Betrag und eine beliebige Phase des Ansteuersignals an jedem einzelnen Eingang eingestellt werden.

Die Steuerfunktion ET im digitalen Bereich besitzt fast unendlich viele Lösungen im fünf-dimensionalen Raum, in welchem mindestens eine statische Funktion gefunden werden kann, welche die Optimierungskriterien hinsichtlich der Effizienz, Linearität und Bandbreite erfüllt. Darüber hinaus hat die Steuerfunktion die Aufgabe die Komplexität der DPD (Digital Pre Distortion) und dynamische Memory-Effekte der benutzten GaN-HEMT Transistoren zu minimieren. Das Auslagern der Steuerfunktion ET in den digitalen Bereich hat den zusätzlichen Vorteil, dass die Durchgangsdämpfung des analogen Leistungsteilers nicht vorhanden ist.

Fig. 8 zeigt vier Antenneninstallations-Varianten, nämlich in der ersten Zeile die Variante 1 als Rundstab für das L-Band (dabei sitzt die Stabantenne zentral auf der Mastspitze), in der zweiten Zeile die Variante 1b als Rundstab für das L-Band und GPS (dabei sitzt die Stabantenne zentral auf der Mastspitze und die GPS Stabantenne auf der L-Band Stabantenne), in der dritten Zeile die Variante 1c in der Anordnung der L-Band Stabantenne seitlich auf der Mastspitze und die GPS Stabantenne seitlich auf der Mastspitze neben der L-Band Stabantenne), in der vierten Zeile die Variante 2 in der Anordnung, dass die Stabantennen für das L-Band und GPS seitlich vom Mast und nicht auf der Mastspitze sitzen und in der fünften Zeile in Draufsicht eine 3xPlanar-Antenne A, wobei jede Planarantenne aus bis zu sechs L-Band Antennenelementen Ant. 1 bis Ant. n besteht. Die jeweilige Installationsvariante der Antenne A bestimmt die Ausbreitung bzw. die Abschottung vom elektromagnetischen Feld, das von der Antenne A abgestrahlt bzw. empfangen wird. Der Vorteil der erfindungsgemäßen Sende- Empfangsanlage ist, dass alle in der Fig. 8 abgebildete Varianten mit einem System abgedeckt werden können.

Zusammenfassend ermöglicht der erfindungsgemäße Ausgangskombinierer C, welcher Impedanzinverter an allen Verstärkerkernen DM, DP1, DP2, .. besitzt, die Eliminierung von parasitären Harmonischen sowie die Optimierung für Breitbandperformance. Ein erster Ausgangskombinierer C, welcher die Spitzeneffizienz des Zweiten-Back-offs (in welchem nur der Hauptleistungsverstärkers DM arbeitet) über das gesamte Frequenzband erhalten soll und auch als (in Fig. 15 dargestellter) lastabgestimmter Combiner (LMC) bezeichnet wird, benötigt für die Lastanpassung breitbandige Mehrstufen-Transformationsleitungen und bietet hohe Back-off Effizienz über die Zielbandbreite. Diese Ausführungsform des erfindungsgemäßen HF-Hochleistungsverstärker HPA erreicht eine relative Bandbreite von 36,4% und eine Spitzenausgangsleistung von 61 dBm mit einem Ripple von weniger als 1 dB. Der zweite in Fig. 16 dargestellte und als Breitband-Back-off Combiner (WBC) bezeichnete Ausgangskombinierer C, transformiert die niedrige Impedanzumgebung an den gewünschten Lastabschluss. Er eignet sich dazu die Designziele über das gesamte Frequenzband zu erreichen und deckt sogar eine breite Region außerhalb des Bands ab. Er besitzt eine relative Bandbreite von 43,5% und eine Spitzenausgangsleistung von 61 dBm mit einem Ripple von weniger als 1 dB.

Darauf basierend wird erfindungsgemäß eine digitale, energieeffiziente, lüfterlose und gegen Blitzeinschläge geschützte, konfigurierbare Hochleistungs- Sende- und Empfangsvorrichtung für das derzeitige aeronautische L-Band bereitgestellt. Das Layout einer ein- oder zweiseitigen HF-Leiterplatte HFL des erfindungsgemäßen Moduls GSZ ist in Fig. 32 dargestellt. Dabei sind mit HFP1 der HF-Signal Eingang des 1. Spitzenleistungsverstärkers DP1, mit HFP1 der HF-Signal Eingang des 2. Spitzenleistungsverstärker DP2, mit HFM der HF-Signal Eingang des Hauptleistungsverstärker DM, mit HFO der HF-Hochleistungsverstärker Ausgang des HF-Hochleistungsverstärker HPA (High Power Amplifier), mit DCV die impedanzangepassten Gleichstromversorgungsanschlüsse, mit DK diskrete Kapazitäten, mit ITN ein Impedanztransformationsnetzwerk für die Eingangsanpassung, mit TKK1 ein Mikrostreifenleitungen der Länge λ/4 aufweisender T-Kreuz Kombinierer 1, mit TKK2 ein weiterer T-Kreuz Kombinierer 2, mit W1 ein Widerstand 1 (auch Sumpfwiderstand genannt), mit AGT ein Ausgangstransformator und ein Zwischenstufennetzwerk (Gate & Drain Matching mit Impedanztransformation) gekennzeichnet.

Erfindungsgemäß sind spezielle Netzwerke zur Bereitstellung eines bestimmten Terminierungsverlaufes bei der zweiten Harmonischen vorgesehen, insbesondere zur Realisierung von erweiterten Breitband -Verstärkerklassen, wobei der Imaginärteil bei der 2. Harmonischen gegenläufig zum Imaginärteil der Fundamentalen und zusätzlich in einem bestimmten Verhältnis entlang der Frequenzachse ist. Mit der erfindungsgemäßen Architektur werden die Verstärkerkerne des Hauptleistungsverstärkers DM, des 1. Spitzenleistungsverstärkers DP1 und des 2. Spitzenleistungsverstärker DP2 diesen Breitband-Terminierungsbedingungen bei Fundamentaler und Harmonischen unterworfen. In dieser Architektur wird der Impedanzinverter aus kurzen Leitungselementen aufgebaut, die so kurz gegenüber der Wellenlänge λ sind, dass sie als Ersatz für konzentrierte Bauelemente - wie Kapazitäten und Spulen- und eben nicht als Leitungen betrachtet werden können. Auch ist das Problem der lokalen Harmonischenterminierung an den Ausgängen der Verstärkerkerne gelöst, da sich die Leitungssegmente aufgrund ihrer Längen leitungstransformatisch und nicht konzentriert verhalten.

Die erfindungsgemäßen mehrstufigen Netzwerke höherer Ordnung sind im Layout der Fig. 15, Fig. 16 und Fig. 32 aus den mehrfachen direkt aufeinander folgenden Verbreiterungen der Leiterbahnen zu erkennen. Im Combiner von Hauptleistungsverstärkers DM, des 1. Spitzenleistungsverstärkers DP1 und des 2. Spitzenleistungsverstärker DP2 werden auch die Transformationen der Harmonischen berücksichtigt und gezielt beeinflusst, wofür die Breite der Leitungen variiert wird. Durch die höhere Ordnung der Netzwerke lokal an den Verstärkerkernen in der beschriebenen Architektur, lassen sich die Terminierungsbedingungen bei mehreren Harmonischen und korrekter Phasenlage bedienen. Damit kann der Austausch von Leistung (bei Harmonischen durch Kapazitäten und Induktivitäten) nicht nur bei einer, sondern bei mehreren Harmonischen stark reduziert bis unterbunden werden, was den Wirkungsgrad weiter erhöht. Die Kontrolle von noch mehr Harmonischen wird erfindungsgemäß im Fall hoher Ausgangsleistungen von über 500 W vorgenommen, um die Abwärme zu reduzieren.

Im Vergleich zum in der WO 2013006941 A1 beschriebenen Doherty Verstärker, welcher keinen Richtkoppler/ Zirkulator Z1 im Combiner (Ausgangskombinierer C) aufweist ,wird die 2. Harmonische transparent über den Combiner geführt, so dass Main und Peak Amplifier bei der 2. Harmonischen Leistung austauschen, was in der erfindungsgemäßen Architektur unterbunden wird, da dies den Wirkungsgrad herabsetzt. Erfindungsgemäß werden alle Verstärkerkerne von Hauptleistungsverstärker DM, 1. Spitzenleistungsverstärkers DP1 und 2. Spitzenleistungsverstärker DP2 lokal bezüglich ihrer Harmonischen bei korrekter Phasenlage terminiert, so dass nur ein geringer bis gar kein Austausch von Leistung bei Harmonischen stattfinden kann.

Im Vergleich zum in der DE 601 24 728 T2 beschriebenen Komposit-Verstärker wird erfindungsgemäß eine digitale Vorverzerrung DPD bzw. die digitale Steuerfunktion ET genutzt. Der Eingang der digitalen Vorverzerrung DPD ist mit dem Ausgang des Digital Signal Prozessor Block DSP und der Ausgang der digitalen Vorverzerrung DPD ist mit der Steuerfunktion/ dem digitalen Eingangssignalteiler ET verbunden (siehe Fig. 1). DSP ist ein Digital Signal Prozessor Block, der für die Aufbereitung des digitalen Sendesignals zuständig ist, d.h. das Sendesignal wird für den jeweiligen Kommunikationsstandard encodiert.

Die digitale Vorverzerrung DPD ist kein Bestandsteil der Steuerfunktion ET. DPD ist eine digitale Vorverzerrung des Sendesignals, wobei die digitale Vorverzerrung DPD der Steuerfunktion/ dem digitalen Eingangssignalteiler ET vorgeschaltet ist (siehe Fig. 1). Die digitale Vorverzerrung DPD soll die Memory- Effekte, die bei den Verstärkerkernen auftreten ausgleichen/entgegenwirken. Die Memory - Effekte sind nicht statisch sondern dynamisch. Diese sind von der Temperatur, Modulationsverfahren, Alterung, Drainspannung u.a. abhängig.

Das Sendesignal wird über den Richtkoppler R2 (siehe Fig. 1) überwacht, was eine Echtzeit-Vorverzerrung des digitalen Datenstroms erlaubt. Durch den Einsatz der digitalen Vorverzerrung DPD steigert man die Linearität des Doherty Verstärkers. Die Kombination von der digitalen Vorverzerrung DPD und Steuerfunktion/ dem digitalen Eingangssignalteiler ET erlaubt einen effizienten, breitbandigen und linearen Betrieb des HF-Hochleistungsverstärkers HPA sowie eine deutliche Verbesserung von SNR. So ein Betrieb ist mit einer analogen Vorverzerrungstechnik und mit einer statischer Steuerfunktion (nur eine Phasenlage zwischen Hauptleistungsverstärker DM und Spitzenleistungsverstärker DP1 bzw. DP2) ist nicht möglich.

Mit der digitalen Vorverzerrung DPD können auch gedächtnisbehaftete Effekte korrigiert werden, was durch eine geschickte Kombination von statischer Steuerfunktion und Memory-DPD (gedächtnisbehaftete digitale Vorverzerrung) erreicht wird und mit analogen Vorverzerrungsnetzwerken nur mit extrem großen Aufwand bzw. gar nicht möglich ist. Demzufolge weist die erfindungsgemäße Architektur mit ihrer digitalen Steuerfunktion ET mehr Freiheitsgrade auf als der in der DE 601 24 728 T2 beschriebene Komposit-Verstärker mit analoger Steuerfunktion.

Um die Steuerfunktion aus dem analogen Bereich in den digitalen zu verschieben erfolgt die Implementierung der Steuerfunktion ET im FPGA. Das digitale Sendesignal aus der Steuerfunktion ET wird mit dem Digital-zu-Analog Wandler DAC in das analoge Sendesignal gewandelt (siehe Fig. 1).

Die typische Impedanz des analogen Sendezuges am Ausgang von Digital-zu-Analog Wandler DAC beträgt 50 Ohm. Die Impedanz am Eingang der Treiberstufe (Fig. 32) Verstärkerkerne ist niederohmig, weil der Hauptleistungsverstärker HPA als Klasse-B Verstärker und die Spitzenleistungsverstärker DP1 und DP2als Klasse-C Verstärker vorgespannt sind. Zwischen dem Signaleingang vom Hauptleistungsverstärker DM, vom Spitzenleistungsverstärker DP1 und vom Spitzenleistungsverstärker DP2 und den Verstärkerkernen der jeweiligen Treiberstufe ist ein Impedanztransformationsnetzwerk ITN mit Impedanzwandlern AN1 und AN2 angeordnet. Im Einzelnen ist AN2 ein für den Spitzenleistungsverstärker DP1 und den Spitzenleistungsverstärker DP2 jeweils gleiches (zweites) Anpassnetzwerk. Das (erste) Anpassnetzwerk/Impedanzwandler AN1 des Hauptleistungsverstärkers HPA unterscheidet sich vom (zweiten) Anpassnetzwerk AN2 von DP1 und DP2 und weist eine andere physikalische Leitungsführungsstruktur wie der Impedanzwandler AN1 auf, da die Strukturen für die beste Effizienz und höchste Bandbreite des HF-Hochleistungsverstärkers HPA bei der Designfrequenz entwickelt sind. Dies gilt allgemein auch für einen Zwei-Wege Doherty Power Amplifier.

Zusätzlich sind Hauptleistungsverstärker DM und die Spitzenleistungsverstärker DP1/DP2 unterschiedlich am Gate vorgespannt (DP1 und DP2 sind gleich). Dadurch ergeben sich unterschiedliche Eingangsimpedanzen am Hauptleistungsverstärker DM und den Spitzenleistungsverstärkern DP1/DP2.

Das Impedanztranformationsnetzwerk ITN wandelt die 50 Ohm-Impedanz in die Impedanz der Eingänge von Treiberstufe Verstärkerkerne um. Dadurch werden Reflexionen bei der Designfrequenz am Eingang vom HF-Hochleistungsverstärker HPA vermieden.

Wie oben stehend beschrieben sind die Ausgänge der Leistungstransistoren DM, DP1, DP2 (im Rahmen der Erfindung n-Wege Doherty Verstärker) an ein multi-harmonisches Leistungskombinierungsnetzwerk/ Ausgangskombinierer C /Impedanzwandler AN1 angeschlossen, welches/welcher einen Ausgang besitzt, an dem der Zirkulator Z1 angeschlossen wird und welcher über den Gasableiter G1 (auf der Leiterplatte HFL integriert, welche in Leiterplattengehäuse LG angeordnet ist), der schaltbaren rauscharmen Verstärkerschaltung LNA mit der Last/Antenne A in Verbindung steht. Der durch Software definierte digitale Verstärker ermöglicht die Konfiguration eines verlustarmen 3-Wege Doherty Verstärker, die Kalibrierung online (Steuerfunktion, digitale Vorverzerrung DPD), die digitale Adaption von Phasenlage und Amplitude (online). Zudem ist eine flexible Konfiguration für unterschiedliche Antennenvarianten möglich. Durch die gesteuerte Spannungsversorgung (ein/aus) kann der Umschaltbetrieb zwischen Senden und Empfangen gesteuert, sowie der Test der Infrastruktur online durchgeführt werden. Das Leiterplattengehäuse LG bzw. des Moduls GSZ agiert als ein zusätzliches Kühlelement (so dass beide Gehäusetypen lüfterlos designt werden können) und der integrierte Gasableiter G1 ist für den Service wechselfähig. Die Stromversorgungsleitungen VCC und GND sind isoliert gegen Erde und die Überspannungsableitung erfolgt gegen Erdpotential, so dass Potential gebunden oder getrennte Installation, und so ein verbessertes SNR, da keine (Ein) - Kopplung durch Erde, und eine potentialgetrennte Installation ermöglicht wird. Ferner weist die erfindungsgemäße Hochleistungs- Sende-/Empfangsvorrichtung eine Reduktion der Kabel und damit eine Reduktion der Steckverbindungen auf, wobei gleiche Baugruppen und Steckerbelegungen für die Konfiguration von Indoor und Outdoor Varianten benutzt werden können. Erfindungsgemäß kann der Richtkoppler R2 (siehe Fig. 1) zweifach, nämlich auch für das Testsignal genutzt werden. Weitere Vorteile ergeben sich aus der Nutzung einer besonderen Powerline Übertragung (DLC) die Vorteile der Redundanz (nämlich eine zusätzliche optionale Zeitsynchronisation) sowie eine Reduktion der Kabel und damit der Steckverbindungen. Durch den reduzierten Energieverbrauch der erfindungsgemäßen Hochleistungs- Sende- und Empfangsvorrichtung können die Betriebskosten gesenkt und ein lüfterloser Betrieb (passive Kühlung) sowohl Indoor als auch Outdoor ermöglicht werden. Die Reduktion der Verluste bedeutet auch mehr Reichweite des Senders (mit GaN HEMT Transistoren für alle drei Verstärkerkerne DM, DP1 und DP2 des HF-Hochleistungsverstärker (HPA) mit 500W) sowie besseres SNR auf der Empfangsseite.

Im Vergleich zum in der Fachliteratur beschriebenen Konzept, siehe insbesondere Neo, W. C. Edmund [u.a.]: A mixed-signal approach towards linear and efficient N-way Doherty amplifiers (siehe Seite 5 der vorliegenden Beschreibung)ist die hohe Bandbreite HF-Hochleistungsverstärker (HPA) ein wesentliches Unterscheidungsmerkmal In der vorstehend genannten Fachliteratur von Neo et al wurde ein digitaler Eingangsteiler dazu verwendet, um auf der Designfrequenz verbesserte Eigenschaften zu erreichen. Speziell ist hier die Reduzierung der hohen Kompression des Hauptleistungsverstärkers (DM) zu nennen. Anregung einen Doherty mit hoher Bandbreite zu bauen sind der Fachliteratur von Neo et al nicht zu entnehmen sondern dort wird das Konzept des digitalen Eingangsteilers eingeführt und dessen Vorteile demonstriert; alles bei Designfrequenz. Es kann festgestellt werden, dass es fast keine Publikationen gibt, die sich mit Steuerfunktionen geschweige denn mit breitbandigen Doherty beschäftigen, welche digitale Eingangsteiler besitzen.

Die Versatzleitungen mit der Länge $\lambda/2$ und der digitale Eingangsteiler ET sind unterschiedliche Ansätze, um das gleiche Problem zu lösen, nämlich Doherty mit hoher Bandbreite bei sehr hoher Leistung zu ermöglichen.

Digitale Eingangsteiler erhöhen die Bandbreite durch eine Anpassung von Eingangsleistung und Phase abhängig von der Trägerfrequenz und Zielausgangsleistung. Die erfindungsgemäßen zusätzlichen multiharmonischen Transformationsleitungen/Versatzleitungen (LAH) ermöglichen einen Ausgangskombinierer C mit transformativen Eigenschaften zu bauen, der auch bei Verwendung eines statischen Splitters erhebliche Bandbreitengewinne erzielen lässt. Aufgrund dessen handelt es sich hierbei um verschiedene Ansätze, die das gleiche Ziel haben und beide elementar sind das Ziel eines breitbandigen Hochleistungs-Doherty zu erreichen.

Der Schutz des Verstärkers aus der vorstehend genannten Fachliteratur von Neo et al beruht auf der Vermeidung einer starken Kompression des Hauptleistungsverstärkers, während der Zirkulator den Dohertyausgang vor rücklaufender Leistung bei starker Antennenfehlanpassung schützt. Die Fachliteratur von Neo et al hat sich nicht mit Fehlanpassungen am Ausgang beschäftigt, sondern ist von einer idealen 50 Ohm Last ausgegangen. Fehlanpassungen und rücklaufende Leistungen sind nicht Gegenstand der Fachliteratur von Neo et al und der Zirkulator sorgt dafür, dass der Doherty immer eine gut angepasste Last sieht, was für eine praktische Anwendung von Vorteil ist.

Im auf Seite 10, letzter Absatz bis Seite 13, 1. Absatz dieser Anmeldung gewürdigten Stand der Technik, nämlich DE102012105260 A1 eine Breitband-Doherty-Verstärkerschaltung mit Konstantimpedanzkombinierer, wird diese in den klassischen Betriebsarten wie Class-AB und Class-C beschrieben. Bei der erfindungsgemäßen Sende- und Empfangsvorrichtung/HF-Hochleistungsverstärker HPA werden im Hinblick auf die Breitbandigkeit auch die Harmonischen mit einbezogen, was hier auch als Multiharmonic Matching bezeichnet wird (siehe Diskussion zur Beschreibung der Transformationsleitungen, Seite 29, 1 und 2. Absatz).

So stellt Class-J eine Weiterentwicklung von Class-B dar, man könnte Class-J auch als "Class-B Continous" bezeichnen, in Anlehnung an die Erweiterung von Class-F zu Class-F Continous. Auszugehen ist von der Feststellung, dass es unmöglich ist, eine Impedanz über der Frequenz konstant zu halten. Alle Versuche im gewürdigten Stand der Technik sind Kompromisse, die Impedanz als Funktion von f konstant zu halten. Bei der erfindungsgemäßen Lösung des Continous-Mode wird stattdessen festgelegt, wie sich die reaktiven Anteile der Impedanzen bei der Grundwelle und bei den Harmonischen zueinander verhalten sollen.

Bei Class-J=Class-B Continous verlangt man, dass der reaktive Anteil bei der Grundwelle und bei der 2. Harmonischen gegenläufiges Verhalten (induktiv<->kapazitiv) aufweisen sollen und dass sich der Wert des reaktiven Anteils bei der 2. Harmonischen doppelt so stark mit der Frequenz verändern soll als bei der Grundwelle. Der Vorteil hiervon ist, dass man eine Vergrößerung der Bandbreite bekommt, nachteilig hier ist aber eine größere Spannung am Drain. Aber bei GaN geht man dies jedoch ein, d.h. Spitzenspannung 3x Versorgung bei Class-J versus 2x Versorgung bei Class-B.

Mit konstanter Impedanz ist aber auch in der DE102012105260 A1 gemeint, dass eine Impedanz an den drei Knoten der Schaltung 132/134/136 gleich ist. Insbesondere wird für einen bestimmten Back-Off Leistungspunkt eine hohe Bandbreite erreicht, d.h. also nur für einen Punkt der Ausgangsleistung/ Designfrequenz. Bei der erfindungsgemäßen Lösung werden dagegen eine hohe Bandbreite und eine hohe Effizienz über den gesamten Bereich der Ausgangsleistung erreicht.

Schließlich weist der Combiner gemäß der DE102012105260 A1 kein Tiefpassverhalten auf. Bei der erfindungsgemäßen Sende- und Empfangsvorrichtung/HF-Hochleistungsverstärker HPA wird der Austausch von Leistung bei Harmonischen zwischen den Verstärkerkernen DM, DP1, DP2, ... (was im Rahmen der Erfindung für N-Wege Doherty Verstärker gilt) unterbunden. Dadurch wird verhindert, dass der Harmonischen-Abschluss aus Sicht jedes Kerns davon abhängig ist, wie die anderen Verstärkerkerne ausgesteuert werden. Die korrekte Harmonischenterminierung ist aber essentiell, um den Wirkungsgrad jedes Kerns zu maximieren. Dies wird erfindungsgemäß im Continous Mode gemacht, um die hohe Effizienz über eine möglichst große Bandbreite zu erhalten.

Die Erfindung ist nicht auf die dargestellten und beschriebenen Ausführungsbeispiele beschränkt, sondern umfasst auch alle im Sinne der Erfindung gleichwirkenden Ausführungen und ist insbesondere nur durch die Patentansprüche beschränkt.

Bezugszeichenliste:

| | |
|---|---|
| A | Antenne |
| ABN | Absorptionsnetzwerk (Drain-Parasiten) |
| AGT | Ausgangstransformator |
| AMLR | "Adaptive Multichannel L-Band Radio" |
| AN | Anpassnetzwerk |
| AN1 | erstes Anpassnetzwerk/Impedanzwandler |
| AN2 | zweites Anpassnetzwerk/Impedanzwandler |
| BB | Befestigungsbohrung |
| BK | Basiskontakt |
| C | Ausgangskombinierer |
| $C_0$ | Drain-Kapazität |
| $C_1$ | Kapazität |
| DAC | Digital-Analog-Umsetzer |
| DCV | Gleichstromversorgung |
| DD | Digitale Domäne |
| DK | Diskrete Kapazität |
| DM | Hauptleistungsverstärker (Doherty) |
| DPA | Drei-Wege Doherty Power Amplifier |
| DPD | Steuerfunktion (digitale Vorverzerrung) |
| DP1 | erster Spitzenleistungsverstärker (Doherty) |
| DP2 | zweiter Spitzenleistungsverstärker (Doherty) |
| DPS | Drain Parasiten |
| DSM | Drain Strom Messung |
| EA | Empfangsantenne |
| ET | digitaler Eingangssignalteiler |
| ES | Erdschiene |
| FPGA | Field Programable Gate Array |
| G1 | Gasableiter |
| GF | Gehäuse FET |
| GH | Gasentladungshülse |
| GSM | Gate Strom Messung |
| GSZ | Modul |
| HFL | Ein- oder zweiseitige HF-Leiterplatte |
| HFP1 | HF-Signal Eingang 1. Spitzenleistungsverstärker |
| HFP2 | HF-Signal Eingang 2. Spitzenleistungsverstärker |
| HFM | HF-Signal Eingang Hauptleistungsverstärker |
| HFO | HF-Hochleistungsverstärker Ausgang |
| HPA | HF-Hochleistungsverstärker (High Power Amplifier) |
| HSK | Kupfer-Kühlkörper (Heatsink) |
| $I_m$ ($I_M$) | (ideale) Stromquelle (zum Hauptleistungsverstärker DM) |
| $I_{P1}$ | (ideale) Stromquelle (zum ersten Spitzenleistungsverstärker DP1) |
| $I_{P2}$ | (ideale) Stromquelle (zum zweiten Spitzenleistungsverstärker DP2) |
| IT | intrinsischer Transistor (Model) |
| ITG | Transistorgehäuse (von IT) |
| ITN | Impedanztransformationsnetzwerk für Eingangsanpassung |
| KF | Kontaktflächen |
| L | Induktivität |
| LAH | Multiharmonische Transformationsleitung/ Offset-Leitung/ Versatzleitung |
| LMC | Lastangepasster Kombinierer (Load Matched Combiner) |

| | |
|---|---|
| LNA | schaltbare rauscharme Verstärkerschaltung |
| LG | Leiterplattengehäuse |
| LP1 | Lötpad 1 |
| LP2 | Lötpad 2 |
| LPA | Lötpaste / Klebefolie / Kleber |
| LUS | Luftspalt |
| OTA | Drahtlos- / Funkkopplung (Over The Air) |
| PAE | Leistungseffizienz/Leistungswirkungsgrad (Power Added Efficiency) |
| PAPR | Verhältnis von Spitzenleistung zu der mittleren Leistung eines Signals (Peak To Average Power Ratio) |
| PBE | Passive Bauelemente |
| R1 | erster Richtkoppler |
| R2 | zweiter Richtkoppler |
| RA | Referenzebene A |
| RB | Referenzebene B |
| RC | Referenzebene C |
| RD | Ringdichtung |
| RK | Ringkontakt |
| RL | Abschlussimpedanz |
| Rx | Empfänger |
| RX | Ein- oder Mehrfachempfänger |
| RXK | RX-Kabel |
| S1 | Schraube 1 |
| SD | Schraubendichtung |
| SA | Sendeantenne |
| TBS | Transistor Befestigungsschraube |
| TKK1 | T-Kreuz Kombinierer 1 |
| TKK2 | T-Kreuz Kombinierer 2 |
| TM | Transformator (Hauptleistungsverstärker DM) |
| TP1 | Transformator (erster Spitzenleistungsverstärker DP1) |
| TR | Transistor |
| TRD | Transistor Die |
| TRK | Transistor Kühlkörper |
| Tx | Sender |
| TY | Ein- oder Mehrfachsender |
| TXK | TX-Kabel |
| U1 | Feinschutz |
| UPS | unterbrechungsfreie Stromversorgungseinheit |
| $V_{DCG}$ | DC-Stromversorgung Gate |
| $V_{DCD}$ | DC-Stromversorgung Drain |
| WBC | Breitband Back-off Kombinierer |
| W1 | Widerstand 1 |
| W2 | Widerstand 2 |
| W3 | Widerstand 3 |
| Z1 | Zirkulator |

**Patentansprüche**

1. Sende- und Empfangsvorrichtung mit einem Modul (GSZ) mit einem N-Wege Doherty-Leistungsverstärker (HPA), welcher einen Hauptleistungsverstärker (DM) mit Verstärkerkern und mindestens zwei Spitzenleistungsverstärker-(DP1, DP2) mit Verstärkerkern aufweist, wobei die Verstärkerkerne jeweils Leistungstransistoren mit Source-, Gate- und Drain-Anschlüssen aufweisen, wobei ein mit dem Eingang des Hauptleistungsverstärkers (DM) und dem Eingang jedes Spitzenleistungsverstärker (DP1) verbundener digitaler Eingangssignalteiler (ET), welcher im folgenden Steuerfunktion (ET) genannt wird, die Phase und Amplitude jedes seiner Ausgangssignale steuert, und ein mit einem Ausgang der Verstärkerkerne verbundener lastangepasster Ausgangskombinierer (C) für den Hauptleistungsverstärker (DM) und einem Ausgang jedes Spitzenleistungsverstärkers (DP1) vorgesehen ist, wobei die Steuerfunktion eine nicht-lineare Funktion darstellt, die durch Messungen während eines Identifikationsprozess derart definiert wird, dass eine übergeordnete Übertragungsfunktion, bestehend aus der Steuerfunktion (ET), den Verstärkerkernen (DM, DP1, DP2) und dem lastangepassten Ausgangskombinierer (C, LMC), hinsichtlich kontinuierlicher Wellen linear ist, wobei jeweils zwei in Reihe geschaltete multiharmonische Transformationsleitungen (LAH) am Verstärkerkernausgang des Hauptleistungsverstärkers (DM) und am Verstärkerkernausgang jedes Spitzenleistungsverstärkers (DP1, DP2) und ein am Ausgang des lastangepassten Ausgangskombinierers (C) angeschlossener Zirkulator (Z1) vorgesehen sind, wobei jede Transformationsleitung (LAH) eine λ/4 Länge hat, wobei λ die geführte Wellenlänge ist und wobei die charakteristischen Impedanzwerte jeder dieser Transformationsleitungen (LAH) beim Design ihrer Struktur individuell angepasst sind, wobei zur Absorption von Drain-Parasiten in den Transistoren des Hauptleistungsverstärkers (DM) und den Spitzenleistungsverstärkern (DP1, DP2) Absorptionsnetzwerke (ABN) vorgesehen sind, welche Teil der multiharmonischen Transformationsleitungen (LAH) und diese Teil des lastangepassten Ausgangskombinierers (C) sind, wobei mittels des Zirkulators (Z1) der vorgeschaltete Hauptleistungsverstärker (DM) und jeder Spitzenleistungsverstärker (DP1, DP2) vor ausgangsseitigen Überspannungen und Überstrom geschützt ist, indem der Zirkulator (Z1) die Energie zu einem mit dem Zirkulator (Z1) verbundenen Sumpfwiderstand (W1) ableitet, derart, dass der Zirkulator (Z1) eine 50 Ohm-Abschlussimpedanz für den lastangepassten Ausgangskombinierer (C) darstellt, und dass ein lüfterloser Betrieb des Moduls (GSZ) ermöglicht wird, indem eine Leiterplatte des Moduls (GSZ) mit einem Kühlkörper (HSK) in wärmeleitender Verbindung steht und Hauptleistungsverstärker (DM) und Spitzenleistungsverstärker (DP1, DP2) mit dem Source-Anschluss am Kühlkörper (HSK) angeschlossen sind, wobei das Modul (GSZ) für eine Impulssendeleistung von ca. 2.000 Watt geeignet ist.

2. Sende- und Empfangsvorrichtung nach Anspruch 1, wobei zur Kompressionskontrolle die mittels einer elektrischen Schaltung gemessenen Gate-Ströme als Maß für das Kompressionsniveau des Hauptleistungsverstärkers (DM) und jedes Spitzenleistungsverstärkers (DP1, DP2) genutzt werden.

3. Sende- und Empfangsvorrichtung nach Anspruch 1 und/ oder Anspruch 2, wobei zur Kompensation von Drain-Parasiten zusätzlich eine Spannungsversorgung der Verstärkerkerne mit Hilfe einer λ/4-Mikrostreifenleitung vorgesehen ist.

4. Sende- und Empfangsvorrichtung nach einem oder mehreren der Ansprüche 1 bis 3, wobei mit dem Ausgang des Moduls (GSZ) eine schaltbare rauscharme Verstärkerschaltung (LNA) verbunden ist, welche einen Low Noise Amplifier (LNA) zum Verstärken vom Empfangssignal, zwei Filter/Duplexer, einen im Sendezug und einen im Empfangszug liegend, und eine Switch Schaltung aufweist, wobei alle Empfängerkanäle und ein Test-Loop Kreis eine gesteuerte Spannungsversorgung zum Ein-, Aus- und Umschalten des Low Noise Amplifiers (LNA), der Switch-Schaltung sowie der beiden Filter/Duplexer besitzen.

5. Sende- und Empfangsvorrichtung nach einem oder mehreren der Ansprüche 1 bis 4, wobei zur Durchführung eines Over-The-Air Tests der N-Wege Doherty-Leistungsverstärker (HPA) einen am Ausgang des lastangepassten Ausgangskombinierers (C) angeordneten zweiten Richtkoppler (R2) aufweist, welcher das Testsignal induktiv in den Sendekanal einkoppelt.

6. Sende- und Empfangsvorrichtung nach einem oder mehreren der Ansprüche 1 bis 5, wobei zur Messung der rücklaufenden HF-Leistung der Zirkulator (Z1) mit einem ersten Richtkoppler (R1) verbunden ist.

7. Sende- und Empfangsvorrichtung nach einem oder mehreren der Ansprüche 1 bis 6, wobei der Ausgang des N-Wege Doherty-Leistungsverstärkers (HPA) gegen Blitzeinschläge mit einem mit dem Zirkulator (Z1) verbundenen Gasableiter (G) geschützt ist und dass der Gasableiter (G) auf einer der Leiterplatten des N-Wege Doherty-Leistungsverstärkers (HPA) angeordnet und in einem direkt in SMD-Technik gelöteten Leiterplattengehäuse (LG) des Moduls (GSZ) integriert ist.

8. Sende- und Empfangsvorrichtung nach Anspruch 7, wobei der Kühlkörper (HSK) als zusätzliches Kühlelement wirkt, so dass in Verbindung mit dem N-Wege Doherty-Leistungsverstärker (HPA) mit seinem reduzierten Energieverbrauch ein lüfterloser Betrieb des Moduls (GSZ) auch bei einer maximalen Sendeleistung von ca. 2.000 W ermöglicht und eine durchschnittliche Leistungseffizienz (PAE) von ca. 56 % erreicht wird.

9. Sende- und Empfangsvorrichtung nach Anspruch 7 und/oder 8, wobei der Gasableiter (G) eine Gasentladungshülse (GH) aufweist, welche über eine Schraube (S1), welche Erdpotential aufweist, entnommen bzw. eingesetzt wird.

10. Sende- und Empfangsvorrichtung nach Patentanspruch 5, wobei bei der Inbetriebnahme das Modul (GSZ) mittels des zweiten Richtkopplers (R2) kalibriert wird, dass mittels des digitalen Eingangssignalteilers (ET) eine Steuerfunktion (ET) für den Hauptleistungsverstärker (DM) und jeden Spitzenleistungsverstärkers (DP1, DP2) generiert wird und dass im laufenden Sendebetrieb eine parallel im Hintergrund laufende Feinkalibrierung durchgeführt wird.

11. Sende- und Empfangsvorrichtung nach einem oder mehreren der Ansprüche 1 bis 10, wobei dem digitalen Eingangssignalteiler (ET) ein Multiplexer vorgeschaltet ist, dessen Eingängen jeweils ein unterschiedlich moduliertes Signal zugeführt wird.

12. Sende- und Empfangsvorrichtung nach einem oder mehreren der Ansprüche 1 bis 11, wobei dem digitalen Eingangssignalteiler (ET) eine digitale Vorverzerrung (DPD) vorgeschaltet ist und der Eingang der digitalen Vorverzerrung (DPD) mit dem Ausgang eines Digital Signal Prozessor Blocks (DSP) verbunden ist, welchem ein moduliertes Sendesignal zugeführt wird.

13. Sende- und Empfangsvorrichtung nach einem oder mehreren der Ansprüche 1 bis 12, wobei zwischen dem Signaleingang vom Hauptleistungsverstärker (DM) und jedes Spitzenleistungsverstärkers (DP1, DP2) und den Verstärkerkernen einer jeweiligen Treiberstufe ein Impedanztransformationsnetzwerk (ITN) mit Impedanzwandlern (AN1, AN2) angeordnet ist.

14. Sende- und Empfangsvorrichtung nach Anspruch 13, wobei der Impedanzwandler (AN1) des Hauptleistungsverstärkers (DM) eine andere physikalische Leitungsführungsstruktur wie der Impedanzwandler (AN2) jedes Spitzenleistungsverstärkers (DP1, DP2) aufweist.

15. Sende- und Empfangsvorrichtung nach einem oder mehreren der Ansprüche 1 bis 14, wobei ein erster Transformator (TM) am Ausgang des Hauptleistungsverstärkers (DM) angeordnet ist, welcher sowohl zur Nutzung einer Impedanztransformation mit einem Übertragungsfaktor als auch als Impedanzinverter dient.

## Claims

1. Transmitting and receiving device with a module (GSZ) with an N-way Doherty power amplifier (HPA), which has a main power amplifier (DM) with an amplifier core and at least two peak power amplifier (DP1, DP2) with an amplifier core, the amplifier cores each having power transistors with source -, gate- and drain- terminals, with a digital input signal divider (ET) connected to the input of the main power amplifier (DM) and the input of each peak power amplifier (DP1), which is referred to below as the control function (ET) and which is connected to the respective input of the main power amplifier (DM) and peak power amplifier (DM, DP1, DP2) controlling the phase and amplitude of each of its output signals, and a load matched output combiner (C) connected to an output of the amplifier cores for the main power amplifier (DM) and one output of each peak power amplifier (DP1) is provided, the control function being a non-linear function which is defined by measurements during an identification process in such a way that a superordinate transfer function consisting of the control function (ET), the amplifier cores (DM, DP1, DP2) and the load-matched output combiner (C,LMC), is linear with respect to continuous waves, wherein two series-connected multiharmonic transformation lines (LAH) each at the amplifier core output of the main power amplifier (DM) and at the amplifier core output of each peak power amplifier (DP1,DP2) are provided, and wherein an at the output of the load-matched output combiner (C) connected circulator (Z1) is provided, wherein each transformation line (LAH) has a $\lambda/4$ length and wherein the characteristic impedance values of each of these transformation lines (LAH) are individually adjusted in the design of their structure, whereby for the absorption of drain parasites in the transistors of the main power amplifier (DM) and the peak power amplifiers (DP1, DP2) absorption networks (ABN) are provided, which are part of the multiharmonic transformation lines (LAH) and these are part of the load-matched output combiner (C), wherein the upstream main power amplifier (DM) and each peak power amplifier (DP1, DP2 ) are protected from output overvoltage and overcurrent by the circulator (Z1) by deriving the energy to a sump resistor (W1) connected to the circulator (Z1) such that the circulator (Z1) provides a 50 ohm terminating impedance for the load matched output combiner ( C), and that a fanless operation of the module (GSZ) is made possible by a printed circuit board of the module (GSZ) being in thermally conductive connection with a heat sink (HSK) and main power amplifier (DM) and peak power amplifier (DP1, DP2) are connected with the source -connection on the heat sink (HSK) in such a way that the module (GSZ) has a high usable bandwidth with a pulse transmission power of approx. 2,000 watts.

2. Transmitting and receiving device according to claim 1, wherein the gate currents measured by means of an electrical circuit are used as a measure of the compression level of the main power amplifier (DM) and each peak power amplifier (DP1, DP2) for compression control.

3. Transmission and receiving device according to claim 1 and/or claim 2, wherein to compensate for drain parasites a voltage supply of the amplifier cores is provided with the aid of a λ/4 micro strip line.

4. Transmitting and receiving device according to one or more of claims 1 to 3, wherein a switchable low-noise amplifier circuit (LNA) is connected to the output of the module (GSZ), which has a low-noise amplifier (LNA) for amplifying the received signal, two filters /duplexers, one lying in the transmission path and one in the reception path, and having a switch circuit, wherein all receiver channels and a test loop circuit having a controlled voltage supply for switching on, off and switching over the low noise amplifier circuit (LNA), the switch circuit as well as the two filters/duplexers.

5. Transmitting and receiving device according to one or more of claims 1 to 4, wherein the N-way Doherty power amplifier (HPA) having a second directional coupler (R2), which couples the test signal inductively into the transmission channel and arranged at the output of the load-matched output combiner (C) to carry out an over-the-air test.

6. Transmitting and receiving device according to one or more of claims 1 to 5, wherein the circulator (Z1) is connected to a first directional coupler (R1) for measuring the returning HF power.

7. Transmitting and receiving device according to one or more of claims 1 to 6, wherein the output of the N-way Doherty power amplifier (HPA) is protected against lightning strikes with a gas arrester (G) connected to the circulator (Z1) and that the gas arrester (G) is arranged on one of the printed circuit boards of the N-way Doherty power amplifier (HPA) and integrated in a printed circuit board housing (LG) of the module (GSZ) that is soldered directly using SMD technology.

8. Transmitting and receiving device according to claim 7, wherein the heat sink (HSK) acts as an additional cooling element, so that in connection with the N-way Doherty power amplifier (HPA) with its reduced energy consumption, a fanless operation of the module (GSZ) and a maximum transmission power of approx. 2,000 W is also possible and an average power efficiency (PAE) of approx. 56% is achieved.

9. Transmitting and receiving device according to claim 7 and/or 8, wherein the gas arrester (G) has a gas discharge sleeve (GH), which is removed or inserted via a screw (S1), which has ground potential.

10. Transmitting and receiving device according to claim 5, wherein during installation the module (GSZ) is calibrated by means of the second directional coupler (R2), that by means of the digital input signal divider (ET) a control function (ET) for the main power amplifier (DM) and each Peak power amplifier (DP1, DP2) is generated and that a fine calibration running in parallel in the background is carried out during ongoing transmission.

11. Transmitting and receiving device according to one or more of claims 1 to 10, wherein the digital input signal divider (ET) is preceded by a multiplexer whose inputs are each supplied with a differently modulated signal.

12. Transmitting and receiving device according to one or more of claims 1 to 11, wherein the digital input signal divider (ET) is preceded by a digital predistortion (DPD) and the input of the digital predistortion (DPD) is connected to the output of a digital signal processor block (DSP), to which a modulated transmission signal is supplied.

13. Transmitting and receiving device according to one or more of claims 1 to 12, wherein an impedance transformation network (ITN) with impedance converters (AN1, AN2) being arranged between the signal input from the main power amplifier (DM) and each peak power amplifier (DP1, DP2) and the amplifier cores of a respective driver stage.

14. Transmission and receiving device according to claim 13, wherein the impedance converter (AN1) of the main power amplifier (DM) has a different physical wiring structure than the impedance converter (AN2) of each peak power amplifier (DP1, DP2).

15. Transmitting and receiving device according to one or more of claims 1 to 14, wherein a first transformer (TM) is arranged at the output of the main power amplifier (DM), which is used both for using an impedance transformation with a transmission factor and as an impedance inverter.

**Revendications**

1. Dispositif d'émission et de réception avec un module (GSZ) avec un amplificateur de puissance Doherty à N voies (HPA), qui a un amplificateur de puissance principal (DM) avec un noyau d'amplificateur et au moins deux amplificateurs de puissance de crête (DP1, DP2) avec un amplificateur noyau, les noyaux d'amplificateur ayant chacun des transistors de puissance avec des bornes de source, de grille et de drain, avec un diviseur de signal d'entrée numérique (ET) connecté à l'entrée de l'amplificateur de puissance principal (DM) et à l'entrée de chaque amplificateur de puissance de crête (DP1), ci-après dénommée fonction de commande (ET) et qui est connectée à l'entrée respective de l'amplificateur de puissance principal (DM) et de l'amplificateur de puissance de crête (DM, DP1, DP2) contrôlant la phase et l'amplitude de chacun de ses signaux de sortie, et un combineur de sortie adapté à la charge (C) connecté à une sortie des noyaux d'amplificateur pour l'amplificateur de puissance principal (DM) et une sortie de chaque amplificateur de puissance de crête (DP1) est prévu, dans lequel la fonction de commande étant une fonction non- fonction linéaire, qui est définie par des mesures au cours d'un processus d'identification de telle sorte qu'une fonction de transfert supérieure composée de la fonction de commande (ET), des noyaux d'amplificateur (DM, DP1, DP2) et du combineur de sortie adapté à la charge (C, LMC), est linéaire par rapport aux ondes continues, dans lequel deux lignes de transformation multi harmoniques connectées en série (LAH) chacune à la sortie du noyau de l'amplificateur de l'amplificateur de puissance principal (DM) et à la sortie du noyau de l'amplificateur de chaque amplificateur de puissance de crête (DP1, DP2) sont prévus, et dans lequel un circulateur (Z1) connecté à la sortie du combineur de sortie à adaptation de charge (C) est prévu, dans lequel chaque ligne de transformation (LAH) a une longueur $\lambda/4$ et dans lequel les valeurs d'impédance caractéristiques de chacun de ces lignes de transformation (LAH) sont ajustées individuellement dans la conception de leur structure, dans lequel pour l'absorption des parasites de drain dans les transistors de l'amplificateur de puissance principal (DM) et des amplificateurs de puissance de crête (DP1, DP2) des réseaux d'absorption (ABN) sont prévus, qui font partie des lignes de transformation multi harmoniques (LAH) et ceux-ci sont partie du combineur de sortie adapté à la charge (C), dans lequel l'amplificateur de puissance principal en amont (DM) et chaque amplificateur de puissance de crête (DP1, DP2) sont protégés contre les surtensions et les surintensités de sortie par le circulateur (Z1) en dérivant l'énergie vers un résistance de puisard (W1) connectée au circulateur (Z1) de sorte que le circulateur (Z1) fournisse une impédance de terminaison de 50 ohms pour le combineur de sortie adapté à la charge (C), et qu'un fonctionnement sans ventilateur du module (GSZ) soit rendu possible par une carte de circuit imprimé du module (GSZ) étant en connexion thermiquement conductrice avec un dissipateur thermique (HSK) et un amplificateur de puissance principal (DM) et un amplificateur de puissance de crête (DP1, DP2) sont connectés à la connexion de source sur le dissipateur thermique (HSK) de sorte que le module (GSZ) dispose d'une bande passante utilisable élevée avec une puissance d'émission d'impulsions d'env. 2 000 watts.

2. Dispositif d'émission et de réception selon la revendication 1, dans lequel les courants de grille mesurés au moyen d'un circuit électrique sont utilisés comme mesure du niveau de compression de l'amplificateur de puissance principal (DM) et de chaque amplificateur de puissance de crête (DP1, DP2) pour contrôle des compressions.

3. Dispositif d'émission et de réception selon la revendication 1 et/ou la revendication 2, dans lequel pour compenser les parasites de drain une alimentation en tension des amplificateurs noyau est assurée à l'aide d'une ligne micro ruban $\lambda/4$.

4. Dispositif d'émission et de réception selon une ou plusieurs des revendications 1 à 3, dans lequel un circuit amplificateur à faible bruit commutable (LNA) est connecté à la sortie du module (GSZ), qui a un amplificateur à faible bruit (LNA) pour amplifier le signal reçu, deux filtres/duplexeurs, l'un situé dans le chemin de transmission et l'autre dans le chemin de réception, et ayant un circuit de commutation, dans lequel tous les canaux récepteurs et un circuit de boucle de test ayant une alimentation en tension commandée pour allumer, éteindre et commuter l' amplificateur à faible bruit (LNA), le circuit de commutation ainsi que les deux filtres/duplexeurs.

5. Dispositif d'émission et de réception selon une ou plusieurs des revendications 1 à 4, dans lequel l'amplificateur de puissance Doherty à N voies (HPA) ayant un deuxième coupleur directionnel (R2), qui couple le signal de test de manière inductive dans le canal de transmission et disposé à la sortie du combineur de sortie adapté à la charge (C) pour effectuer un test en direct.

6. Dispositif d'émission et de réception selon une ou plusieurs des revendications 1 à 5, dans lequel le circulateur (Z1) est connecté à un premier coupleur directionnel (R1) pour mesurer la puissance HF de retour.

7. Dispositif d'émission et de réception selon une ou plusieurs des revendications 1 à 6, dans lequel la sortie de l'amplificateur de puissance Doherty à N voies (HPA) est protégée contre les coups de foudre par un parafoudre à gaz (G) connecté au circulateur (Z1) et en ce que le pare-gaz (G) est disposé sur l'une des cartes de circuit imprimé de l'amplificateur de puissance Doherty à N voies (HPA) et intégré dans un boîtier de carte de circuit imprimé (LG) du module (GSZ) qui est soudé directement à l'aide Technologie CMS.

**8.** Dispositif d'émission et de réception selon la revendication 7, dans lequel le dissipateur thermique (HSK) agit comme un élément de refroidissement supplémentaire, de sorte qu'en relation avec l'amplificateur de puissance Doherty N voies (HPA) avec sa consommation d'énergie réduite, un fonctionnement sans ventilateur de le module (GSZ) et une puissance d'émission maximale d'env. 2 000 W est également possible et une efficacité énergétique moyenne (PAE) d'env. 56% est atteint.

**9.** Dispositif d'émission et de réception selon la revendication 7 et/ou 8, dans lequel le pare-gaz (G) comporte un manchon d'évacuation de gaz (GH), qui est retiré ou inséré via une vis (S1), qui a un potentiel de masse.

**10.** Dispositif d'émission et de réception selon la revendication 5, dans lequel lors de l'installation le module (GSZ) est calibré au moyen du deuxième coupleur directionnel (R2), qui au moyen du diviseur de signal d'entrée numérique (ET) une fonction de commande (ET) pour l'amplificateur de puissance principal (DM) et chaque amplificateur de puissance de crête (DP1, DP2) est généré et qu'un calibrage fin fonctionnant en parallèle en arrière-plan est effectué pendant la transmission en cours.

**11.** Dispositif d'émission et de réception selon une ou plusieurs des revendications 1 à 10, dans lequel le diviseur de signal d'entrée numérique (ET) est précédé d'un multiplexeur dont les entrées sont chacune alimentées par un signal modulé différemment.

**12.** Dispositif d'émission et de réception selon une ou plusieurs des revendications 1 à 11, dans lequel le diviseur de signal d'entrée numérique (ET) est précédé d'un pré distorsion numérique (DPD) et l'entrée du pré distorsion numérique (DPD) est connectée à la sortie d'un bloc processeur de signal numérique (DSP), auquel un signal de transmission modulé est fourni.

**13.** Dispositif d'émission et de réception selon une ou plusieurs des revendications 1 à 12, dans lequel un réseau de transformation d'impédance (ITN) avec des convertisseurs d'impédance (AN1, AN2) étant agencé entre l'entrée de signal de l'amplificateur de puissance principal (DM) et chaque amplificateur de puissance de crête (DP1, DP2) et les noyaux amplificateurs d'un étage pilote respectif.

**14.** Dispositif d'émission et de réception selon la revendication 13, dans lequel le convertisseur d'impédance (AN1) de l'amplificateur de puissance principal (DM) a une structure de câblage physique différente de celle du convertisseur d'impédance (AN2) de chaque amplificateur de puissance crête (DP1, DP2).

**15.** Dispositif d'émission et de réception selon une ou plusieurs des revendications 1 à 14, dans lequel un premier transformateur (TM) est disposé à la sortie de l'amplificateur de puissance principal (DM), qui est utilisé à la fois pour utiliser une transformation d'impédance avec une transmission facteur et comme inverseur d'impédance.

Fig. 1

Fig. 2

## Mittlerer PAE für Signal mit 10dB PAPR

Fig. 3

Fig. 4

LG

S1

LP1

BK

LP2

SD

RK

RD

GH

Fig. 5

BB

S1

Fig. 6

Fig. 7

Variante 1a:
Rundstab

L-Band

Variante 1b:
Rundstab

GPS

L-Band

Variante 1c:
Mastspitze

L-Band

GPS

Variante 2:
Am Mast / Sektorantennen

GPS          GPS

L-Band          L-Band

GPS

Variante 3:
Planar / Sektorantennen

A 1    A 2    A 3    A 4    A 5    A 6

A 1    A 2    A 3    A 4

A 1    A 2

Fig. 8

Fig. 9

Fig. 10 (Stand der Technik)

Fig. 11

Fig. 12 (Stand der Technik)

Fig. 13

Fig. 14

Fig. 15

Fig. 16

Fig. 17

Fig. 18

Fig. 19

Fig. 20

Fig. 21

Fig. 22

Fig. 23

Fig. 24

Fig. 25

ABN

Fig. 26

$$Z_0 = \sigma R_L$$

TM

TP1

$1 : a$

$1 : b$

$R_L$

$I_M$

$I_{P1}$

Fig. 27

Fig. 28

Fig. 29

Fig. 30

Fig. 31

Fig. 32

HFL

PBE

KF

TBS

TRK

TR

LUS

LPA

HSK

Fig. 33

Fig. 34

Fig. 35

Fig. 36

**IN DER BESCHREIBUNG AUFGEFÜHRTE DOKUMENTE**

*Diese Liste der vom Anmelder aufgeführten Dokumente wurde ausschließlich zur Information des Lesers aufgenommen und ist nicht Bestandteil des europäischen Patentdokumentes. Sie wurde mit größter Sorgfalt zusammengestellt; das EPA übernimmt jedoch keinerlei Haftung für etwaige Fehler oder Auslassungen.*


**In der Beschreibung aufgeführte Patentdokumente**

- WO 2013006941 A1
- DE 60124728 T2
- US 20080007331 A1
- DE 102012202870 A1
- EP 2879291 A1
- DE 102012105260 A1
- DE 102010018274 A1

- DE 102014115315 A1
- DE 102014213684 A1
- DE 102016106278 A1
- DE 102016123932 A1
- DE 102016105742 A1
- WO 2011112129 A1
- US 2015229276 A1
- US 10033335 B1


**In der Beschreibung aufgeführte Nicht-Patentliteratur**

- **K. BATHICH ; A. Z. MARKOS ; G. BOECK.** Frequency Response Analysis and Bandwidth Extension of the Doherty Amplifier. *IEEE Transactions on Microwave Theory and Techniques,* April 2011, vol. 59 (4
- **R. QUAGLIA ; M. PIROLA ; C. RAMELLA.** Offset Lines in Doherty Power Amplifiers: Analytical Demonstration and Design. *IEEE Microwave and Wireless Components Letters,* Februar 2013, vol. 23 (2
- **B. KIM ; J. KIM ; I. KIM ; J. CHA.** The Doherty power amplifier. *IEEE Microwave Magazine,* Oktober 2006, vol. 7 (5
- **R. GIOFRÈ ; L. PIAZZON ; P. COLANTONIO ; F. GIANNINI.** A closed-form design technique für ultra-wideband Doherty power amplifiers. *IEEE Transactions on Microwave Theory and Techniques,* Dezember 2014, vol. 62 (12
- **A. BARAKAT ; M. THIAN ; V. FUSCO ; S. BULJA ; L. GUAN.** Toward a More Generalized Doherty Power Amplifier Design for Broadband Operation. *IEEE Transactions on Microwave Theory and Techniques,* Marz 2017, vol. 65 (3
- **R. DARRAJI ; P. MOUSAVI ; F. M. GHANNOUCHI.** Doherty Goes Digital: Digitally Enhanced Doherty Power Amplifiers. *IEEE Microwave Magazine,* August 2016, vol. 17 (8
- **J.C. CAHUANA ; P. LANDIN ; D. GUSTAFSSON ; C. FAGER ; T. ERIKSSON.** Linearization of dual-input Doherty power amplifiers. *International Workshop on Integrated Nonlinear Microwave and Millimetre-wave Circuits,* April 2014
- **W.C.E. NEO ; J. QURESHI ; M. J. PELK ; J. R. GAJADHARSING ; L. C. N.** A Mixed-Signal Approach Towards Linear and Efficient NWay Doherty Amplifiers. *IEEE Transactions on Microwave Theory and Techniques,* Mai 2007, vol. 55 (5

- **W.C.E. NEO ; J. QURESHI ; M. J. PELK ; J. R. GAJADHARSING ; L. C. N. DE VREEDE.** A Mixed-Signal Approach Towards Linear and Efficient NWay Doherty Amplifiers. *IEEE Transactions on Microwave Theory and Techniques,* Mai 2007, vol. 55 (5
- On the Continuity of High Efficiency Modes in Linear RF Power Amplifiers. *IEEE Microwave and Wireless Components Letters,* 2009, vol. 19, 665-667
- **WRIGHT, P. ; LEES, J. ; BENEDIKT, J ; TASKER, PJ ; CRIPPS, SC.** A Methodology for Realizing High Efficiency Clas-J in a Linear and Broadband PA. *IEEE-Transactions on Microwave Theory and Techniques,* 2009, vol. 57
- A 600W broadband three-way Doherty power amplifier for multistandard wireless Communications. **JING LI et al.** 2015 IEEE MTT-S INTERNATIONAL MICROWAVE SYMPOSIUM. IEEE, 17. Mai 2015, 1-3
- A 500-W high efficiency LDMOS classical three-way Doherty amplifier for base-station applications. **JINGCHU HE et al.** 2016 IEEE MTT-S INTERNATIONAL MICROWAVE SYMPOSIUM (IMS). IEEE, 22. Mai 2016, 1-4
- **R. GIOFRÈ ; L. PIAZZON ; P. COLANTONIO ; F. GIANNINI.** A closed-form design technique for ultra-wideband Doherty power amplifiers. *IEEE Transactions on Microwave Theory and Techniques,* Dezember 2014, vol. 62 (12
- **A. BARAKAT ; M. THIAN ; V. FUSCO.** Towards generalized Doherty power amplifier design for wideband multimode operation. *SBMO/IEEE MTTS International Microwave and Optoelectronics Conference (IMOC),* 2015

- **A. BARAKAT ; M. THIAN ; V FUSCO ; S. BULJA ; L. GUAN.** Toward a More Generalized Doherty Power Amplifier Design for Broadband Operation. *IEEE Transactions on Microwave Theory and Techniques,* Marz 2017, vol. 65 (3
- **J. H. QURESHI.** A Wide-Band 20W LMOS Doherty Power Amplifier. *IMS,* 2010
- **PUBLIKATION J. H. QURESHI.** A Wide-Band 20W LMOS Doherty Power Amplifier. *IMS,* 2010
- **W.C. EDMUND NEO et al.** AMixed-Signal Approach Towards Linear and Efficient N-Way Doherty Amplifiers. *IEEE Transactions on Microwave Theory and Techniques,* Mai 2007, vol. 55 (5
- **H.J. CARLIN ; J.J. KOMIAK.** A New Method of Broad-Band Equalization Applied to Microwave Amplifiers. *IEEE Transactions on Microwave Theory and Techniques,* Februar 1979, vol. 27 (2
- **B.S. YARMAN ; H.J. CARLIN.** A Simplified ''Real Frequency. *Technique Appliable To Broadband Multistage Microwave Amplifiers'' IEEE MTT-S International Microwave Symposium Digest,* 1982
- **G. SUN.** Broadband Doherty Power Amplifier via Real Frequency Technique. *IEEE Transactions on Microwave Theory and Techniques,* Januar 2012, vol. 60 (1
- **W.C. EDMUND NEO et al.** A Mixed-Signal Approach Towards Linear and Efficient N-Way Doherty Amplifiers. *IEEE Transactions on Microwave Theory and Techniques,* Mai 2007, vol. 55 (5